(19) Europäisches Patentamt
European Patent Office
Office européen des brevets

(11) EP 4 596 607 A1

(12) # EUROPEAN PATENT APPLICATION
published in accordance with Art. 153(4) EPC

(43) Date of publication:
**06.08.2025 Bulletin 2025/32**

(21) Application number: **23872599.8**

(22) Date of filing: **29.09.2023**

(51) International Patent Classification (IPC):
***C08G 73/10*** *(2006.01)* ***C08F 290/14*** *(2006.01)*
***G03F 7/004*** *(2006.01)* ***G03F 7/027*** *(2006.01)*
***G03F 7/037*** *(2006.01)* ***G03F 7/075*** *(2006.01)*
***G03F 7/20*** *(2006.01)*

(52) Cooperative Patent Classification (CPC):
**C08F 290/14; C08G 73/10; G03F 7/004; G03F 7/027; G03F 7/037; G03F 7/075; G03F 7/20**

(86) International application number:
**PCT/JP2023/035636**

(87) International publication number:
**WO 2024/071380 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.09.2022 JP 2022159086**

(71) Applicant: **FUJIFILM Corporation**
**Tokyo 106-8620 (JP)**

(72) Inventors:
- **NOZAKI, Atsuyasu**
**Haibara-gun, Shizuoka 421-0396 (JP)**
- **OOTA, Kazuya**
**Haibara-gun, Shizuoka 421-0396 (JP)**

(74) Representative: **HGF**
**HGF Limited**
**1 City Walk**
**Leeds LS11 9DX (GB)**

(54) **RESIN COMPOSITION, CURED OBJECT, LAYERED PRODUCT, METHOD FOR PRODUCING CURED OBJECT, METHOD FOR PRODUCING LAYERED PRODUCT, METHOD FOR PRODUCING SEMICONDUCTOR DEVICE, AND SEMICONDUCTOR DEVICE**

(57) Provided are a resin composition containing at least one resin selected from the group consisting of a polyimide and a precursor thereof and having a ring structure with 5 or more membered rings in a side chain, a polymerization initiator, and a polymerizable compound; a cured substance; a laminate; a manufacturing method for a cured substance; a manufacturing method for a laminate; a manufacturing method for a semiconductor device; and a semiconductor device.

EP 4 596 607 A1

## Description

## BACKGROUND OF THE INVENTION

1. Field of the Invention

The present invention relates to a resin composition, a cured substance, a laminate, a manufacturing method for a cured substance, a manufacturing method for a laminate, a manufacturing method for a semiconductor device, and a semiconductor device.

2. Description of the Related Art

In recent years, a resin material that has been produced from a resin composition containing a resin has been utilized in various fields.

For example, a polyimide is applied to various use applications since it has an excellent heat resistance and insulating properties. The above-described use applications are not particularly limited, and examples thereof in a semiconductor device for mounting include the use as a material of an insulating film or sealing material, or as a protective film. In addition, such a resin can also be used as a base film or a cover lay for a flexible substrate.

For example, in the above-described use applications, the polyimide is used in a form of a resin composition containing a polyimide or a polyimide precursor.

Such a resin composition is applied onto a base material by coating or the like to form a photosensitive film, and then, as necessary, subjected to exposure, development, or heating, whereby a cured substance can be formed on the base material.

The polyimide precursor is cyclized by, for example, heating, and it is converted to a polyimide during curing.

Since the resin composition can be applied by a publicly known coating method or the like, it can be said that the resin composition is excellent in the manufacturing adaptability, for example, a high degree of freedom in designing the shape, size, application position during application of the resin composition to be applied. From the viewpoint of such excellent manufacturing adaptability in addition to the high performance possessed by the polyimide, the industrial application and development of the above-described resin composition are expected increasingly.

For example, WO2020/255859A describes a curable resin composition containing at least one resin selected from the group consisting of a polyimide and a polyimide precursor, which has a polyalkyleneoxy group and a polymerizable group, a polymerization initiator, a polymerizable compound, and a solvent.

WO2021/039782A describes a curable resin composition containing a resin having a repeating unit which is a specific structure and a solvent.

## SUMMARY OF THE INVENTION

It is required to reduce a dielectric constant of a cured substance containing a polyimide from the viewpoint of suppressing transmission loss, or the like.

An object of the present invention is to provide a resin composition from which a cured substance having a low dielectric constant is obtained, a cured substance obtained by curing the resin composition, a laminate including the cured substance, a manufacturing method for the cured substance, a manufacturing method for the laminate, a manufacturing method for a semiconductor device including the manufacturing method for the cured substance, and a semiconductor device including the cured substance.

Examples of representative embodiments according to the present invention are described below.

<1> A resin composition comprising:

at least one resin selected from the group consisting of a polyimide and a precursor thereof and having a ring structure with 5 or more membered rings in a side chain;
a polymerization initiator; and
a polymerizable compound.

<2> A resin composition comprising:

at least one resin selected from the group consisting of a polyimide and a precursor thereof and including a structure represented by Formula (A-1);
a polymerization initiator; and

a polymerizable compound,

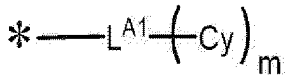 (A-1)

in Formula (A-1), $L^{A1}$ represents a single bond or an (m+1)-valent linking group, Cy's each independently represent a ring structure with 5 or more membered rings, which may have a substituent, m represents an integer of 1 or more, and * represents a bonding site to an atom included in a main chain of the resin.

<3> The resin composition according to <1> or <2>,
in which the resin further has a polymerizable group.
<4> The resin composition according to <3>,
in which a polymerizable group value of the resin is 0.2 to 5 mmol/g.
<5> The resin composition according to any one of <1> to <4>,
in which in a case where a film-like cured substance having a film thickness of 10 μm is formed using the resin composition, a transmittance of the cured substance at a wavelength of 365 nm is 15% or more.
<6> The resin composition according to any one of <1> to <5>,

in which the resin includes a repeating unit represented by Formula (1-1),

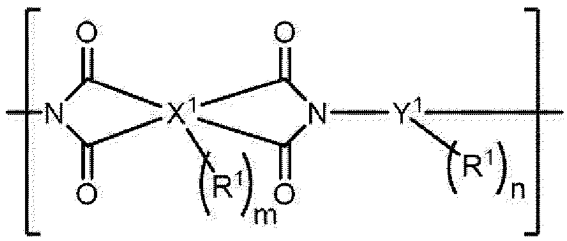 (1-1)

in Formula (1-1), $X^1$ represents an organic group having 4 or more carbon atoms, $Y^1$ represents an organic group having 4 or more carbon atoms, $R^1$'s each independently represent a structure represented by Formula (R-1), m represents an integer of 0 to 4, and n represents an integer of 1 or more,

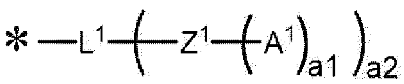 (R-1)

in Formula (R-1), $L^1$ represents an (a2+1)-valent linking group, $Z^1$ represents an aromatic group or a cyclic aliphatic group, $A^1$ represents a polymerizable group, a1 represents an integer of 0 or more and equal to or less than a maximum number of substituents of $Z^1$, a2 represents an integer of 1 or more, and * represents a bonding site to $X^1$ or $Y^1$ in Formula (1-1).

<7> The resin composition according to <6>,
in which at least one of $A^1$'s in Formula (R-1) included in Formula (1-1) is a vinyl group, a (meth)acryloxy group, a vinyl ether group, an allyl group, an epoxy group, or a group including these groups.
<8> The resin composition according to <7>,
in which the at least one of $A^1$'s in Formula (R-1) in Formula (1-1) is a vinyl group or a vinyl ether group.
<9> The resin composition according to any one of <6> to <8>,
in which $X^1$ and $Y^1$ in Formula (1-1) each include a structure obtained by removing two or more hydrogen atoms from a structure represented by any one of Formulae (V-1) to (V-4),

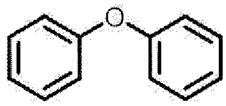
(V-1)

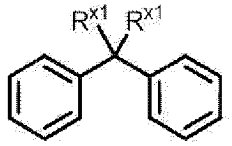
(V-2)

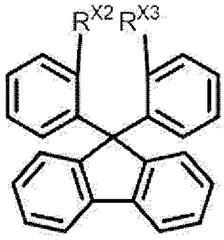
(V-3)

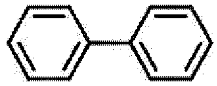
(V-4)

in Formula (V-2), $R^{X1}$'s each independently represent a hydrogen atom, an alkyl group, or a halogenated alkyl group,
in Formula (V-3), $R^{X2}$ and $R^{X3}$ each independently represent a hydrogen atom or a substituent, and $R^{X2}$ and $R^{X3}$ may be bonded to each other to form a ring structure.

<10> The resin composition according to any one of <6> to <9>, in which $L^1$ in Formula (R-1) is a group represented by Formula (L-1),

$$* - O - L^X \left( \# \right)_{a2} \qquad (L\text{-}1)$$

in Formula (L-1), $L^X$ represents an (a2+1)-valent linking group, a2 represents an integer of 1 or more, * represents a bonding site to $X^1$ or $Y^1$ in Formula (1-1), and # represents a bonding site to $Z^1$ in Formula (R-1).
<11> A resin composition comprising:

at least one resin selected from the group consisting of a polyimide and a precursor thereof and including at least one repeating unit represented by Formula (2-1) or Formula (3-1);
a polymerization initiator; and
a polymerizable compound,

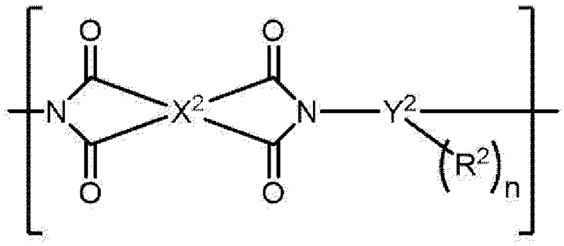
(2-1)

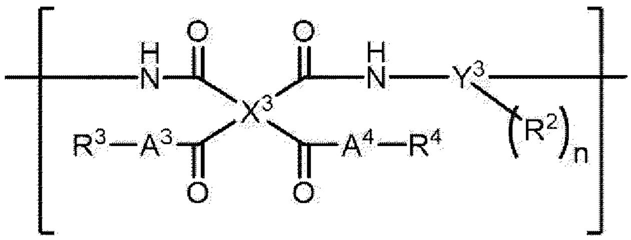
(3-1)

in Formula (2-1), $X^2$ represents an organic group having 4 or more carbon atoms, $Y^2$ represents an organic group having 4 or more carbon atoms, $Y^2$ does not include an ester bond, $R^2$'s each independently represent a group represented by Formula (R-2), and n represents an integer of 1 or more,
in Formula (3-1), $X^3$ represents an organic group having 4 or more carbon atoms, $Y^3$ represents an organic group having 4 or more carbon atoms, $Y^3$ does not include an ester bond, $A^3$ and $A^4$ each independently represent an oxygen atom or $-NR^N-$, $R^3$ and $R^4$ each independently represent a hydrogen atom or a monovalent organic group, $R^2$'s each independently represent a group represented by Formula (R-2), and n represents an integer of 1 or more,

$$*-L^2\left(-Z^2\left(-A^2\right)_{b1}\right)_{b2} \qquad (R\text{-}2)$$

in Formula (R-2), $L^2$ represents a (b2+1)-valent linking group, $Z^2$ represents a (b1+1)-valent organic group, $A^2$ represents a polymerizable group, b1 represents an integer of 1 or more and equal to or less than a maximum number of substituents of $Z^2$, b2 represents an integer of 1 or more, * represents a bonding site to $Y^2$ in Formula (2-1) or $Y^3$ in Formula (3-1), and the number of ester bonds included in Formula (R-2) is 1 or 0.

<12> The resin composition according to <11>,
in which the resin is a resin having a ring structure with 5 or more membered rings in a side chain.
<13> The resin composition according to <11> or <12>,
in which a polymerizable group value of the resin is 0.2 to 5 mmol/g.
<14> The resin composition according to any one of <11> to <13>,
in which in a case where a film-like cured substance having a film thickness of 10 μm is formed using the resin composition, a transmittance of the cured substance at a wavelength of 365 nm is 15% or more.
<15> The resin composition according to any one of <11> to <14>,
in which at least one of $A^2$'s in Formula (R-2) included in Formula (2-1) is a vinyl group, a (meth)acryloxy group, a vinyl ether group, an allyl group, an epoxy group, or a group including these groups, at least one of $A^2$'s in Formula (R-2) included in Formula (3-1) is a vinyl group, a (meth)acryloxy group, a vinyl ether group, an allyl group, an epoxy group, or a group including these groups, $X^2$ and $Y^2$ in Formula (2-1) each include a structure obtained by removing two or more hydrogen atoms from a structure represented by any one of Formulae (V-1) to (V-4), and $X^3$ and $Y^3$ in Formula (3-1) each include a structure obtained by removing two or more hydrogen atoms from a structure represented by any one of Formulae (V-1) to (V-4),

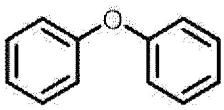
(V-1)

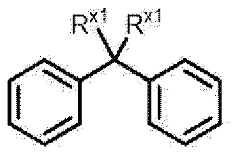
(V-2)

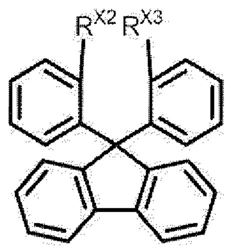
(V-3)

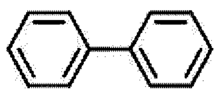
(V-4)

in Formula (V-2), $R^{X1}$'s each independently represent a hydrogen atom, an alkyl group, or a halogenated alkyl group,
in Formula (V-3), $R^{X2}$ and $R^{X3}$ each independently represent a hydrogen atom or a substituent, and $R^{X2}$ and $R^{X3}$ may be bonded to each other to form a ring structure.

<16> The resin composition according to any one <11> to <15>, in which $L^2$ in Formula (R-2) is a group represented by Formula (L-2), and $A^2$ in Formula (R-2) is a vinyl group or a vinyl ether group,

$$*-O-L^X\left(-\#\right)_{b2} \qquad (L\text{-}2)$$

in Formula (L-2), $L^X$ represents a (b2+1)-valent linking group, b2 represents an integer of 1 or more, * represents a bonding site to $X^2$ or $Y^2$ in Formula (2-1) or $X^3$ or $Y^3$ in Formula (3-1), and # represents a bonding site to $Z^2$ in Formula (R-2).
<17> The resin composition according to any one of <1> to <16>,
in which the polymerization initiator is a photoacid generator.
<18> The resin composition according to any one of <1> to <17>,
in which the polymerization initiator includes two or more kinds of polymerization initiators.
<19> The resin composition according to any one of <1> to <18>,
in which the polymerization initiator includes a photopolymerization initiator and a thermal polymerization initiator, or includes a photoradical polymerization initiator and a photoacid generator.
<20> The resin composition according to any one of <1> to <19>, further comprising:

an azole compound; and
a silane coupling agent.

<21> The resin composition according to any one of <1> to <20>,
in which the resin composition is used for forming an interlayer insulating film for a re-distribution layer.
<22> A cured substance obtained by curing the resin composition according to any one of <1> to <21>.
<23> A laminate comprising:

two or more layers consisting of the cured substance according to <22>; and
a metal layer provided between any of the layers consisting of the cured substance.

<24> A manufacturing method for a cured substance, further comprising:
a film forming step of applying the resin composition according to any one of <1> to <21> onto a base material to form a film.
<25> The manufacturing method for a cured substance according to <24>, further comprising:

an exposure step of selectively exposing the film; and
a development step of developing the film using a developer to form a pattern.

<26> The manufacturing method for a cured substance according to <24> or <25>, further comprising:
a heating step of heating the film at 50°C to 450°C.
<27> A manufacturing method for a laminate, comprising:
the manufacturing method for a cured substance according to any one of <24> to <26>.
<28> A manufacturing method for a semiconductor device, comprising:
the manufacturing method for a cured substance according to any one of <24> to <26>.
<29> A semiconductor device comprising:
the cured substance according to <22>.

According to the present invention, there are provided a resin composition from which a cured substance having a low dielectric constant is obtained, a cured substance obtained by curing the resin composition, a laminate including the cured substance, a manufacturing method for the cured substance, a manufacturing method for the laminate, a manufacturing method for a semiconductor device including the manufacturing method for the cured substance, and a semiconductor device including the cured substance.

## DESCRIPTION OF THE PREFERRED EMBODIMENTS

Hereinafter, the main embodiments according to the present invention will be described. However, the present invention is not limited to the specified embodiments.
In the present specification, a numerical value range described by using "to" means a range including numerical values described before and after the preposition "to" as a lower limit value and an upper limit value, respectively.
In the present specification, the term "step" means not only an independent step but also a step that cannot be clearly distinguished from other steps as long as the desired action of the step can be achieved.
In describing a group (an atomic group) in the present specification, in a case where a description of substitution and unsubstitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).
In the present specification, the "exposure" includes not only exposure using light but also exposure using corpuscular beams such as an electron beam and an ion beam, unless otherwise specified. In addition, examples of the light that is used for exposure include an actinic ray such as a bright line spectrum of a mercury lamp, a far ultraviolet ray represented by an excimer laser, an extreme ultraviolet ray (EUV light), an X-ray, or an electron beam, and a radioactive ray.
In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".
In the structural formulae of the present specification, Me represents a methyl group, Et represents an ethyl group, Bu represents a butyl group, and Ph represents a phenyl group.
In the present specification, the total solid content refers to the total mass of components excluding a solvent from the entire components of the composition. In addition, in the present specification, the concentration of solid contents is a

mass percentage of other components excluding a solvent with respect to the total mass of the composition.

In the present specification, weight-average molecular weight (Mw) and number-average molecular weight (Mn) are each a value measured using gel permeation chromatography (GPC) unless otherwise specified, which are defined as a polystyrene equivalent value. In the present specification, the weight-average molecular weight (Mw) and the number-average molecular weight (Mn) can be determined, for example, by using HLC-8220 GPC(manufactured by Tosoh Corporation) and using GUARD COLUMN HZ-L, TSKgel Super HZM-M, TSK gel Super HZ4000, TSK gel Super HZ3000, and TSK gel Super HZ2000 (all of which are manufactured by Tosoh Corporation) as a column connected in series. The measurements of the above molecular weights are carried out using tetrahydrofuran (THF) as an eluent unless otherwise specified. However, N-methyl-2-pyrrolidone (NMP) can also be used in a case where THF is not suitable as the eluent, for example, in a case where the solubility is low. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between the reference layer and the other layer, and the reference layer and the other layer need not be in contact with each other. Unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such a setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise specified. The content of each component in the composition means the total content of all the compounds corresponding to the component unless otherwise specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

(Resin composition)

A resin composition (hereinafter, also simply referred to as a "first resin composition") according to a first aspect of the present invention contains at least one resin selected from the group consisting of a polyimide and a precursor thereof and having a ring structure with 5 or more membered rings in a side chain, a polymerization initiator, and a polymerizable compound.

A resin composition (hereinafter, also simply referred to as a "second resin composition") according to a second aspect of the present invention contains at least one resin selected from the group consisting of a polyimide and a precursor thereof and including a structure represented by Formula (A-1), a polymerization initiator, and a polymerizable compound.

A resin composition (hereinafter, also simply referred to as a "third resin composition") according to a third aspect of the present invention contains at least one resin selected from the group consisting of a polyimide and a precursor thereof and including at least one repeating unit represented by Formula (2-1) and Formula (3-1), a polymerization initiator, and a polymerizable compound.

Hereinafter, the first resin composition, the second resin composition, and the third resin composition are simply referred to as a "resin composition".

Hereinafter, at least one resin selected from the group consisting of a polyimide and a precursor thereof and having a ring structure with 5 or more membered rings in a side chain, the resin being contained in the first resin composition, is also referred to as a "first specific resin".

Hereinafter, at least one resin selected from the group consisting of a polyimide and a precursor thereof and having a structure represented by Formula (A-1), the resin being contained in the second resin composition, is also referred to as a "second specific resin".

Hereinafter, at least one resin selected from the group consisting of a polyimide and a precursor thereof and having at least one repeating unit represented by Formula (2-1) and Formula (3-1), the resin being contained in the third resin composition, is also referred to as a "third specific resin".

Hereinafter, in a case where the term "specific resin" is simply described, it refers to all of the first specific resin, the second specific resin, and the third specific resin.

The resin composition according to the embodiment of the present invention is preferably used for forming a photosensitive film that is subjected to exposure and development, and it is preferably used for forming a film that is subjected to exposure and development using a developer containing an organic solvent.

The resin composition according to the embodiment of the present invention can be used, for example, for

forming an insulating film of a semiconductor device, an interlayer insulating film for a re-distribution layer, or a stress buffer film, and it is preferably used for forming an interlayer insulating film for a re-distribution layer.

In particular, one of the preferred aspects of the present invention is that the resin composition according to the embodiment of the present invention is used for forming an interlayer insulating film for a re-distribution layer.

In addition, the resin composition according to the embodiment of the present invention is preferably used for forming a photosensitive film that is subjected to negative-tone development.

In the present invention, the negative-tone development refers to development in which, in exposure and development, a non-exposed portion is removed by the development, and the positive-tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

With the resin composition according to the embodiment of the present invention, a cured substance having a low dielectric constant can be obtained.

Although the mechanism by which the above effect is obtained is not revealed, it is presumed as follows.

The resin (first specific resin) contained in the resin composition according to the first aspect of the present invention has a ring structure with 5 or more membered rings in a side chain. Since such a ring structure has a low polarizability, it is considered that a proportion of a polar group contained in the resin can be reduced, and a dielectric constant of the obtained cured substance is reduced.

The resin (second specific resin) contained in the resin composition according to the second aspect of the present invention includes a ring structure with 5 or more membered rings in a structure represented by Formula (A-1). Since such a ring structure has a low polarizability, it is considered that a proportion of a polar group contained in the resin can be reduced, and a dielectric constant of the obtained cured substance is reduced.

In the resin according to the third aspect of the present invention, the number of ester bonds included in $R^2$ is 0 or 1. It is considered that the dielectric constant of the obtained cured substance is reduced by limiting the number of structures having such a high polarizability.

Here, WO2020/255859A and WO2021/039782A do not describe a resin composition containing a specific resin.

Hereinafter, the components contained in the resin composition according to the embodiment of the present invention will be described in detail.

<Specific resin>

The first resin composition contains at least one resin selected from the group consisting of a polyimide and a precursor thereof, the resin (first specific resin) having a ring structure with 5 or more membered rings in a side chain.

In the present invention, a main chain of the resin indicates the relatively longest bonding chain in the resin molecule. In addition, in a case where the ring structure is included in the main chain, an atom included as a ring member in the ring structure is an atom included in the main chain.

In the present invention, the side chain of the resin refers to a molecular chain bonded to the main chain, and the molecular chain may or may not have a repeating unit. That is, the molecular chain may or may not include a repeating structure. In addition, the molecular chain may be a molecular chain composed of 6 or more atoms, but is preferably a molecular chain composed of 10 or more atoms, and more preferably a molecular chain composed of 15 or more atoms. An upper limit of the number of atoms included in the molecular chain is not particularly limited, but is, for example, preferably 1,000 or less and more preferably 500 or less.

Here, the side chain in the first specific resin is preferably bonded to a carbon atom included in the main chain, and in a case where the side chain is represented by R, the side chain R is preferably bonded to a carbon atom C of the main chain as C-R. That is, it is preferable that there is only one bond to the main chain in one side chain.

The ring structure with 5 or more membered rings in the first specific resin is preferably a ring structure with 5 to 20 membered rings, and more preferably a ring structure with 5 to 12 membered rings.

The ring structure with 5 or more membered rings in the first specific resin may be any of an aromatic ring or an aliphatic ring, and is preferably an aromatic ring or an aliphatic hydrocarbon ring.

The aromatic ring may be any of an aromatic hydrocarbon ring or a heteroaromatic ring, but is preferably an aromatic hydrocarbon ring or a heteroaromatic ring containing a nitrogen atom as a ring member.

The aromatic hydrocarbon ring is preferably an aromatic hydrocarbon ring having 6 to 20 carbon atoms, more preferably an aromatic hydrocarbon ring having 6 to 10 carbon atoms, and still more preferably a benzene ring.

Examples of the heteroaromatic ring include a furan ring, a benzofuran ring, a thiophene ring, a benzothiophene ring, a pyrrole ring, an imidazole ring, a triazole ring, a tetrazole ring, an oxazole ring, a pyridine ring, a pyridazine ring, a pyrazine ring, a triazine ring, an indole ring, an indazole ring, a benzimidazole ring, and a purine ring.

Examples of the aliphatic ring include an aliphatic hydrocarbon ring having 5 to 20 carbon atoms, a pyrrolidine ring, a pyrroline ring, a pyrazolidine ring, an imidazolidine ring, a tetrahydrofuran ring, a tetrahydrothiophene ring, a piperidine ring, a piperazine ring, a tetrahydropyran ring, a dioxane ring, and a morpholine ring.
Among these, as the ring structure with 5 or more membered rings, a benzene ring, a cyclohexane ring, or an adamantane ring is preferable.
In the ring structure with 5 or more membered rings, a hydrogen atom may be substituted. Examples of the substituent include an alkyl group, an aryl group, a halogen atom, and a polymerizable group described later.
The content of the ring structure with 5 or more membered rings in the first specific resin is preferably 0.01 to 5.0 mmol/g, more preferably 0.1 to 4.0 mmol/g, and still more preferably 0.5 to 2.5 mmol/g with respect to 1 g of the first specific resin.
The second resin composition contains a resin (second specific resin) which is at least one resin selected from the group consisting of a polyimide and a precursor thereof and contains a structure represented by Formula (A-1).

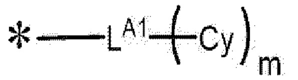
(A-1)

In Formula (A-1), $L^{A1}$ represents a single bond or an (m+1)-valent linking group, Cy's each independently represent a ring structure with 5 or more membered rings, which may have a substituent, m represents an integer of 1 or more, and * represents a bonding site to an atom included in a main chain of the resin.
In Formula (A-1), $L^{A1}$ is preferably an (m+1)-valent linking group. A preferred aspect of $L^{A1}$ is the same as a preferred aspect of $L^1$ in Formula (R-1) described later.
In Formula (A-1), a preferred aspect of Cy is the same as a preferred aspect of the ring structure with 5 or more membered rings in the above-described first specific resin.
In addition, it is also preferable that Cy is directly bonded to a polymerizable group described later. In the present invention, the direct bonding of a certain structure A and another structure B means that the structure A and the structure B are bonded to each other without a linking group being interposed therebetween.
In Formula (A-1), * represents a bonding site to an atom included in the main chain of the resin, and is preferably a bonding site to a carbon atom included in the main chain. The carbon atom is preferably a tertiary carbon atom or a quaternary carbon atom.
Among the structures represented by Formula (A-1), it is preferable that the main chain is not included.
In addition, the structure represented by Formula (A-1) is also a structure represented by Formula (R-1) described later, which is one of the preferred aspects of the present invention.
The content of the structure represented by Formula (A-1) in the second specific resin is preferably 0.01 to 5.0 mmol/g, more preferably 0.1 to 4.0 mmol/g, and still more preferably 0.5 to 2.5 mmol/g with respect to 1 g of the second specific resin.
The first specific resin and the second specific resin preferably have a polymerizable group.
The polymerizable group may be a cationically polymerizable group, but is preferably a radically polymerizable group.
Examples of the polymerizable group include an epoxy group, an oxetanyl group, an alkoxymethyl group, an acyloxymethyl group, a methylol group, a blocked isocyanate group, and a group containing an ethylenically unsaturated bond, but a group containing an ethylenically unsaturated bond is preferable.
The group having an ethylenically unsaturated bond is preferably a radically polymerizable group.
In addition, examples of the group containing an ethylenically unsaturated bond include a vinyl group, a vinyl ether group, an allyl group, an isoallyl group, a 2-methylallyl group, a (meth)acrylamide group, and a (meth)acryloyloxy group, and from the viewpoint of reducing the polarity and reducing the dielectric constant of the obtained cured substance, a vinyl group or a vinyl ether group is preferable. Here, it is also preferable that the vinyl group is directly bonded to the above-described ring structure with 5 or more membered rings. Specifically, it is preferable that the above-described aromatic ring structure with 5 or more membered rings and the above-described vinyl group are directly bonded to each other.
The polymerizable group value (the total molar amount of polymerizable groups with respect to 1 g of the specific resin) in the specific resin is preferably 0.1 to 10 mmol/g and more preferably 0.2 to 5 mmol/g.
It is preferable that the first specific resin and the second specific resin include a repeating unit represented by Formula (1-1).

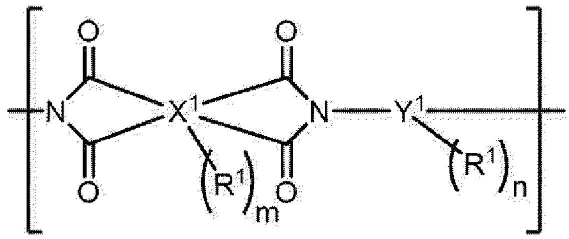

(1-1)

In Formula (1-1), $X^1$ represents an organic group having 4 or more carbon atoms, $Y^1$ represents an organic group having 4 or more carbon atoms, $R^1$'s each independently represent a structure represented by Formula (R-1), m represents an integer of 0 to 4, and n represents an integer of 1 or more.

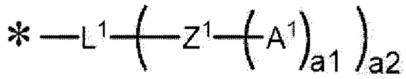

(R-1)

In Formula (R-1), $L^1$ represents an (a2+1)-valent linking group, $Z^1$ represents an aromatic group or a cyclic aliphatic group, $A^1$ represents a polymerizable group, a1 represents an integer of 0 or more and equal to or less than a maximum number of substituents of $Z^1$, a2 represents an integer of 1 or more, and * represents a bonding site to $X^1$ or $Y^1$ in Formula (1-1).

-$R^1$-

$R^1$'s each independently represent a structure represented by Formula (R-1).
In Formula (R-1), $L^1$ represents an (a2+1)-valent linking group.
$L^1$ is preferably a group represented by Formula (L-1).

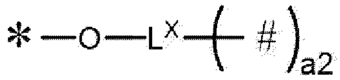

(L-1)

In Formula (L-1), $L^X$ represents an (a2+1)-valent linking group, a2 represents an integer of 1 or more, * represents a bonding site to $X^1$ or $Y^1$ in Formula (1-1), and # represents a bonding site to $Z^1$ in Formula (R-1).
$L^X$ is preferably an alkylene group, more preferably an alkylene group having 1 to 10 carbon atoms, still more preferably an alkylene group having 1 to 4 carbon atoms, and particularly preferably a methylene group.
The preferred aspect of a2 in Formula (L-1) is the same as the preferred aspect of a2 in Formula (R-1).

-$Z^1$-

$Z^1$ in Formula (R-1) represents an aromatic group or a cyclic aliphatic group. The preferred aspect of these groups is the same as a preferred aspect of the ring structure with 5 or more membered rings in the above-described first specific resin.

-$A^1$-

$A^1$ in Formula (R-1) represents a polymerizable group, and the preferred aspect of the polymerizable group is the same as the preferred aspect of the polymerizable group in the first specific resin and the second specific resin described above.
Among these, at least one of $A^1$'s in Formula (R-1) included in Formula (1-1) is preferably a vinyl group, a (meth)acryloxy group, a vinyl ether group, an allyl group, an epoxy group, or a group including these groups, and more preferably a vinyl group or a vinyl ether group.

-a1, a2-

In Formula (R-1), a1 is preferably an integer of 0 to 2, and more preferably 0 or 1. In addition, an aspect in which a1 is 1 or 2 is also one of the preferred aspects of the present invention.
In Formula (R-1), a2 represents an integer of 1 or more, and is preferably 1 or 2 and more preferably 1.
In addition, the number of ester bonds included in Formula (R-1) is preferably 1 or 0.

$-X^1-$

In Formula (1-1), it is preferable that $X^1$ includes a structure obtained by removing two or more hydrogen atoms from a structure represented by any one of Formulae (V-1) to (V-4).

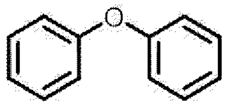

(V-1)

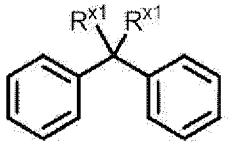

(V-2)

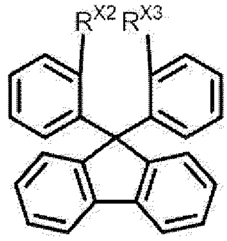

(V-3)

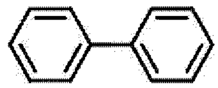

(V-4)

In Formula (V-2), $R^{X1}$'s each independently represent a hydrogen atom, an alkyl group, or a halogenated alkyl group.

In Formula (V-3), $R^{X2}$ and $R^{X3}$ each independently represent a hydrogen atom or a substituent, and $R^{X2}$ and $R^{X3}$ may be bonded to each other to form a ring structure.

In Formula (V-2), $R^{X1}$'s are each independently preferably an alkyl group or a halogenated alkyl group, more preferably an alkyl group having 1 to 4 carbon atoms or a halogenated alkyl group having 1 to 4 carbon atoms, and still more preferably a methyl group or a trifluoromethyl group. The halogenated alkyl group refers to a group in which at least one hydrogen atom of an alkyl group is substituted with a halogen atom. As the halogen atom, F or Cl is preferable, and F is more preferable.

In Formula (V-3), $R^{X2}$ and $R^{X3}$ are each independently preferably a hydrogen atom.

In a case where $R^1$ and $R^2$ are bonded to each other to form a ring structure, the structure formed by the bonding of $R^{X2}$ and $R^{X3}$ is preferably a single bond, -O-, or $-CR_2-$, more preferably -O- or $-CR_2-$, and still more preferably -O-. R represents a hydrogen atom or a monovalent organic group, preferably a hydrogen atom, an alkyl group, or an aryl group, and more preferably a hydrogen atom.

In a case where $X^1$ is a group including a structure obtained by removing two or more hydrogen atoms from a structure represented by Formula (V-1), $X^1$ is preferably a group represented by Formula (V-1-1). In the following Formula, * represents a bonding site to four carbonyl groups to which $X^1$ in Formula (1-1) is bonded, and n1 represents an integer of 0 to 5, and it is also preferable that n1 is an integer of 1 to 5. In addition, the hydrogen atom in the following structure may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

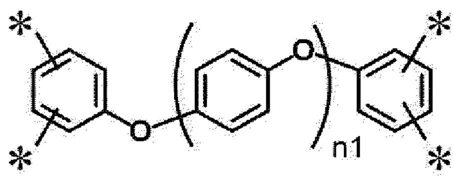

(V-1-1)

In a case where $X^1$ is a group including a structure obtained by removing two or more hydrogen atoms from a structure represented by Formula (V-2), $X^1$ is preferably a group represented by Formula (V-2-1) or Formula (V-2-2), and from the viewpoint of reducing the amine value in the resin, $X^1$ is preferably a group represented by Formula (V-2-2). In the present specification, a bond that intersects with a side of a ring structure means that any hydrogen atom in the ring structure is substituted. In the following Formula, $L^{X1}$ represents a single bond or -O-, and * represents a bonding site to four carbonyl groups to which $X^1$ in Formula (1-1) is bonded. In addition, the definition and preferred aspect of $R^{X1}$ are as described above. In addition, the hydrogen atom in these structures may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

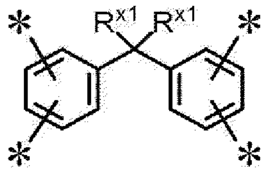

(V-2-1)

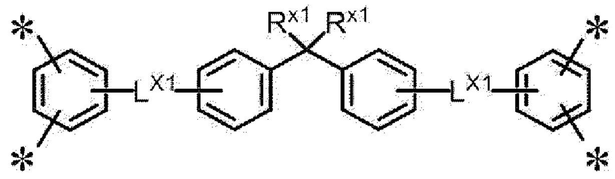

(V-2-2)

In a case where $X^1$ is a group including a structure obtained by removing two or more hydrogen atoms from a structure represented by Formula (V-3), $X^1$ is preferably a group represented by Formula (V-3-1) or Formula (V-3-2), and from the viewpoint of reducing the dielectric constant, $X^1$ is preferably a group represented by Formula (V-3-2). In the following Formula, * represents a bonding site to four carbonyl groups to which $X^1$ in Formula (1-1) is bonded. In addition, the definitions and preferred aspects of $R^{X2}$ and $R^{X3}$ are as described above. In addition, the hydrogen atom in these structures may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

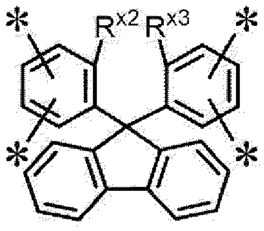

(V-3-1)

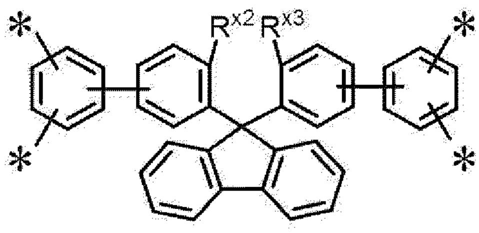

(V-3-2)

In a case where $X^1$ is a group including a structure obtained by removing two or more hydrogen atoms from a structure represented by Formula (V-4), $X^1$ is preferably a group represented by Formula (V-4-1). In the following Formula, * represents a bonding site to four carbonyl groups to which $X^1$ in Formula (1-1) is bonded, and n1 represents an integer of 0 to 5. In addition, the hydrogen atom in the following structure may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

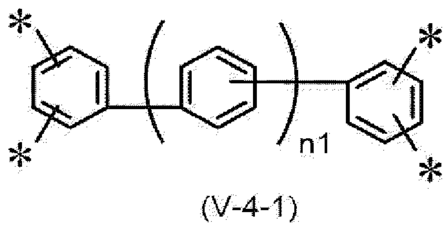

(V-4-1)

In addition, $X^1$ may be a group obtained by removing m hydrogen atoms from a group represented by $R^{132}$ in Formula (4) described later.

In addition, it is preferable that $X^1$ does not contain an imide structure in the structure.

In the present invention, the imide structure is a structure represented by -C(=O)N(-*)C(=O)-. * represents a bonding site to another structure.

In addition, it is preferable that $X^1$ does not contain a urethane bond, a urea bond, and an amide bond in the structure.

In the present invention, the urethane bond is a bond represented by *-O-C(=O)-NR$^N$-*, where $R^N$ represents a hydrogen atom or a monovalent organic group, and *'s each represent a bonding site to a carbon atom. $R^N$ is preferably a hydrogen atom, an alkyl group, or an aryl group, and more preferably a hydrogen atom.

In the present invention, the urea bond is a bond represented by *-NR$^N$-C(=O)-NR$^N$-*, where $R^N$'s each independently represent a hydrogen atom or a monovalent organic group, and *'s each represent a bonding site to a carbon atom. The preferred aspect of $R^N$ is as described above.

In the present invention, the amide bond is a bond represented by *-N$^R$N-C(=O)-*, where $R^N$ represents a hydrogen atom or a monovalent organic group, and *'s each represent a bonding site to a carbon atom. The preferred

aspect of $R^N$ is as described above.

Furthermore, it is preferable that $X^1$ does not contain an ester bond in the structure.

In the present invention, the ester bond is a bond represented by *-O-C(=O)-*.

Among these, it is preferable that $X^1$ does not contain an imide structure, a urethane bond, a urea bond, and an amide bond, and it is more preferable that $X^1$ does not contain an imide structure, a urethane bond, a urea bond, an amide bond, and an ester bond.

$-Y^1-$

In Formula (1-1), $Y^1$ is preferably a group including a structure obtained by removing two or more hydrogen atoms from the structure represented by any one of Formulae (V-1) to (V-4) described above.

In a case where $Y^1$ is a group including a structure obtained by removing two or more hydrogen atoms from a structure represented by Formula (V-1), $Y^1$ is preferably a group obtained by removing n hydrogen atoms from a group represented by Formula (V-1-2). In the following Formula, * represents a bonding site to two nitrogen atoms to which $Y^1$ in Formula (1-1) is bonded, and n1 represents an integer of 1 to 5. n hydrogen atoms in the following structure are substituted with $R^1$ in Formula (1-1). n has the same meaning as n in Formula (1-1). In addition, the hydrogen atom in the following structure may be further substituted with a known substituent such as a hydroxy group or a hydrocarbon group.

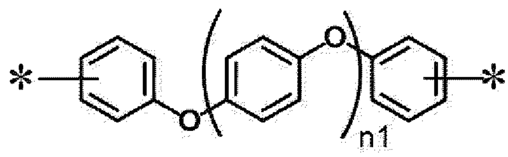

(V-1-2)

In a case where $Y^1$ is a group including a structure obtained by removing two or more hydrogen atoms from a structure represented by Formula (V-2), $Y^1$ is preferably a group represented by Formula (V-2-3) or Formula (V-2-4), and from the viewpoint of reducing the dielectric constant, $Y^1$ is preferably a group represented by Formula (V-2-4). In the following Formula, $L^{X1}$ represents a single bond or -O-, and * represents a bonding site to two nitrogen atoms to which $Y^1$ in Formula (1-1) is bonded. In addition, the preferred aspect of $R^{X1}$ is as described above. n hydrogen atoms in the following structure are substituted with $R^1$ in Formula (1-1). n has the same meaning as n in Formula (1-1). In addition, the hydrogen atom in these structures may be further substituted with a known substituent such as a hydroxy group or a hydrocarbon group.

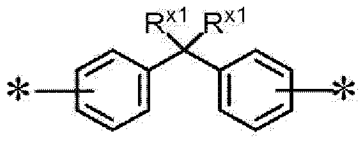

(V-2-3)

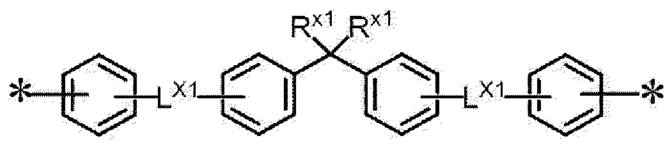

(V-2-4)

In a case where $Y^1$ is a group including a structure obtained by removing two or more hydrogen atoms from a structure represented by Formula (V-3), $Y^1$ is preferably a group represented by Formula (V-3-3) or Formula (V-3-4), and from the viewpoint of reducing the dielectric constant, $Y^1$ is preferably a group represented by Formula (V-3-3). In the following Formula, * represents a bonding site to two nitrogen atoms to which $Y^1$ in Formula (1-1) is bonded. In addition, the preferred aspects of $R^{X2}$ and $R^{X3}$ are as described above. n hydrogen atoms in the following structure are substituted with $R^1$ in Formula (1-1). n has the same meaning as n in Formula (1-1). In addition, the hydrogen atom in these structures may be further substituted with a known substituent such as a hydroxy group or a hydrocarbon group.

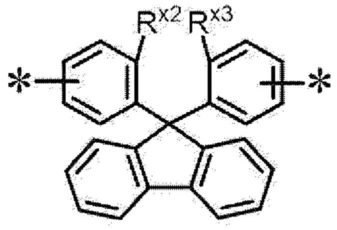

(V-3-3)

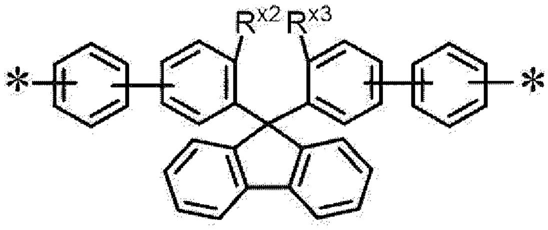

(V-3-4)

In a case where $Y^1$ is a group including a structure obtained by removing two or more hydrogen atoms from a structure represented by Formula (V-4), $Y^1$ is preferably a group represented by Formula (V-4-2). In the following Formula, * represents a bonding site to two nitrogen atoms to which $Y^1$ in Formula (1-1) is bonded, and n1 represents an integer of 0 to 5. In addition, an aspect in which n1 is 0 is also one of the preferred aspects of the present invention. n hydrogen atoms in the following structure are substituted with $R^1$ in Formula (1-1). n has the same meaning as n in Formula (1-1). In addition, the hydrogen atom in the following structure may be further substituted with a known substituent such as a hydroxy group or a hydrocarbon group.

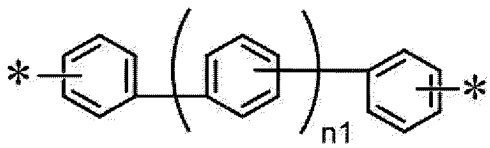

(V-4-2)

In addition, $Y^1$ may be a group obtained by removing n hydrogen atoms from a group represented by $R^{131}$ in Formula (4) described later.

In addition, it is preferable that $Y^1$ does not contain an imide structure in the structure.

In addition, it is preferable that $Y^1$ does not contain a urethane bond, a urea bond, and an amide bond in the structure.

Furthermore, it is preferable that $Y^1$ does not contain an ester bond in the structure.

Among these, it is preferable that $Y^1$ does not contain an imide structure, a urethane bond, a urea bond, and an amide bond, and it is more preferable that $Y^1$ does not contain an imide structure, a urethane bond, a urea bond, an amide bond, and an ester bond.

Among these, it is preferable that $X^1$ and $Y^1$ in Formula (1-1) each include a structure obtained by removing two or more hydrogen atoms from a structure represented by any one of Formulae (V-1) to (V-4).

In Formula (1-1), m is preferably an integer of 0 to 2, and more preferably 0 or 1. In addition, an aspect in which m is 0 is also one of the preferred aspects of the present invention.

In Formula (1-1), n is preferably 1 or 2, and more preferably 2.

It is also preferable that the first specific resin and the second specific resin include a repeating unit represented by Formula (1-2).

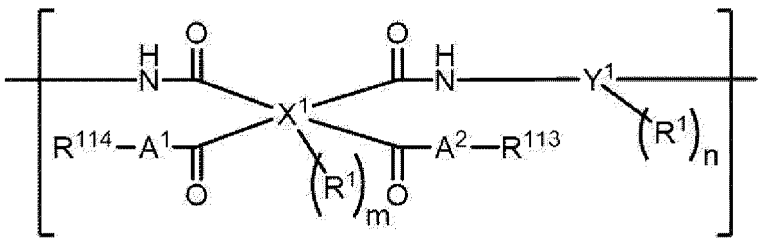

(1-2)

In Formula (1-2), $A^1$ and $A^2$ each independently represent an oxygen atom or $-NR^z-$, $X^1$ represents an organic group having 4 or more carbon atoms, $Y^1$ represents an organic group having 4 or more carbon atoms, $R^1$'s each independently represent a structure represented by Formula (R-1), $R^{113}$ and $R^{114}$ each independently represent a hydrogen atom or a monovalent organic group, $R^z$ represents a hydrogen atom or a monovalent organic group, m represents an integer of 0 to 4, and n represents an integer of 1 or more.

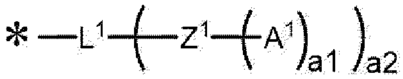

(R-1)

In Formula (R-1), $L^1$ represents an (a2+1)-valent linking group, $Z^1$ represents an aromatic group or a cyclic aliphatic group, $A^1$ represents a polymerizable group, a1 represents an integer of 0 or more and equal to or less than a maximum number of substituents of $Z^1$, a2 represents an integer of 1 or more, and * represents a bonding site to $X^1$ or $Y^1$ in Formula (1-2).

Preferred aspects of $X^1$, $Y^1$, $R^1$, n, and m in Formula (1-2) are the same as the preferred aspects of $X^1$, $Y^1$, $R^1$, n, and m in Formula (1-1) described above.

Preferred aspects of $A^1$, $A^2$, $R^{113}$, and $R^{114}$ in Formula (1-2) are the same as the preferred aspects of $A^1$, $A^2$, $R^{113}$, and $R^{114}$ in Formula (2) described later.

The first specific resin and the second specific resin may include a repeating unit represented by Formula (2).

The repeating unit corresponding to the repeating unit represented by Formula (1-2) does not correspond to the repeating unit represented by Formula (2).

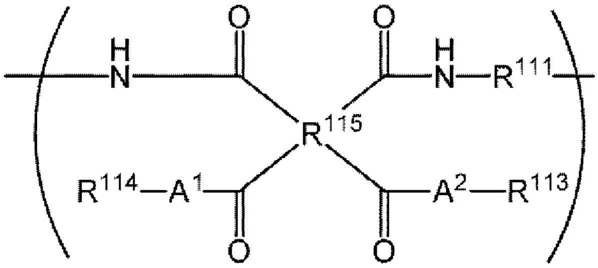

(2)

In Formula (2), $A^1$ and $A^2$ each independently represent an oxygen atom or $-NR^z-$, $R^{111}$ represents a divalent organic group, $R^{115}$ represents a tetravalent organic group, $R^{113}$ and $R^{114}$ each independently represent a hydrogen atom or a monovalent organic group, and $R^Z$ represents a hydrogen atom or a monovalent organic group.

$A^1$ and $A^2$ in Formula (2) each independently represent an oxygen atom or $-NR^Z-$, and an oxygen atom is preferable.

$R^Z$ represents a hydrogen atom or a monovalent organic group, and a hydrogen atom is preferable.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of $R^{111}$ in Formula (2) include groups represented by -Ar- and -Ar-L-Ar-, respectively, and a group represented by -Ar-L-Ar- is preferable. However, Ar's are each independently an aromatic group, and L is a single bond or an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine include a linear or branched aliphatic, cyclic aliphatic, or aromatic diamine. One kind of diamine may be used alone, or two or more kinds thereof may be used.

Specifically, $R^{111}$ is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

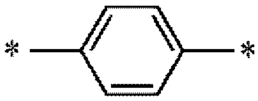
AR-1

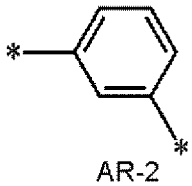
AR-2

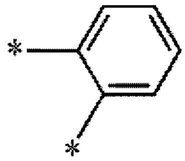
AR-3

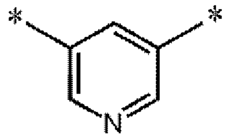
AR-4

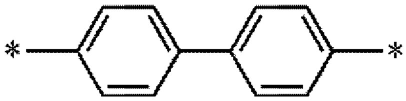
AR-5

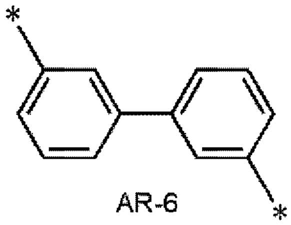
AR-6

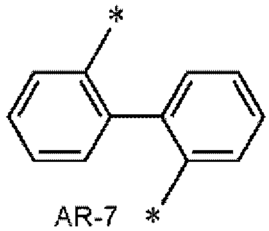
AR-7

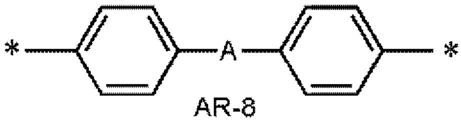
AR-8

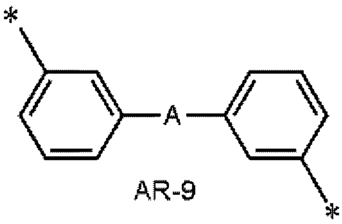
AR-9

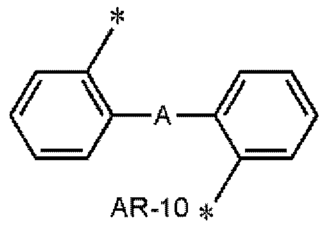
AR-10

In Formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In Formulae, * represents a bonding site to another structure.

Specific examples of diamine include at least one diamine selected from 1,2-diaminoethane, 1,2-diaminopropane, 1,3-diaminopropane, 1,4-diaminobutane, or 1,6-diaminohexane;

1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, and isophoronediamine;

m- or p-phenylenediamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane,

2,2-bis(3-hydroxy-4-aminophenyl)propane,

2,2-bis(3-hydroxy-4-aminophenyl)hexafluoropropane,

2,2-bis(3-amino-4-hydroxyphenyl)propane,

2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4'-bis(4-aminophenoxy)biphenyl, bis[4-(4-aminophenoxy)phenyl] sulfone, bis[4-(3-aminophenoxy)phenyl]sulfone, bis[4-(2-aminophenoxy)phenyl]sulfone, 1,4-bis(4-aminophenoxy) benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane,

9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl) fluorene, 4,4'-dimethyl-3,3'-diaminodiphenyl sulfone, 3,3',5,5'-tetramethyl-4,4'-diaminodiphenylmethane, 2,4- and 2,5-diaminocumen, 2,5-dimethyl-p-phenylenediamine, acetoguanamine, 2,3,5,6-tetramethyl-p-phenylenediamine, 2,4,6-trimethyl-m-phenylenediamine, bis(3-aminopropyl)tetramethyldisiloxane, bis(p-aminophenyl)octamethylpentasiloxane, 2,7-diaminofluorene, 2,5-diaminopyridine, 1,2-bis(4-aminophenyl)ethane, diaminobenzanilide, an ester

of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane,
2,2-bis[4-(3-aminophenoxy)phenyl]hexafluoropropane,
2,2-bis[4-(2-aminophenoxy)phenyl]hexafluoropropane,
2,2-bis[4-(4-aminophenoxy)-3,5-dimethylphenyl]hexafluoropropane,
2,2-bis[4-(4-aminophenoxy)-3,5-bis(trifluoromethyl)phenyl]hexafluoropropane, p-bis(4-amino-2-trifluoromethylphenoxy)benzene,
4,4'-bis(4-amino-2-trifluoromethylphenoxy)biphenyl,
4,4'-bis(4-amino-3-trifluoromethylphenoxy)biphenyl,
4,4'-bis(4-amino-2-trifluoromethylphenoxy)diphenyl sulfone,
4,4'-bis(3-amino-5-trifluoromethylphenoxy)diphenyl sulfone, 2,2-bis[4-(4-amino-3-trifluoromethylphenoxy)phenyl]hexafluoropropane,
3,3',5,5'-tetramethyl-4,4'-diaminobiphenyl, 4,4'-diamino-2,2'-bis(trifluoromethyl)biphenyl, 2,2',5,5',6,6'-hexafluorotolidine, and 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

In addition, $R^{111}$ may be a group including a structure obtained by removing two or more hydrogen atoms from the structure represented by any one of Formula (V-1) to Formula (V-4) described above, and may be a group that does not have a bonding site to $R^1$ described above.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, $R^{111}$ is also preferably a group including a structure obtained by removing two or more hydrogen atoms from the structure represented by any one of Formula (V-1) to Formula (V-4) described above, the group having no bonding site to $R^1$ described above. A preferred aspect of such a group is the same as the preferred aspect of the group including a structure obtained by removing two or more hydrogen atoms from the structure represented by any one of Formulae (V-1) to (V-4) in $Y^1$ included in Formula (1-2), except that the group does not have a bonding site to $R^1$.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

Formula (51)

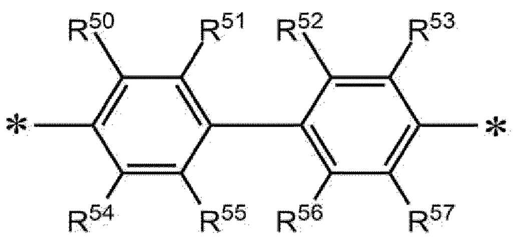

(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6 carbon atoms) carbon atoms and a fluorinated alkyl group having 1 to 10 (preferably 1 to 6 carbon atoms) carbon atoms.

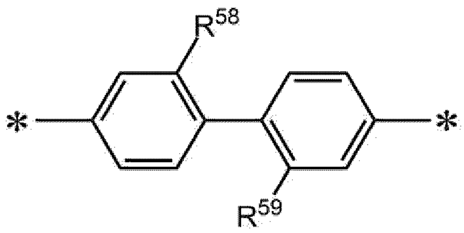 (61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, 2,2'-bis(fluoro)-4,4'-diaminobiphenyl, and 4,4'-diaminooctafluorobiphenyl. These may be used alone, or two or more kinds thereof may be used in combination.

$R^{115}$ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

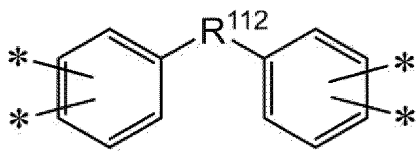 (5) 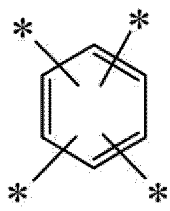 (6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or $-SO_2-$, and still more preferably a divalent group selected from the group consisting of $-CH_2-$, $-C(CF_3)_2-$, $-C(CH_3)_2-$, -O-, -CO-, -S-, and $-SO_2-$.

Specific examples of $R^{115}$ include a tetracarboxylic acid residue that remains after the removal of the anhydride group from the tetracarboxylic acid dianhydride. The first specific resin or the second specific resin may contain only one or two or more kinds of tetracarboxylic acid dianhydride residues as a structure corresponding to $R^{115}$.

The tetracarboxylic acid dianhydride is preferably represented by Formula (O).

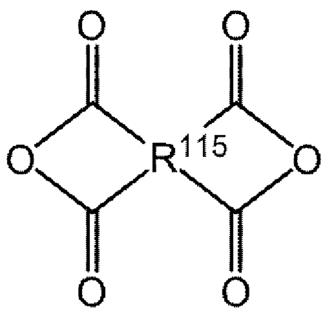 (O)

In Formula (O), $R^{115}$ represents a tetravalent organic group. $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride,

3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In addition, $R^{115}$ is also preferably a group including a structure obtained by removing two or more hydrogen atoms from the structure represented by any one of Formula (V-1) to Formula (V-4) described above, the group having no bonding site to $R^1$ described above. A preferred aspect of such a group is the same as the preferred aspect of the group including a structure obtained by removing two or more hydrogen atoms from the structure represented by any one of Formulae (V-1) to (V-4) included in $X^1$ in Formula (1-2), except that the group does not have a bonding site to $R^1$.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the first specific resin or the second specific resin is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

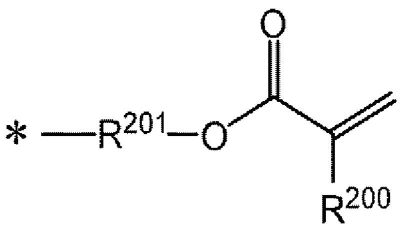

(III)

In Formula (III), $R^{200}$ represents a hydrogen atom, a methyl group, an ethyl group, or a methylol group, where a hydrogen atom or a methyl group is preferable.

In Formula (III), * represents a bonding site to another structure.

In Formula (III), $R^{201}$ represents an alkylene group having 2 to 12 carbon atoms, $-CH_2CH(OH)CH_2-$, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, $-CH_2CH(OH)CH_2-$, and a polyalkyleneoxy group, where an alkylene group such as an ethylene group or a propylene group, $-CH_2CH(OH)CH_2-$, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a randomly arranged sequence, may be a sequence arranged to have a block, or may be a sequence arranged to have an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even more preferably 2 to 5, even still more preferably 2 to 4, even further still more preferably 2 or 3, and particularly

preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polyethyleneoxy group or a polypropyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom or in a case where $R^{114}$ is a hydrogen atom, the first specific resin or the second specific resin may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (2), at least one of $R^{113}$ or $R^{114}$ may be a polarity converting group such as an acid-decomposable group. The acid-decomposable group is not particularly limited as long as it decomposes by the action of the acid to generate an alkali-soluble group such as a phenolic hydroxy group or a carboxy group; however, it is preferably an acetal group, a ketal group, a silyl group, or a silyl ether group, a tertiary alkyl ester group, or the like, and from the viewpoint of exposure sensitivity, it is more preferably an acetal group or a ketal group.

Specific examples of the acid-decomposable group include a tert-butoxycarbonyl group, an isopropoxycarbonyl group, a tetrahydropyranyl group, a tetrahydrofuranyl group, an ethoxyethyl group, a methoxyethyl group, an ethoxymethyl group, a trimethylsilyl group, a tert-butoxycarbonylmethyl group, and a trimethylsilyl ether group. From the viewpoint of exposure sensitivity, an ethoxyethyl group or a tetrahydrofuranyl group is preferable.

The first specific resin and the second specific resin may include a repeating unit represented by Formula (4).

The repeating unit corresponding to the repeating unit represented by Formula (1-1) does not correspond to the repeating unit represented by Formula (4).

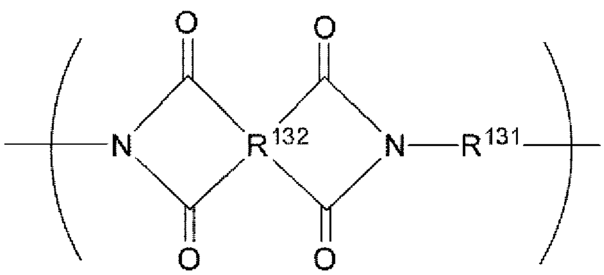

(4)

In Formula (4), $R^{131}$ represents a divalent organic group, and $R^{132}$ represents a tetravalent organic group.

$R^{131}$ represents a divalent organic group. Examples of the divalent organic group include the same one as $R^{111}$ in Formula (2), and the same applies to the preferred range thereof.

Examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trade name) KH-511, ED-600, ED-900, ED-2003, EDR-148, EDR-176, D-200, D-400, D-2000, D-4000 (all product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

Examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include

2,2-bis(3-hydroxy-4-aminophenyl)propane,
2,2-bis(3-hydroxy-4-aminophenyl)hexafluoropropane,
2,2-bis(3-amino-4-hydroxyphenyl)propane,
2,2-bis(3-amino-4-hydroxyphenyl)hexafluoropropane, and the above (DA-1) to (DA-18), and more preferred examples of $R^{132}$ include the above (DAA-1) to (DAA-5).

The first specific resin and the second specific resin may include a repeating unit represented by Formula (3).

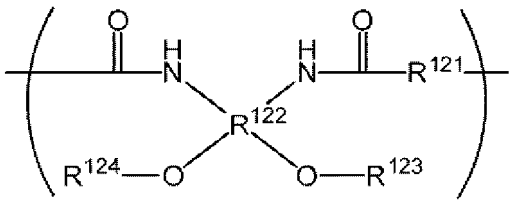

(3)

In Formula (3), $R^{121}$ represents a divalent organic group, $R^{122}$ represents a tetravalent organic group, and $R^{123}$ and $R^{124}$ each independently represent a hydrogen atom or a monovalent organic group.

In Formula (3), $R^{123}$ and $R^{124}$ have the same meanings as $R^{113}$ in Formula (2), and the same applies to the preferred ranges thereof. That is, it is preferable that at least one of them is a polymerizable group.

In Formula (3), $R^{121}$ represents a divalent organic group. The divalent organic group is preferably a group containing at least one of an aliphatic group or an aromatic group. The aliphatic group is preferably a linear aliphatic group. $R^{121}$ is preferably a dicarboxylic acid residue. One kind of dicarboxylic acid residue may be used alone, or two or more kinds thereof may be used.

The dicarboxylic acid residue is preferably a dicarboxylic acid containing an aliphatic group or a dicarboxylic acid residue containing an aromatic group, and more preferably a dicarboxylic acid residue containing an aromatic group.

The dicarboxylic acid containing an aliphatic group is preferably a dicarboxylic acid containing a linear or branched (preferably linear) aliphatic group, and more preferably a dicarboxylic acid consisting of a linear or branched (preferably linear) aliphatic group and two

-COOH. The linear or branched (preferably linear) aliphatic group preferably has 2 to 30 carbon atoms, more preferably 2 to 25 carbon atoms, still more preferably 3 to 20 carbon atoms, even still more preferably 4 to 15 carbon atoms, particularly preferably 5 to 10 carbon atoms. The linear aliphatic group is preferably an alkylene group.

Examples of the dicarboxylic acid containing a linear aliphatic group include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and furthermore, dicarboxylic acids represented by the following Formulae.

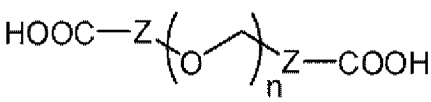 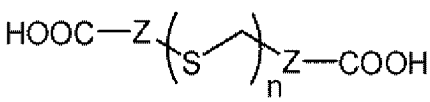

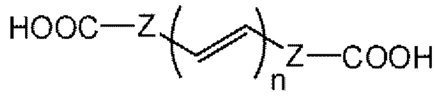 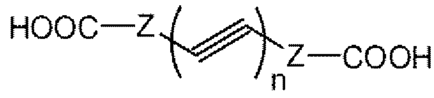

(In Formulae, Z is a hydrocarbon group having 1 to 6 carbon atoms, and n is an integer of 1 to 6).

The dicarboxylic acid containing an aromatic group is preferably a dicarboxylic acid having the following aromatic group and more preferably a dicarboxylic acid consisting of only the following group having an aromatic group and two pieces of -COOH.

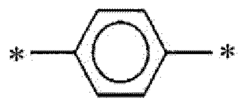 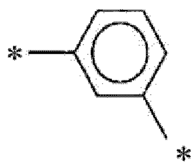 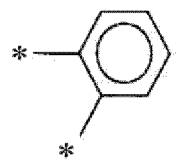 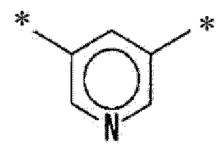

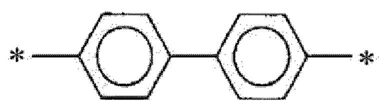 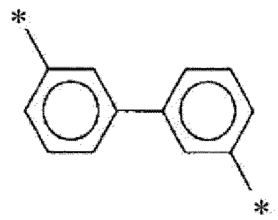 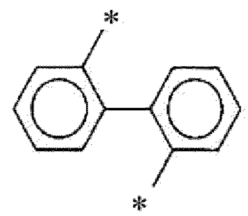

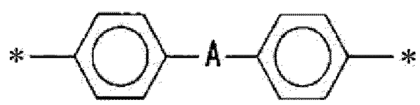 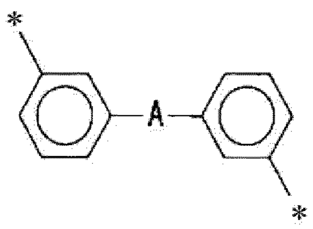 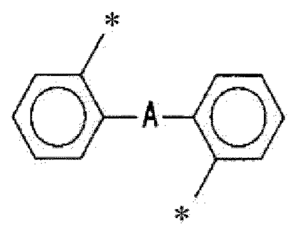

In Formulae, A represents a divalent group selected from the group consisting of $-CH_2-$, -O-, -S-, $-SO_2-$, -CO-, -NHCO-, $-C(CF_3)_2-$, and $-C(CH_3)_2-$, and *'s each independently represent a bonding site to another structure.

Specific examples of the dicarboxylic acid containing an aromatic group include 4,4'-carbonyldibenzoic acid, 4,4'-dicarboxydiphenyl ether, and terephthalic acid.

In Formula (3), $R^{122}$ represents a tetravalent organic group. The tetravalent organic group has the same meaning as $R^{115}$ in Formula (2) described above, and the same applies to the preferred range thereof.

$R^{122}$ is preferably a group derived from a bisaminophenol derivative. Examples of the group derived from the bisaminophenol derivative include 3,3'-diamino-4,4'-dihydroxybiphenyl, 4,4'-diamino-3,3'-dihydroxybiphenyl, 3,3'-diamino-4,4'-dihydroxydiphenylsulfone, 4,4'-diamino-3,3'-dihydroxydiphenylsulfone, bis-(3-amino-4-hydroxyphenyl) methane, 2,2-bis(3-amino-4-hydroxyphenyl)propane, 2,2-bis-(3-amino-4-hydroxyphenyl)hexafluoropropane, 2,2-bis-(4-amino-3-hydroxyphenyl)hexafluoropropane, bis-(4-amino-3-hydroxyphenyl)methane, 2,2-bis-(4-amino-3-hydroxyphenyl)propane, 4,4'-diamino-3,3'-dihydroxybenzophenone, 3,3'-diamino-4,4'-dihydroxybenzophenone, 4,4'-diamino-3,3'-dihydroxydiphenyl ether, 3,3'-diamino-4,4'-dihydroxydiphenyl ether, 1,4-diamino-2,5-dihydroxybenzene, 1,3-diamino-2,4-dihydroxybenzene, and 1,3-diamino-4,6-dihydroxybenzene. These bisaminophenols may be used alone or may be mixedly used.

Among the bisaminophenol derivatives, the bisaminophenol derivative having the following aromatic group is preferable.

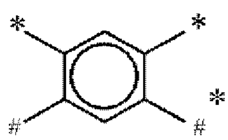 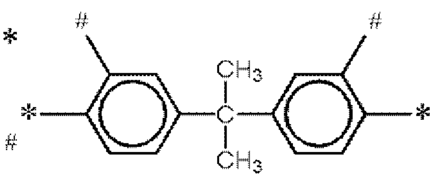 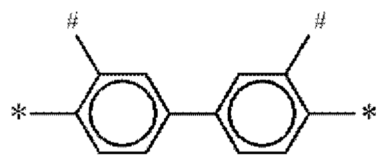

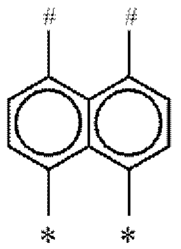
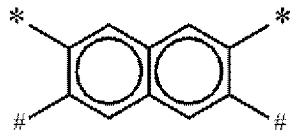
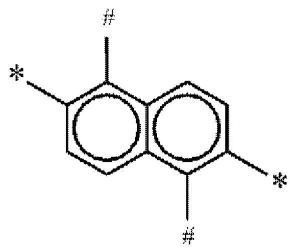

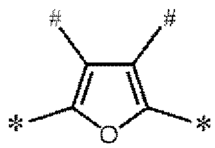
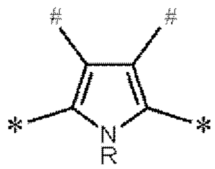
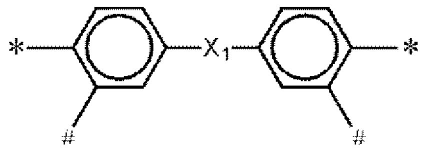

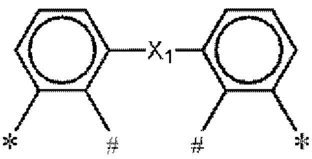

In Formulae, $X_1$ represents -O-, -S-, $-C(CF_3)_2-$, $-CH_2-$, $-SO_2-$, or -NHCO-, and * and # each represent a bonding site to another structure. R represents a hydrogen atom or a monovalent substituent, where a hydrogen atom or a hydrocarbon group is preferable, and a hydrogen atom or an alkyl group is more preferable. In addition, it is also preferable that $R^{122}$ has a structure represented by the above Formula. In a case where $R^{122}$ has a structure represented by the above Formula, it is preferable that any two of a total of four of *'s and #'s are bonding sites to the nitrogen atom to which $R^{122}$ in Formula (3) is bonded and the other two are bonding sites to the oxygen atom to which $R^{122}$ Formula (3) is bonded, it is more preferable that two *'s are bonding sites to the oxygen atom to which $R^{122}$ in Formula (3) is bonded and two #'s are bonding sites to the nitrogen atom to which $R^{122}$ Formula (3) is bonded or that two *'s are bonding sites to the nitrogen atom to which $R^{122}$ in Formula (3) is bonded and two #'s are bonding sites to the oxygen atom to which $R^{122}$ Formula (3) is bonded, and it is still more preferable that two *'s are bonding sites to the oxygen atom to which $R^{122}$ in Formula (3) is bonded and two #'s are bonding sites to the nitrogen atom to which $R^{122}$ Formula (3) is bonded.

The bisaminophenol derivative is also preferably a compound represented by Formula (A-s).

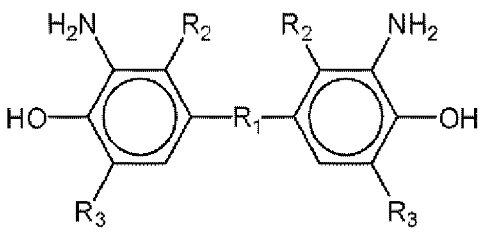
(A-s)

In Formula (A-s), $R_1$ is a hydrogen atom, an alkylene, a substituted alkylene, -O-, -S-, $-SO_2-$, -CO-, -NHCO-, a single bond, or an organic group selected from the group of Formula (A-sc). $R^2$'s are any one of a hydrogen atom, an alkyl group, an alkoxy group, an acyloxy group, or a cyclic alkyl group, and may be the same or different from each other. $R_3$'s are any one of a hydrogen atom, a linear or branched alkyl group, an alkoxy group, an acyloxy group, or a cyclic alkyl group, and may be the same or different from each other.

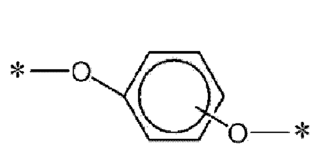
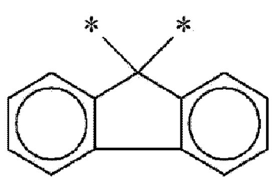
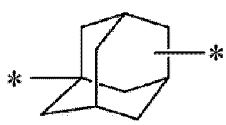

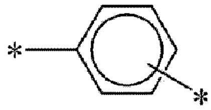 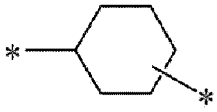 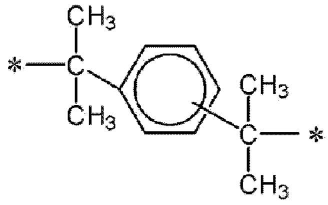 (A－sc)

In the organic group selected from the group of Formula (A-sc), * represents bonding to an aromatic ring of an aminophenol group of the bisaminophenol derivative represented by Formula (A-s).

In Formula (A-s), it is conceived that in a case where a substituent is also provided at the ortho position of the phenolic hydroxy group, that is, $R_3$, the distance between the carbonyl carbon of the amide bond and the hydroxy group is reduced, and such a case is particularly preferable since the effect that the cyclization rate rises in a case where curing is carried out at a low temperature is further enhanced.

In Formula (A-s), in a case where $R_2$ is an alkyl group and $R_3$ is an alkyl group, it is possible to maintain the high transparency to the i-line and the effect that the cyclization rate is high in a case where curing is carried out at a low temperature, which is preferable.

In Formula (A-s), it is more preferable that $R_1$ is an alkylene or a substituted alkylene. Specific examples of the alkylene and the substituted alkylene, which is involved in $R_1$ include linear or branched alkyl groups having 1 to 8 carbon atoms. However, among them, $-CH_2-$, $-CH(CH_3)-$, or $-C(CH_3)_2-$ is more preferable since it is possible to obtain a specific resin excellent in balance in terms of having sufficient solubility in a solvent while maintaining the high transparency to the i-line and the effect that the cyclization rate is high in a case where curing is carried out at a low temperature.

As a method of producing the bisaminophenol derivative represented by Formula (A-s), for example, paragraph Nos. 0085 to 0094 and Example 1 (paragraph Nos. 0189 to 0190) of JP2013-256506A can be referenced, the content of which is incorporated in the present specification by reference.

Specific examples of the structure of the bisaminophenol derivative represented by Formula (A-s) include those described in paragraph Nos. 0070 to 0080 of JP2013-256506A, the content of which is incorporated in the present specification. Specific examples of the structure of the bisaminophenol derivative represented by Formula (A-s) are not limited thereto.

From the viewpoint of suppressing occurrence of warping associated with closing the loop, it is preferable that the first specific resin and the second specific resin include a diamine residue represented by Formula (SL) as another type of repeating unit.

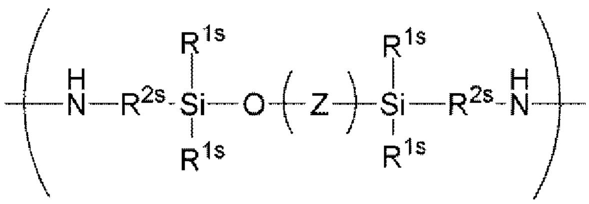 (SL)

a: 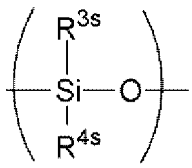 b: 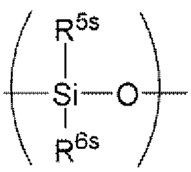

**In** Formula (SL), Z has a structure and a b structure, $R^{1s}$ is a hydrogen atom or a hydrocarbon group having 1 to 10 carbon atoms, $R^{2s}$ is a hydrocarbon group having 1 to 10 carbon atoms, and at least one of $R^{3s}$, $R^{4s}$, $R^{5s}$, or $R^{6s}$ is an aromatic group, where the rest are a hydrogen atom or an organic group having 1 to 30 carbon atoms and may be the same or different from each other. The polymerization of the a structure and the b structure may be block polymerization or random polymerization. Regarding the contents of the structures in the Z portion in terms of "% by mole", the content of the a structure is 5% to 95% by mole and the content of the b structure is 95% to 5% by mole, the sum (the content of the a structure + the content of the b structure) is 100% by mole.

**In** Formula (SL), examples of the preferred Z include one in which $R^{5s}$ and $R^{6s}$ in the b structure are a phenyl group. The molecular weight of the a structure represented by Formula (SL) is preferably 400 to 4,000 and more preferably 500 to 3,000. **In** a case where the molecular weight is within the above-described range, it is possible to more effectively decrease an elastic modulus of a specific resin after the dehydration ring closure and to achieve both effects of suppressing

warping and improving solubility in a solvent.

In a case where a diamine residue represented by Formula (SL) is contained as another kind of repeating unit, it is also preferable that a tetracarboxylic acid residue that has remained after removing an anhydride group from the tetracarboxylic acid dianhydride is further contained as a repeating unit. Examples of such a tetracarboxylic acid residue include the examples of $R^{115}$ in Formula (2).

The first specific resin and the second specific resin may include a repeating unit represented by Formula (3).

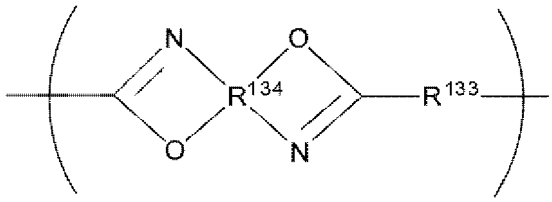

(X)

In Formula (X), $R^{133}$ represents a divalent organic group, and $R^{134}$ represents a tetravalent organic group.

In a case where the polarity converting group such as a polymerizable group or an acid-decomposable group is contained, the polarity converting group such as a polymerizable group or an acid-decomposable group may be located at at least one of $R^{133}$ or $R^{134}$, or may be located at a terminal of the specific resin as shown in Formula (X-1) or Formula (X-2).

Formula (X-1)

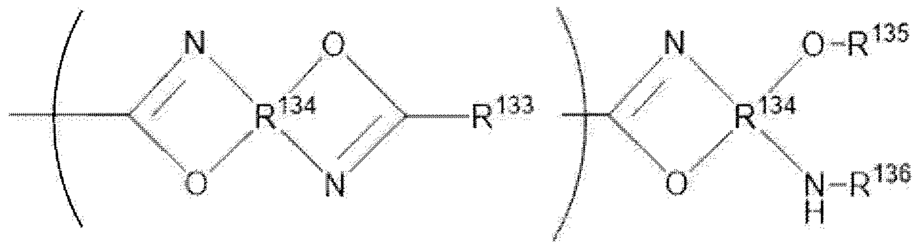

In Formula (X-1), at least one of $R^{135}$ or $R^{136}$ is a polymerizable group or a polarity converting group such as an acid-decomposable group, or it is an organic group in a case where it is not a polymerizable group or a polarity converting group such as an acid-decomposable group, and other groups are the same as those in Formula (X).

Formula (X-2)

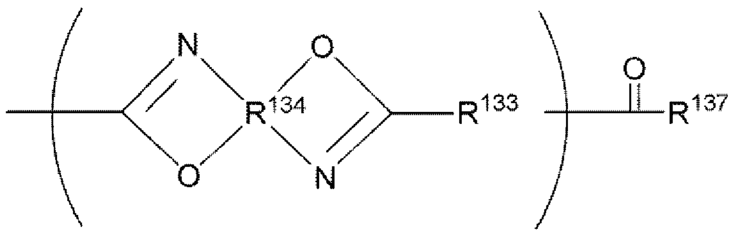

In Formula (X-2), $R^{137}$ is a polymerizable group or a polarity converting group such as an acid-decomposable group, others are substituents, and other groups are the same as those in Formula (X).

The polymerizable group or the polarity converting group such as an acid-decomposable group has the same meaning as the polymerizable group described above for the polymerizable group contained in the polyimide precursor.

$R^{133}$ represents a divalent organic group. Examples of the divalent organic group include an aliphatic group and an aromatic group. Specific examples thereof include examples of $R^{121}$ in Formula (3) of the polybenzoxazole precursor, and preferred examples thereof are the same as those for $R^{121}$.

$R^{134}$ represents a tetravalent organic group. Examples of the tetravalent organic group include examples of $R^{122}$ in Formula (3) of the polybenzoxazole precursor, and preferred examples thereof are the same as those for $R^{122}$.

For example, four bonding partners of the tetravalent organic group exemplified as $R^{122}$ are bonded to the nitrogen atom and the oxygen atom in Formula (X) to form a fused ring. For example, in a case where $R^{134}$ is the following organic group, the following structure is formed. In the following structure, each * represents a bonding site to a nitrogen atom or an oxygen atom in Formula (X).

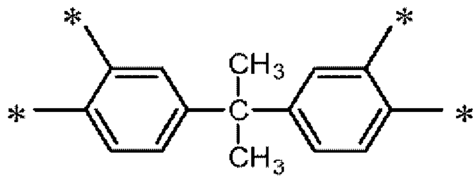

**In** a case where the first specific resin or the second specific resin is a polyimide, the content of the repeating unit represented by Formula (1-1) is preferably 30% by mass or more, more preferably 50% by mass or more, still more preferably 70% by mass or more, and particularly preferably 80% by mass or more with respect to the total mass of the first specific resin or the second specific resin. The upper limit of the content is not particularly limited, and may be 100% by mass.

In addition, the first specific resin or the second specific resin may contain two or more kinds of repeating units represented by Formula (1-1) having different structures. In that case, it is preferable that the total amount is within the above-described range.

In a case where the first specific resin or the second specific resin is a polyimide, the total content of the repeating unit represented by Formula (1-1) and the repeating unit represented by Formula (4) is preferably 50% by mass or more, preferably 70% by mass or more, more preferably 80% by mass or more, and particularly preferably 90% by mass or more with respect to the total mass of the first specific resin or the second specific resin. The upper limit of the content is not particularly limited, and may be 100% by mass.

In addition, in a case where the first specific resin or the second specific resin includes a repeating unit represented by Formula (4), the first specific resin or the second specific resin may include two or more kinds of repeating units represented by Formula (4) having different structures. In that case, it is preferable that the total amount is within the above-described range.

In a case where the first specific resin or the second specific resin is a polyimide precursor, the content of the repeating unit represented by Formula (1-2) is preferably 30% by mass or more, more preferably 50% by mass or more, still more preferably 70% by mass or more, and particularly preferably 80% by mass or more with respect to the total mass of the first specific resin or the second specific resin. The upper limit of the content is not particularly limited, and may be 100% by mass.

In addition, the first specific resin or the second specific resin may contain two or more kinds of repeating units represented by Formula (1-2) having different structures. In that case, it is preferable that the total amount is within the above-described range.

In a case where the first specific resin or the second specific resin is a polyimide precursor, the total content of the repeating unit represented by Formula (1-2) and the repeating unit represented by Formula (2) is preferably 50% by mass or more, preferably 70% by mass or more, more preferably 80% by mass or more, and particularly preferably 90% by mass or more with respect to the total mass of the first specific resin or the second specific resin. The upper limit of the content is not particularly limited, and may be 100% by mass.

In addition, in a case where the first specific resin or the second specific resin includes a repeating unit represented by Formula (2), the first specific resin or the second specific resin may include two or more kinds of repeating units represented by Formula (2) having different structures. In that case, it is preferable that the total amount is within the above-described range.

The third resin composition includes a resin (third specific resin) which is at least one resin selected from the group consisting of a polyimide and a precursor thereof and includes at least one of a repeating unit represented by Formula (2-1) or a repeating unit represented by Formula (3-1).

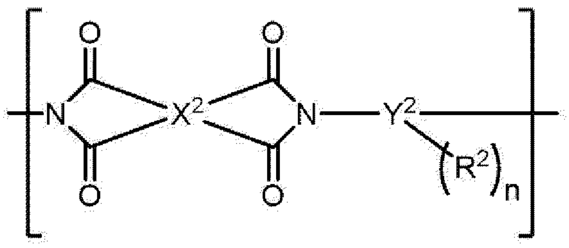

(2-1)

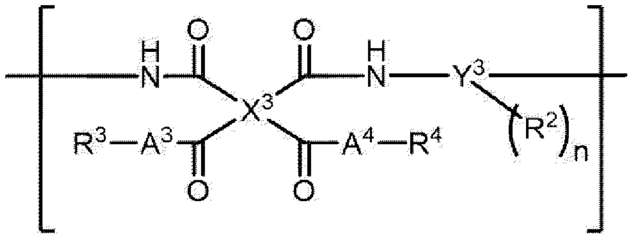

(3-1)

In Formula (2-1), $X^2$ represents an organic group having 4 or more carbon atoms, $Y^2$ represents an organic group having 4 or more carbon atoms, $Y^2$ does not include an ester bond, $R^2$'s each independently represent a group represented by Formula (R-2), and n represents an integer of 1 or more.

In Formula (3-1), $X^3$ represents an organic group having 4 or more carbon atoms, $Y^3$ represents an organic group having 4 or more carbon atoms, $Y^3$ does not include an ester bond, $A^3$ and $A^4$ each independently represent an oxygen atom or $-NR^N-$, $R^3$ and $R^4$ each independently represent a hydrogen atom or a monovalent organic group, $R^2$'s each independently represent a group represented by Formula (R-2), and n represents an integer of 1 or more.

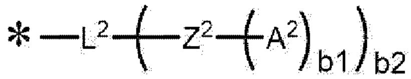

(R-2)

In Formula (R-2), $L^2$ represents a (b2+1)-valent linking group, $Z^2$ represents a (b1+1)-valent organic group, $A^2$ represents a polymerizable group, b1 represents an integer of 1 or more and equal to or less than a maximum number of substituents of $Z^2$, b2 represents an integer of 1 or more, * represents a bonding site to $Y^2$ in Formula (2-1) or $Y^3$ in Formula (3-1), and the number of ester bonds included in Formula (R-2) is 1 or 0.

Preferred aspects of $X^2$, $Y^2$, and n in Formula (2-1) are the same as the preferred aspects of $X^1$, $Y^1$, and n in Formula (1-1).

Preferred aspects of $L^2$, $A^2$, b1, and b2 in Formula (R-2) are the same as the preferred aspects of $L^1$, $A^1$, a1, and a2 in Formula (R-1).

In addition, the number of ester bonds included in Formula (R-2) is 1 or 0, and it is also one of the preferred aspects of the present invention that the number of ester bonds is 0.

In Formula (R-2), $Z^2$ is preferably a group including a ring structure, and more preferably a group obtained by removing b1+1 hydrogen atoms from the ring structure.

The preferred aspect of the ring structure in $Z^2$ is the same as a preferred aspect of the ring structure with 5 or more membered rings in the above-described first specific resin.

In addition, in a case where $Z^2$ is a group obtained by removing b1+1 hydrogen atoms from a ring structure, $Z^2$ is preferably an aromatic group or a cyclic aliphatic group. In addition, the preferred aspect of $Z^2$ in the above-described aspect is the same as the preferred aspect of $Z^1$ in Formula (R-1) described above.

In addition, $Z^2$ may be a hydrocarbon group or a group represented by a combination of a hydrocarbon group and at least one structure selected from the group consisting of -O-, -CO-, -S-, $-SO_2-$, and $-NR^N-$. The preferred aspect of $R^N$ is as described above.

In Formula (R-2), $L^2$ is preferably a group represented by Formula (L-2). In addition, it is more preferable that $L^2$ is a group represented by Formula (L-2) and $A^2$ in Formula (R-2) is a vinyl group or a vinyl ether group.

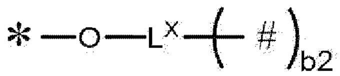

(L-2)

In Formula (L-2), $L^x$ represents a (b2+1)-valent linking group, b2 represents an integer of 1 or more, * represents a bonding site to $X^2$ or $Y^2$ in Formula (2-1) or $X^3$ or $Y^3$ in Formula (3-1), and # represents a bonding site to $Z^2$ in Formula (R-2).

In Formula (L-2), a preferred aspect of $L^X$ is the same as the preferred aspect of $L^X$ in Formula (L-1) described above.

In Formula (L-2), b2 has the same meaning as b2 in Formula (R-2), and the same applies to the preferred aspect thereof.

Among these, it is preferable that at least one of $A^2$'s in Formula (R-2) included in Formula (2-1) is a vinyl group, a (meth)acryloxy group, a vinyl ether group, an allyl group, an epoxy group, or a group including these groups, at least one of $A^2$'s in Formula (R-2) included in Formula (3-1) is a vinyl group, a (meth)acryloxy group, a vinyl ether group, an allyl group, an epoxy group, or a group including these groups, $X^2$ and $Y^2$ in Formula (2-1) each include a structure obtained by removing two or more hydrogen atoms from a structure represented by any one of Formulae (V-1) to (V-4), and $X^3$ and $Y^3$ in

Formula (3-1) each include a structure obtained by removing two or more hydrogen atoms from a structure represented by any one of Formulae (V-1) to (V-4).

In addition, the third specific resin may include the above-described repeating unit represented by Formula (2). However, the repeating unit represented by Formula (3-1) is not included in the repeating unit represented by Formula (2) in this case.

In addition, the third specific resin may include the above-described repeating unit represented by Formula (4). However, the repeating unit represented by Formula (4-1) is not included in the repeating unit represented by Formula (4) in this case.

In a case where the third specific resin is a polyimide, the content of the repeating unit represented by Formula (2-1) is preferably 30% by mass or more, more preferably 50% by mass or more, still more preferably 70% by mass or more, and particularly preferably 80% by mass or more with respect to the total mass of the third specific resin. The upper limit of the content is not particularly limited, and may be 100% by mass.

In addition, the third specific resin may contain two or more kinds of repeating units represented by Formula (2-1) having different structures. In that case, it is preferable that the total amount is within the above-described range.

In a case where the third specific resin is a polyimide, the total content of the repeating unit represented by Formula (1-1) and the repeating unit represented by Formula (4) is preferably 50% by mass or more, preferably 70% by mass or more, more preferably 80% by mass or more, and particularly preferably 90% by mass or more with respect to the total mass of the third specific resin. The upper limit of the content is not particularly limited, and may be 100% by mass.

In addition, in a case where the third specific resin includes a repeating unit represented by Formula (4), the third specific resin may include two or more kinds of repeating units represented by Formula (4) having different structures. In that case, it is preferable that the total amount is within the above-described range.

In a case where the third specific resin is a polyimide precursor, the content of the repeating unit represented by Formula (1-2) is preferably 30% by mass or more, more preferably 50% by mass or more, still more preferably 70% by mass or more, and particularly preferably 80% by mass or more with respect to the total mass of the third specific resin. The upper limit of the content is not particularly limited, and may be 100% by mass.

In addition, the third specific resin may contain two or more kinds of repeating units represented by Formula (1-2) having different structures. In that case, it is preferable that the total amount is within the above-described range.

In a case where the third specific resin is a polyimide precursor, the total content of the repeating unit represented by Formula (1-2) and the repeating unit represented by Formula (2) is preferably 50% by mass or more, preferably 70% by mass or more, more preferably 80% by mass or more, and particularly preferably 90% by mass or more with respect to the total mass of the third specific resin. The upper limit of the content is not particularly limited, and may be 100% by mass.

In addition, in a case where the third specific resin includes a repeating unit represented by Formula (2), the third specific resin may include two or more kinds of repeating units represented by Formula (2) having different structures. In that case, it is preferable that the total amount is within the above-described range.

In a case where the specific resin is a polyimide, the weight-average molecular weight (Mw) is preferably 3,000 to 100,000, more preferably 5,000 to 50,000, and still more preferably 10,000 to 40,000. In a case where the weight-average molecular weight is set to 3,000 or more, it is possible to improve the breakage resistance of the film after curing. In order to obtain an organic film having excellent mechanical properties (for example, breaking elongation), the weight-average molecular weight is particularly preferably 5,000 or more.

The number-average molecular weight (Mn) of the polyimide is preferably 1,000 to 40,000, more preferably 2,000 to 30,000, and still more preferably 5,000 to 20,000.

The dispersivity of the molecular weight of the polyimide is preferably 1.5 or more, more preferably 1.8 or more, and still more preferably 2.0 or more. The upper limit value of the dispersivity of the molecular weight of the polyimide is not particularly limited; however, it is, for example, preferably 7.0 or less, more preferably 6.5 or less, and still more preferably 6.0 or less.

In a case where the resin composition contains a plurality of kinds of polyimides as the specific resin, it is preferable that the weight-average molecular weight, the number-average molecular weight, and the dispersivity of at least one kind of polyimide are in the above ranges. It is also preferable that the weight-average molecular weight, the number-average molecular weight, and the dispersity, calculated by using the plurality of kinds of polyimides as one resin, are within the above ranges.

In a case where the specific resin is a polyimide precursor, the weight-average molecular weight (Mw) is preferably 5,000 to 100,000, more preferably 10,000 to 50,000, and still more preferably 15,000 to 40,000. The number-average molecular weight (Mn) of the polyimide precursor is preferably 2,000 to 40,000, more preferably 3,000 to 30,000, and still more preferably 4,000 to 20,000.

The dispersivity of the molecular weight of the polyimide precursor is preferably 1.5 or more, more preferably 1.8 or more, and still more preferably 2.0 or more. The upper limit value of the dispersivity of the molecular weight of the polyimide precursor is not particularly limited; however, it is, for example, preferably 7.0 or less, more preferably 6.5 or less, and still more preferably 6.0 or less.

In the present specification, the dispersity of the molecular weight is a value obtained by calculating "weight-average molecular weight/number-average molecular weight".

In a case where the resin composition contains a plurality of kinds of polyimide precursors as the specific resin, it is preferable that the weight-average molecular weight, the number-average molecular weight, and the dispersivity of at least one kind of polyimide precursor are in the above ranges. Further, it is also preferable that the weight-average molecular weight, the number-average molecular weight, and the dispersity, calculated by using the plurality of kinds of polyimide precursors as one resin, are within the above ranges.

In a case where the specific resin is polyimide, from the viewpoint of film hardness, insulating properties, and the like of an organic film to be obtained, an imidization rate of the polyimide (also referred to as "ring closure rate") is preferably 70% or more, more preferably 80% or more, and still more preferably 90% or more. The upper limit of the imidization rate is not particularly limited, and it may be any imidization rate of 100% or less.

In addition, in a case where the specific resin is a polyimide, the content of the imide structure in the specific resin is preferably 3 mmol/g or less and more preferably 2.5 mmol/g or less. The lower limit of the above-described content is not particularly limited, but can be, for example, 0.5 mmol/g or more.

In a case where the specific resin is a polyimide precursor, from the viewpoint of film hardness, insulating properties, and the like of an organic film to be obtained, an imidization rate of the polyimide precursor (also referred to as "ring closure rate") is preferably less than 70%, more preferably 50% or less, still more preferably 20% or less, and particularly preferably 10% or less. The lower limit of the imidization rate is not particularly limited, and it may be any imidization rate of 0% or less.

The imidization rate is measured by, for example, the following method.

The infrared absorption spectrum of the specific resin is measured, and a peak intensity P1 in the vicinity of 1,377 $cm^{-1}$, which is the absorption peak derived from the imide structure, is obtained. Next, the specific resin is subjected to a heat treatment at 350°C for 1 hour, and then the infrared absorption spectrum is measured again to obtain a peak intensity P2 in the vicinity of 1,377 $cm^{-1}$. Using the obtained peak intensities P1 and P2, the imidization rate of the specific resin can be determined based on the following expression.

$$\text{Imidization rate (\%)} = (\text{peak intensity P1}/\text{peak intensity P2}) \times 100$$

[Method for producing specific resin]

The specific resin can be obtained by, for example, a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production methods, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

In addition, in a case where a polyimide is desired to be obtained as the specific resin, the polyimide can be synthesized by a method of completely imidizing the resin obtained by the above method using a known imidization reaction method, a method of introducing a partial imide structure by stopping the imidization reaction in the middle of the reaction, or a method of introducing a partial imide structure by blending a completely imidized polymer and a polyimide precursor thereof. In addition, another known method for synthesizing polyimide can also be applied.

In the method for producing the specific resin, it is preferable to use an organic solvent at the time of reaction. One kind of organic solvent may be used, or two or more kinds thereof may be used.

The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and γ-butyrolactone.

In the method for producing the specific resin, it is preferable to add a basic compound in a case of carrying out the

reaction. One kind of basic compound may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

-Terminal blocking agent-

In the method for producing the specific resin, in order to further improve the storage stability, it is preferable to seal a carboxylic acid anhydride, an acid anhydride derivative, or an amino group, which remains at the resin terminal of the specific resin. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid,3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, benzoic anhydride, and 5-norbornene-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

-Solid precipitation-

In the production method for a specific resin, a step of precipitating a solid may be included. Specifically, it is possible to obtain a specific resin by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the specific resin may be repeated. Further, a step of removing ionic impurities using an ion exchange resin may be included.

[Specific Example]

Specific examples of the specific resin include polyimides (SP-1) to (SP-15) and a polyimide precursor (P-1) in Examples described later, but the present invention is not limited thereto.

[Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition,

the content of the resin in the resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

It is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure derived from the dianhydride is different.

<Another resin>

The resin composition according to the embodiment of the present invention may contain the above-described specific resin and another resin (hereinafter, also simply referred to as "the other resin") that is different from the specific resin.

Examples of the other resins include other polyimide precursors different from the specific resin, other polyimides different from the specific resin, polybenzoxazole precursors, polybenzoxazole, polyamideimide precursors, polyamideimide, aromatic polyether, phenol resin, polyamide, epoxy resin, polysiloxane, resin including a siloxane structure, (meth)acrylic resin, (meth)acrylamide resin, urethane resin, butyral resin, styryl resin, polyether resin, and polyester resin.

Examples of the other polyimide precursors, the other polyimides, the polybenzoxazole precursors, the polybenzoxazoles, the polyamideimide precursors, and the polyamideimides include the compounds described in paragraphs 0017 to 0138 of WO2022/145355A. The above description is incorporated in the present specification.

The aromatic polyether is not particularly limited, but is preferably a polyphenylene ether.

The polyphenylene ether preferably includes a repeating unit represented by Formula (PE).

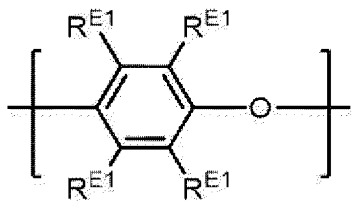

(PE)

In Formula (PE), $R^{E1}$ represents a hydrogen atom or a substituent. Examples of the substituent include a halogen atom, an alkyl group which may have a substituent, an alkoxy group which may have a substituent, an amino group which may have a substituent, a nitro group, and a carboxy group.

In addition, the polyphenylene ether is also preferably a compound having a polymerizable group.

As the polymerizable group, an epoxy group, an oxetanyl group, an oxazolyl group, a methylol group, an alkoxymethyl group, an acyloxymethyl group, a blocked isocyanate group, or a group having an ethylenically unsaturated bond is preferable, and a group having an ethylenically unsaturated bond is more preferable.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth)acryloyloxy group is more preferable, and a (meth)acryloyloxy group is still more preferable.

In a case where the polyphenylene ether is a compound having a polymerizable group, the position of the polymerizable group is not particularly limited, but for example, a structure in which the polymerizable group is introduced at the terminal of the main chain is preferable.

The polyphenylene ether may include other repeating units. However, the content of the other repeating units is preferably 30% by mass or less, more preferably 20% by mass or less, and still more preferably 10% by mass or less with

respect to the total mass of the polyphenylene ether.

The number-average molecular weight of the polyphenylene ether is not particularly limited, but is preferably 500 to 50,000.

The lower limit of the number-average molecular weight is preferably 800 or higher, more preferably 1000 or higher, and still more preferably 1500 or higher.

The upper limit of the number-average molecular weight is preferably 30,000 or less, more preferably 20,000 or less, and still more preferably 10,000 or less.

Specific examples of the polyphenylene ether (PPE) include poly(2,6-dimethyl-1,4-phenylene ether), poly(2-methyl-6-ethyl-1,4-phenylene ether), poly(2-methyl-6-phenyl-1,4-phenylene ether), poly(2,6-dichloro-1,4-phenylene ether), a copolymer of 2,6-dimethylphenol and other phenols (for example, 2,3,6-trimethylphenol, 2-methyl-6-butylphenol, and the like), a polyphenylene ether copolymer obtained by coupling 2,6-dimethylphenol with biphenols or bisphenols, and a polyphenylene ether having a linear structure or a branched structure, which is obtained by heating poly(2,6-dimethyl-1,4-phenylene ether) and the like with phenolic compounds such as bisphenols or trisphenols in a toluene solvent in the presence of an organic peroxide and performing a redistribution reaction, but the present invention is not limited thereto.

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

The content of the other resin in the resin composition according to the embodiment of the present invention is preferably 80% by mass or less, more preferably 75% by mass or less, still more preferably 70% by mass or less, even still more preferably 60% by mass or less, and even further still more preferably 50% by mass or less, with respect to the total solid content of the resin composition.

As the preferred aspect of the resin composition according to the embodiment of the present invention, an aspect in which the content of the other resin is a low content can be adopted. In the above aspect, the content of the other resin is preferably 20% by mass or less, more preferably 15% by mass or less, still more preferably 10% by mass or less, even still more preferably 5% by mass or less, and even further still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. In a case where two or more kinds thereof are contained, the total amount thereof is preferably within the above range.

<Polymerizable compound>

The resin composition according to the embodiment of the present invention contains a polymerizable compound.

In particular, from the viewpoint of reducing the dielectric constant, it is preferable that the polymerizable compound includes a compound having a ClogP value of 3.0 or more, and it is more preferable that the polymerizable compound includes a compound having a ClogP value of 3.0 or more and having an aromatic ring structure or an aliphatic ring structure with 6 or more carbon atoms.

In the present specification, the ClogP value of a compound is defined as follows.

The octanol-water partition coefficient (logP value) can be measured generally by a flask immersion method described in JIS Japanese Industrial Standard Z7260-107 (2000). In addition, the octanol-water partition coefficient (logP value) can also be estimated by a computational chemistry method or an empirical method instead of measurement. As a calculation method, a Crippen's fragmentation method (J. Chem. Inf. Comput. Sci., 27, 21 (1987)), a Viswanadhan's fragmentation method (J. Chem. Inf. Comput. Sci., 29, 163 (1989)), a Broto's fragmentation method (Eur. J. Med. Chem. -Chim. Theor., 19, 71 (1984)), and the like are known to be used. In the present invention, a Crippen's fragmentation method (J. Chem. Inf. Comput. Sci., 27, 21 (1987)) is used.

The ClogP value is a value obtained by calculating the common logarithm logP of the 1-octanol/water partition coefficient P. A known method or software can be used for calculating the ClogP value, but unless otherwise specified, in the present invention, a ClogP program incorporated in the system: PCModels of Daylight Chemical Information Systems, Inc. is used.

The ClogP value is preferably 4.0 or more and more preferably 6.0 or more.

**In** addition, the upper limit of the ClogP value is not particularly limited, but is preferably 15.0 or less.

The above-described aromatic ring structure may be an aromatic hydrocarbon ring or an aromatic heterocyclic ring, but is preferably an aromatic hydrocarbon ring, and more preferably includes a benzene ring. In addition, from the

viewpoint of reducing the dielectric constant, a fused ring such as a fluorene ring is preferable.

As the aliphatic ring structure with 6 or more carbon atoms, an aliphatic ring structure with 6 to 30 carbon atoms is preferable, and an aliphatic ring structure with 6 to 20 carbon atoms is more preferable.

Examples of the aliphatic ring structure with 6 or more carbon atoms include a monocyclic ring such as a cyclohexane ring, and a polycyclic ring such as a dicyclopentane ring and a tricyclo[5.2.1.0$^{2,6}$]decane ring, and a polycyclic ring is preferable.

The polymerizable compound having a ClogP value of 3.0 or more (particularly, a compound having a ClogP value of 3.0 or more and having an aromatic ring structure or an aliphatic ring structure with 6 or more carbon atoms) is preferably a compound containing a group having an ethylenically unsaturated bond, and more preferably a compound containing two or more groups having an ethylenically unsaturated bond. In addition, the compound is also preferably a compound having two groups having an ethylenically unsaturated bond.

In addition, the polymerizable compound having a ClogP value of 3.0 or more (particularly, a compound having a ClogP value of 3.0 or more and having an aromatic ring structure or an aliphatic ring structure with 6 or more carbon atoms) is preferably a compound corresponding to a radical crosslinking agent described later.

Specific examples of the polymerizable compound having a ClogP value of 3.0 or more include the following compounds, but the polymerizable compound is not limited thereto.

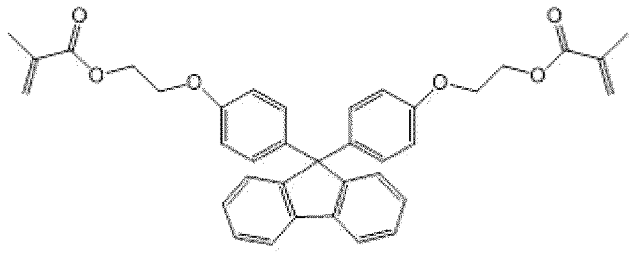

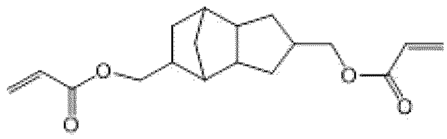

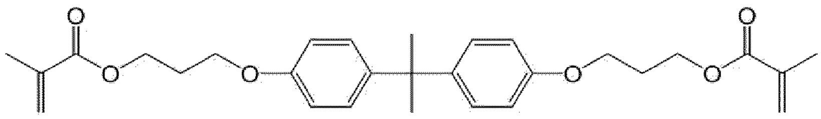

Examples of the polymerizable compound include a radical crosslinking agent and another crosslinking agent.

[Radical crosslinking agent]

The resin composition according to the embodiment of the present invention preferably contains a radical crosslinking agent.

The radical crosslinking agent is a compound having a radically polymerizable group. The radically polymerizable group is preferably a group containing an ethylenically unsaturated bond. Examples of the group containing an ethylenically unsaturated bond include a vinyl group, an allyl group, a vinylphenyl group, a (meth)acryloyl group, a maleimide group, and a (meth)acrylamide group.

Among these, a (meth)acryloyl group, a (meth)acrylamide group, or a vinylphenyl group is preferable, and from the viewpoint of reactivity, a (meth)acryloyl group is more preferable.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

From the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where esters between unsaturated carboxylic acids and polyhydric alcohol compounds or amides between unsaturated

carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

The radical crosslinking agent is also preferably a compound having a boiling point of 100°C or higher under normal pressure. Examples of the compound having a boiling point of 100°C or higher under normal pressure include the compounds described in paragraph 0203 of WO2021/112189A. The content thereof is incorporated in the present specification.

Examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, SR-209, 231, and 239 which are a difunctional methacrylate having four ethyleneoxy chains (all of which are manufactured by manufactured by Sartomer Company Inc.), DPCA-60 which is a hexafunctional acrylate having six pentyleneoxy chains and TPA-330 which is a trifunctional acrylate having three isobutylene oxy chains (all of which are manufactured by Nippon Kayaku Co., Ltd.), UAS-10 and UAB-140 which are a urethane oligomer (all of which are manufactured by Nippon Paper Industries Co., Ltd.), NK Ester M-40G, NK Ester 4G, NK Ester M-9300, NK Ester A-9300, and UA-7200 (all of which are manufactured by Shin-Nakamura Chemical Co., Ltd.), DPHA-40H (manufactured by Nippon Kayaku Co., Ltd.), UA-306H, UA-306T, UA-306I, AH-600, T-600, and AI-600 (all of which are manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. As the radical crosslinking agent, the compounds having an amino structure or a sulfide structure in the molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

An acid value of the radical crosslinking agent having an acid group is preferably 0.1 to 300 mgKOH/g and more preferably 1 to 100 mgKOH/g. In a case where the acid value of the radical crosslinking agent is within the above-described range, excellent manufacturing handleability is exhibited, and excellent developability is exhibited. In addition, good polymerization properties are exhibited. The acid value is measured in accordance with the description of JIS K 0070:

1992.

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, dipropylene glycol diacrylate, tripropylene glycol diacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid EO-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain Formula weight of about 200.

In the photocurable resin composition according to the embodiment of the present invention, a monofunctional radical crosslinking agent can be preferably used as the radical crosslinking agent from the viewpoint of suppressing the warping of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate; butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under normal pressure is also preferable in order to suppress volatilization before exposure.

In addition, examples of the bi- or higher functional radical crosslinking agent include allyl compounds such as diallyl phthalate and triallyl trimellitate.

In a case where a radical crosslinking agent is contained, the content of the radical crosslinking agent is preferably more than 0% by mass and 60% by mass or less with respect to the total solid content of the resin composition. The lower limit thereof is more preferably 5% by mass or more. The upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

[Another crosslinking agent]

The photocurable resin composition according to the embodiment of the present invention also preferably contains another crosslinking agent different from the radical crosslinking agent described above.

The other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is preferably a compound having a plurality of groups, in the molecule, which accelerates a reaction of forming a covalent bond between other compounds in the composition or reaction products thereof, by the action of the acid or the base.

The acid or the base is preferably an acid or a base, which is generated from a photoacid generator or a photobase generator in the exposure step.

Examples of the other crosslinking agent include the compounds described in paragraphs 0179 to 0207 of WO2022/145355A. The above description is incorporated in the present specification.

[Polymerization initiator]

The resin composition according to the embodiment of the present invention contains a polymerization initiator. The polymerization initiator may be a thermal polymerization initiator or a photopolymerization initiator; however, it is particularly preferable to contain a photopolymerization initiator.

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from the ultraviolet ray range to the visible light range is preferable. In addition, it may be an activator that acts with a

sensitizing agent to generate an active radical.

The photoradical polymerization initiator preferably contains at least one compound having a molar absorption coefficient of at least about 50 $L \cdot mol^{-1} \cdot cm^{-1}$ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an α-amino ketone compound such as aminoacetophenone, an α-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313A, the contents of which are incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification.

As the α-hydroxy ketone-based initiator, Omnirad 184, Omnirad 1173, Omnirad 2959, Omnirad 127 (all of which manufactured by IGM Resins B.V), IRGACURE 184 (IRGACURE is a registered trademark), DAROCUR 1173, IRGACURE 500, IRGACURE-2959, and IRGACURE 127 (all of which manufactured by BASF SE) can be used.

As the α-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1-one, 2-(benzoyloxy(imino))-1-phenylpropan-1-one, 3-((4-toluenesulfonyloxy)imino)butan-2-one, and 2-(ethoxycarbonyloxy(imino))-1-phenylpropan-1-one. In the resin composition, it is preferable to use an oxime compound, particularly as a photoradical polymerization initiator. The oxime compound as a photoradical polymerization initiator has a linking group of >C=N-O-C(=O)- in the molecule.

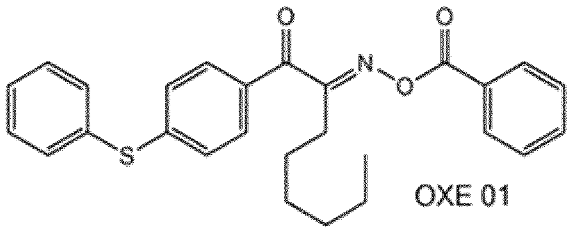

OXE 01

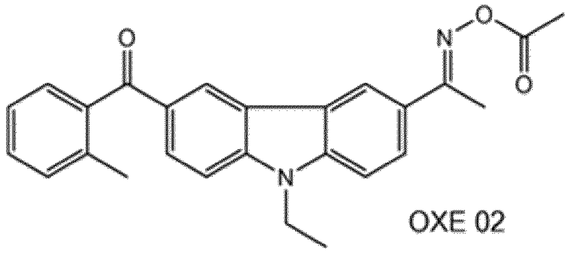

OXE 02

Examples of the commercially available product of the oxime compound include IRGACURE OXE 01, IRGACURE OXE 02, IRGACURE OXE 03, and IRGACURE OXE 04 (all of which are manufactured by BASF SE), ADEKA OPTOMER N-1919 (manufactured by ADEKA Corporation, the photoradical polymerization initiator 2 described in JP2012-014052A), TR-PBG-304 and TR-PBG-305 (all of which are manufactured by Changzhou Tronly New Electronic Materials Co., Ltd.), ADEKA ARKLS NCI-730, NCI-831, and ADEKA ARKLS NCI-930 (all of which are manufactured by ADEKA Corporation), DFI-091 (manufactured by DAITO CHEMIX Co., Ltd.), and SpeedCure PDO (manufactured by SARTOMER ARKEMA). In addition, oxime compounds having the following structures can also be used.

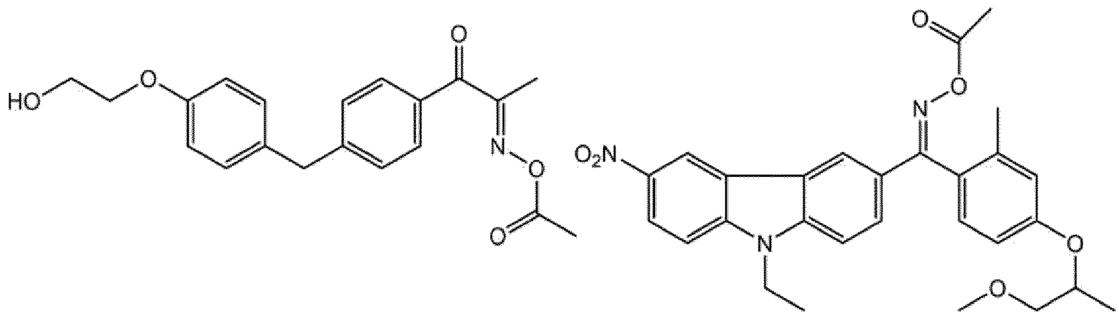

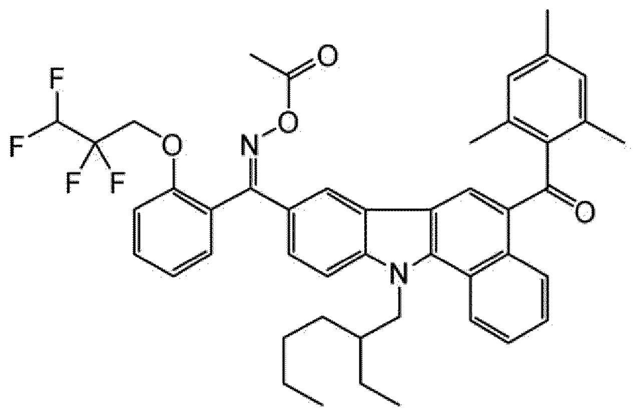

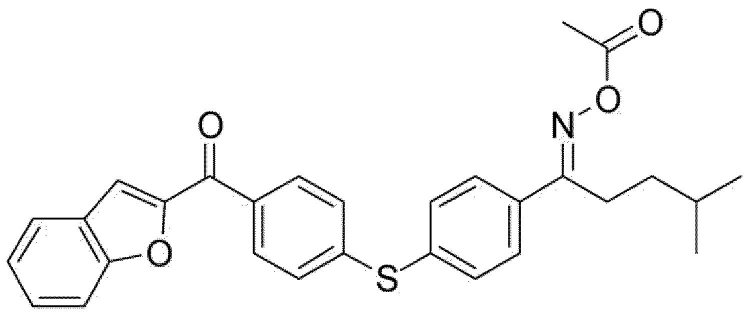

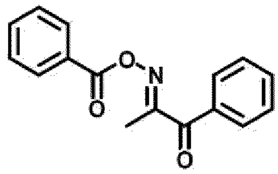

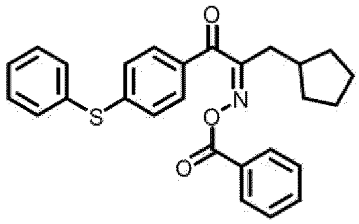

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom.

In addition, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The content thereof is incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX1) or a compound represented by Formula (OX2), and more preferably a compound represented by Formula (OX2).

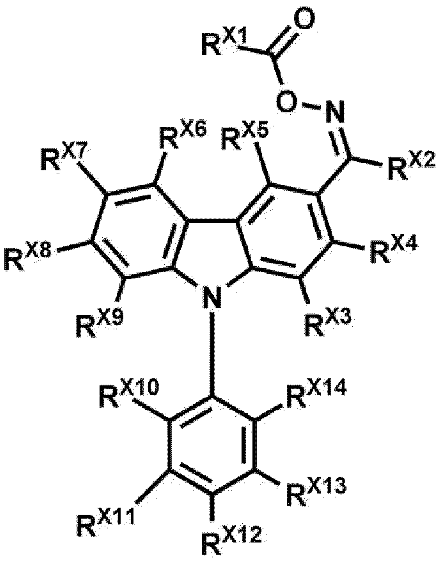

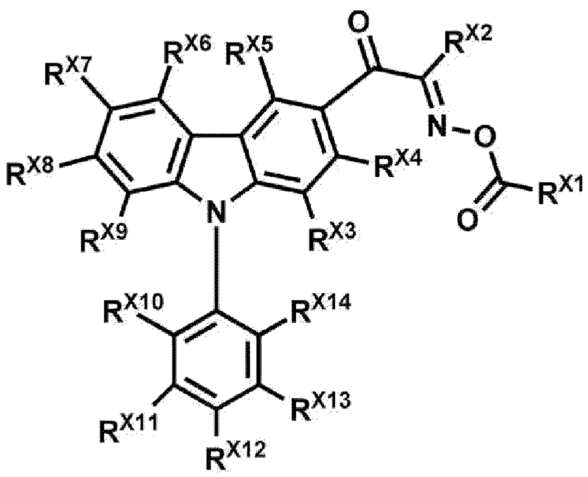

(OX2)

(OX1)

In Formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group, $R^{X2}$ represents an alkyl group, an alkenyl group, an alkoxy

group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and $R^{X3}$ to $R^{X14}$ each independently represent a hydrogen atom or a substituent.

However, at least one of $R^{X10}$, ..., or $R^{X14}$ is an electron withdrawing group.

In the above Formulae, it is preferable that $R^{X12}$ is an electron withdrawing group, and $R^{X10}$, $R^{X11}$, $RX^{13}$, and $R^{X14}$ are a hydrogen atom.

Specific examples of the oxime compound OX include the compounds described in paragraph Nos. 0083 to 0105 of JP4600600B, the content of which is incorporated in the present specification.

Examples of the particularly preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an α-hydroxy ketone compound, an α-aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

In addition, the photoradical polymerization initiator is a trihalomethyltriazine compound, an α-aminoketone compound, an acylphosphine compound, a phosphine oxide compound, a metallocene compound, an oxime compound, a triaryl imidazole dimer, an onium salt compound, a benzophenone compound, or an acetophenone compound. It is more preferably at least one compound selected from the group consisting of a trihalomethyltriazine compound, an α-aminoketone compound, a metallocene compound, an oxime compound, a triaryl imidazole dimer, and a benzophenone compound, and still more preferably a metallocene compound or an oxime compound.

As the photoradical polymerization initiator, the compounds described in paragraphs 0175 to 0179 of WO2021/020359A and the compounds described in paragraphs 0048 to 0055 of WO2015/125469A can also be used, the contents of which are incorporated in the present specification.

As the photoradical polymerization initiator, a photoradical polymerization initiator which is difunctional or tri- or higher functional may be used. In a case where such a photoradical polymerization initiator is used, two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, which makes it possible to improve the temporal stability of the resin composition. Specific examples of the photoradical polymerization initiator which is difunctional or tri- or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in WO2016/034963A, the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, and the oxime ester photoinitiator described in JP6469669B, the contents of which are incorporated in the present specification.

In a case where the resin composition contains a photopolymerization initiator, the content thereof is preferably 0.1% to 30% by mass, more preferably 0.1% to 20% by mass, still more preferably 0.5% to 15% by mass, and even still more preferably 1.0% to 10% by mass with respect to the total solid content of the resin composition with respect to the total solid content of the resin composition. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further allowed to proceed by heating an oven, a hot plate, or the like.

[Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based,

a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyanine-based, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition. One kind of chain transfer agent may be used alone, or two or more kinds thereof may be used. In a case where two or more kinds of chain transfer agents are used, the total thereof is preferably within the above-described range.

In addition, the polymerization initiator is preferably a photoacid generator. The photoacid generator is preferably a photoacid generator that generates a radical.

Specifically, the compound is preferably a compound that absorbs light, decomposes the absorbed light to generate a radical, and abstracts hydrogen from a solvent, an acid generator itself, or the like to generate an acid.

Examples of the photoacid generator include a quinone diazide compound, an oxime sulfonate compound, an organic halogenated compound, an organic borate compound, a disulfone compound, and an onium salt, and an onium salt is preferable.

Examples of the onium salt include a diazonium salt, a phosphonium salt, a sulfonium salt, and an iodonium salt.

Further, the onium salt is a salt of a cation having an onium structure and an anion, and the cation and the anion may be or may not be bonded through a covalent bond.

That is, the onium salt may be an intramolecular salt having a cation moiety and an anion moiety in the same molecular structure, or may be an intermolecular salt in which a cation molecule and an anion molecule, which are separate molecules, are ionically bonded; however, an intermolecular salt is preferred. Further, in the composition according to the embodiment of the present invention, the cation moiety or the cation molecule and the anion moiety or the anion molecule may be bonded by the ionic bonding or be dissociated from each other.

[Sulfonium salt]

In the present invention, the sulfonium salt means a salt of a sulfonium cation and an anion.

-Sulfonium cation-

The sulfonium cation is preferably a tertiary sulfonium cation and more preferably a triaryl sulfonium cation.

In addition, the sulfonium cation is preferably a cation represented by Formula (103).

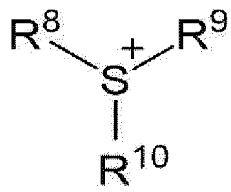

(103)

In Formula (103), $R^8$ to $R^{10}$ each independently represent a hydrocarbon group.

$R^8$ to $R^{10}$ are each independently preferably an alkyl group or an aryl group, more preferably an alkyl group having 1 to 10 carbon atoms or an aryl group having 6 to 12 carbon atoms, still more preferably an aryl group having 6 to 12 carbon atoms, and even still more preferably a phenyl group.

$R^8$ to $R^{10}$ may have a substituent, and examples of the substituent include a hydroxy group, an aryl group, an alkoxy group, an aryloxy group, an arylcarbonyl group, an alkylcarbonyl group, an alkoxycarbonyl group, an aryloxycarbonyl group, and an acyloxy group. Among these, $R^8$ to $R^{10}$ preferably have an alkyl group or an alkoxy group as the substituent, more preferably has a branched alkyl group or an alkoxy group, and still more preferably has a branched alkyl group having 3 to 10 carbon atoms or an alkoxy group having 1 to 10 carbon atoms.

$R^8$ to $R^{10}$ may be the same group or different groups; however, from the viewpoint of synthesis compatibility, $R^8$ to $R^{10}$ are preferably the same group.

-Anion-

The anion is not particularly limited, and may be selected in consideration of the acid generated. Examples of the anion include boron-based anions such as $B(C_6F_5)_4^-$ and $BF_4^-$, phosphorus-based anions such as $(Rf)_nPF_{6-n}^-$, $PF_3(C_2F_5)_3^-$ and $PF_6^-$, antimony-based anions such as $SbF_6^-$, and other carboxylate anions, sulfonate anions, and the like.

[Iodonium salt]

In the present invention, the iodonium salt means a salt of an iodonium cation and an anion. Examples of the anion include the same anions as those in the sulfonium salt described above, and the same applies to the preferred aspect.

-Iodonium cation-

The iodonium cation is preferably a diaryl iodonium cation.

In addition, the iodonium cation is preferably a cation represented by Formula (104).

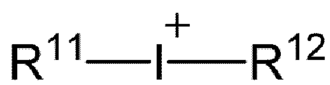

(104)

In Formula (104), $R^{11}$ and $R^{12}$ each independently represent a hydrocarbon group.

$R^{11}$ and $R^{12}$ are each independently preferably an alkyl group or an aryl group, more preferably an alkyl group having 1 to 10 carbon atoms or an aryl group having 6 to 12 carbon atoms, still more preferably an aryl group having 6 to 12 carbon atoms, and even still more preferably a phenyl group.

$R^{11}$ and $R^{12}$ may have a substituent, and examples of the substituent include a hydroxy group, an aryl group, an

alkoxy group, an aryloxy group, an arylcarbonyl group, an alkylcarbonyl group, an alkoxycarbonyl group, an aryloxycarbonyl group, and an acyloxy group. Among these, $R^{13}$ to $R^{16}$ preferably have an alkyl group or an alkoxy group as the substituent, more preferably has a branched alkyl group or an alkoxy group, and still more preferably has a branched alkyl group having 3 to 10 carbon atoms or an alkoxy group having 1 to 10 carbon atoms.

$R^{11}$ and $R^{12}$ may be the same group or different groups; however, from the viewpoint of synthesis compatibility, $R^{11}$ and $R^{12}$ are preferably the same group.

[Phosphonium salt]

In the present invention, the phosphonium salt means a salt of a phosphonium cation and an anion. Examples of the anion include the same anions as those in the sulfonium salt described above, and the same applies to the preferred aspect.

-Phosphonium cation-

The phosphonium cation is preferably a quaternary phosphonium cation, and examples thereof include a tetraalkylphosphonium cation and a triarylmonoalkylphosphonium cation.

In addition, the phosphonium cation is preferably a cation represented by Formula

(105).

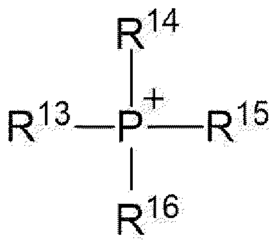

(105)

In Formula (105), $R^{13}$ to $R^{16}$ each independently represent a hydrogen atom or a hydrocarbon group.

$R^{13}$ to $R^{16}$ are each independently preferably an alkyl group or an aryl group, more preferably an alkyl group having 1 to 10 carbon atoms or an aryl group having 6 to 12 carbon atoms, still more preferably an aryl group having 6 to 12 carbon atoms, and even still more preferably a phenyl group.

$R^{13}$ to $R^{16}$ may have a substituent, and examples of the substituent include a hydroxy group, an aryl group, an alkoxy group, an aryloxy group, an arylcarbonyl group, an alkylcarbonyl group, an alkoxycarbonyl group, an aryloxycarbonyl group, and an acyloxy group. Among these, $R^{13}$ to $R^{16}$ preferably have an alkyl group or an alkoxy group as the substituent, more preferably has a branched alkyl group or an alkoxy group, and still more preferably has a branched alkyl group having 3 to 10 carbon atoms or an alkoxy group having 1 to 10 carbon atoms.

$R^{13}$ to $R^{16}$ may be the same group or different groups; however, from the viewpoint of synthesis compatibility, $R^{13}$ to $R^{16}$ are preferably the same group.

The content of the photoacid generator is preferably 0.1% to 20% by mass, more preferably 0.5% to 18% by mass, still more preferably 0.5% to 10% by mass, even more preferably 0.5% to 3% by mass, and even still more preferably 0.5% to 1.2% by mass, with respect to the total solid content of the resin composition.

One kind of photoacid generator may be used alone, or a plurality of kinds thereof may be used in combination. In the case of the combination of a plurality of kinds, it is preferable that the total amount thereof is within the above range.

In addition, in order to impart photosensitivity to a desired light source, it is also preferable to use a sensitizing agent in combination.

In addition, one of the preferred aspects of the present invention is that the resin composition according to the embodiment of the present invention contains two or more kinds of polymerization initiators as the polymerization initiator.

Specifically, the resin composition according to the embodiment of the present invention preferably contains a photopolymerization initiator and a thermal polymerization initiator described later, or contains the above-described photoradical polymerization initiator and the above-described photoacid generator.

By containing the photopolymerization initiator and the thermal polymerization initiator described later, pattern formation by exposure is possible, and radical polymerization is also likely to proceed during curing in the heating step described later, and thus the performance such as chemical resistance may be improved.

**In** the content ratio in a case where the photopolymerization initiator and the thermal polymerization initiator

described later are contained, the content of the thermal polymerization initiator is preferably 20% to 70% by mass and more preferably 30% to 60% by mass with respect to the total content of the photopolymerization initiator and the thermal polymerization initiator.

The performance such as resolution may be improved by containing a photoradical polymerization initiator and a photoacid generator.

**In** the content ratio in a case where the photopolymerization initiator and the photoacid generator are contained, the content of the photoacid generator is preferably 20% to 70% by mass, and more preferably 30% to 60% by mass with respect to the total content of the photopolymerization initiator and the photoacid generator.

[Thermal polymerization initiator]

Examples of the thermal polymerization initiator include a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved.

Specific examples of thermal radical polymerization initiator include compounds described in paragraphs 0074 to 0118 of JP2008-063554A, the content of which is incorporated in the present specification.

**In** a case where a thermal polymerization initiator is contained, the content thereof is preferably 0.1% to 30% by mass, more preferably 0.1% to 20% by mass, and still more preferably 0.5% to 15% by mass with respect to the total solid content of the resin composition. Only one kind of thermal polymerization initiator may be contained, or two or more kinds thereof may be contained. **In** a case where two or more kinds of thermal polymerization initiators are contained, the total amount thereof is preferably within the above-described range.

<Base generator>

The resin composition according to the embodiment of the present invention may contain a base generator. Here, the base generator is a compound that is capable of generating a base under a physical or chemical action. Examples of the preferred base generator include a thermal base generator and a photobase generator.

**In** particular, in a case where the resin composition contains a precursor of a cyclization resin, it is preferable that the resin composition contains a base generator. **In a** case where the resin composition contains a thermal-base generator, it is possible to, for example, accelerate the cyclization reaction of the precursor by heating, whereby the mechanical properties and chemical resistance of the cured substance are improved and for example, the performance as an interlayer insulating film for a re-distribution layer, included in a semiconductor package, is improved.

The base generator may be an ionic base generator or may be a nonionic base generator. Examples of the base that is generated from the base generator include a secondary amine and a tertiary amine.

The base generator is not particularly limited, and a publicly known base generator can be used. Examples of the publicly known base generator include a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an α-aminoacetophenone derivative compound, a quaternary ammonium salt derivative compound, an iminium salt, a pyridinium salt, an α-lactone ring derivative compound, a phthalimide derivative compound, and an acyloxyimino compound.

Specific examples of the nonionic base generator include the compounds described in paragraphs 0249 to 0275 of WO2022/145355A. The above description is incorporated in the present specification.

Examples of the base generator include the following compounds; however, the base generator is not limited thereto.

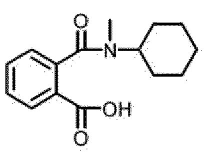

(B-1)

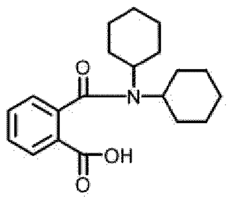

(B-2)

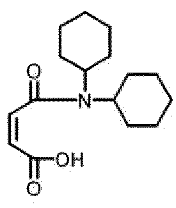

(B-3)

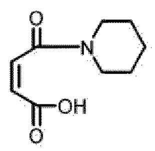

(B-4)

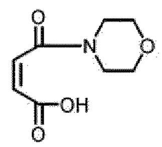

(B-5)

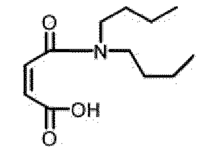
(B-6)

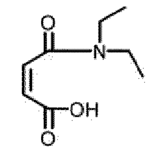
(B-7)

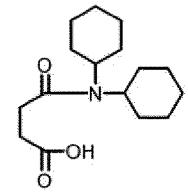
(B-8)

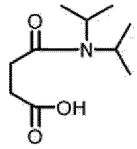
(B-9)

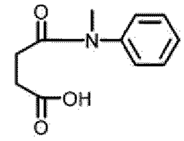
(B-10)

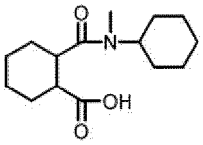
(B-11)

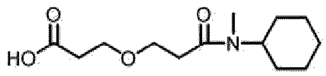
(B-12)

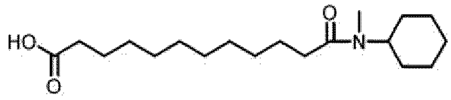
(B-13)

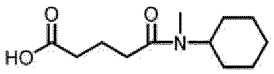
(B-14)

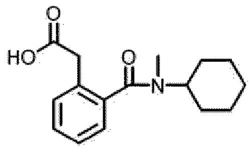
(B-15)

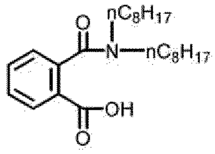
(B-16)

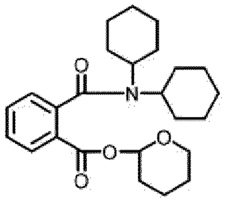
(B-17)

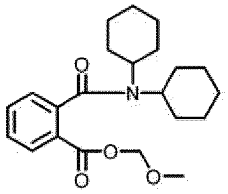
(B-18)

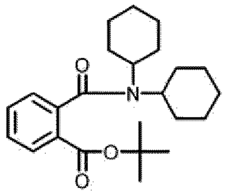
(B-19)

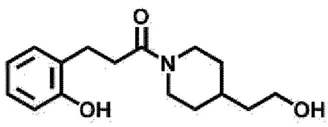
(B-20)

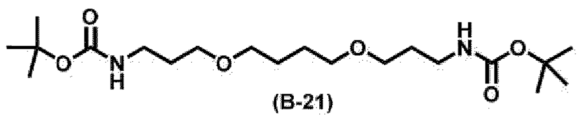
(B-21)

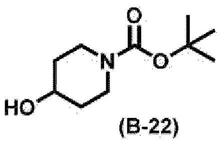
(B-22)

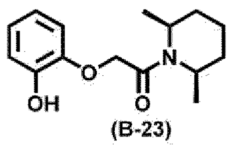
(B-23)

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/038002A.

Specific examples of the ammonium salt include the following compounds; however, the ammonium salt is not limited thereto.

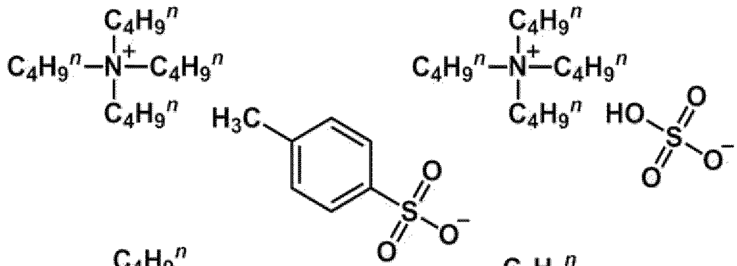
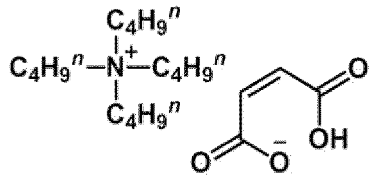
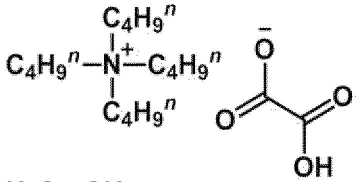
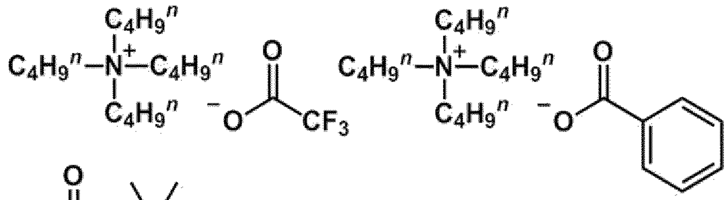
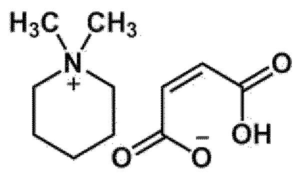
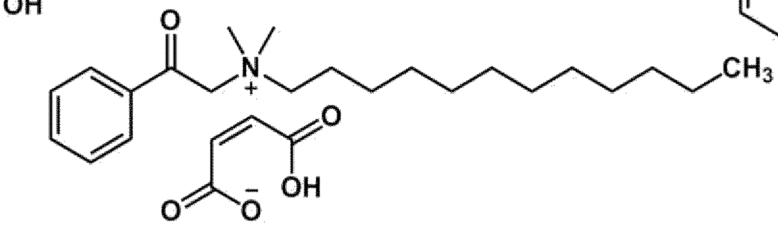
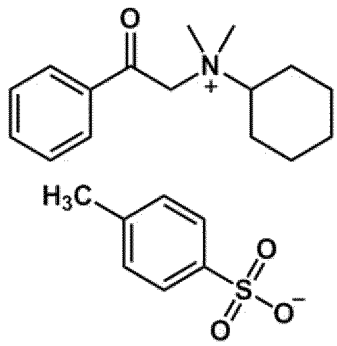
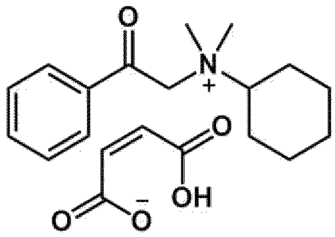
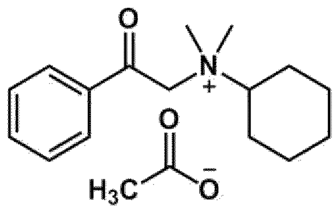
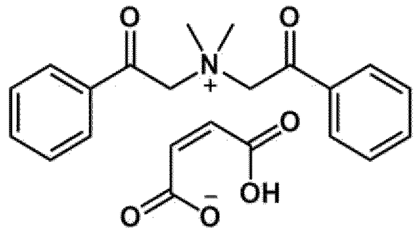

Specific examples of the iminium salt include the following compounds; however, the iminium salt is not limited thereto.

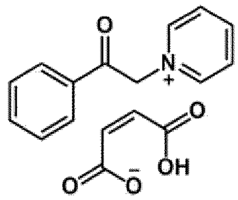
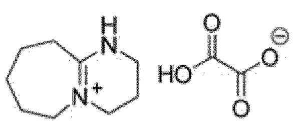
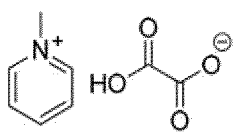
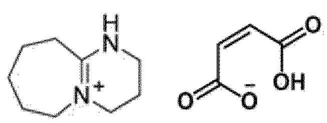
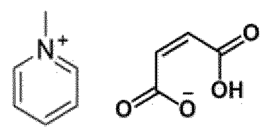

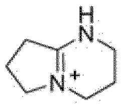 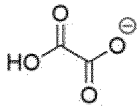 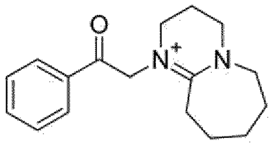 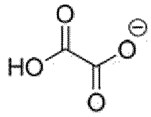

In addition, from the viewpoint of storage stability and generation of a base by deprotection during curing, the base generator is preferably an amine in which an amino group is protected by a t-butoxycarbonyl group.

Examples of the amine compound protected by a t-butoxycarbonyl group include ethanolamine, 3-amino-1-propanol, 1-amino-2-propanol, 2-amino-1-propanol, 4-amino-1-butanol, 2-amino-1-butanol, 1-amino-2-butanol, 3-amino-2,2-dimethyl-1-propanol, 4-amino-2-methyl-1-butanol, valinol, 3-amino-1,2-propanediol, 2-amino-1,3-propanediol, tyramine, norephedrine, 2-amino-1-phenyl-1,3-propanediol, 2-aminocyclohexanol, 4-aminocyclohexanol, 4-aminocyclohexanethanol, 4-(2-aminoethyl)cyclohexanol, N-methylethanolamine, 3-(methylamino)-1-propanol, 3-(isopropylamino) propanol, N-cyclohexylethanolamine, α-[2-(methylamino)ethyl]benzyl alcohol, diethanolamine, diisopropanolamine, 3-pyrrolidinol, 2-pyrrolidinomethanol, 4-hydroxypiperidine, 3-hydroxypiperidine, 4-hydroxy-4-phenylpiperidine, 4-(3-hydroxyphenyl)piperidine, 4-piperidinemethanol, 3-piperidinemethanol, 2-piperidinemethanol, 4-piperidinetanol, 2-piperidinetanol, 2-(4-piperidyl)-2-propanol, 1,4-butanol bis(3-aminopropyl)ether, 1,2-bis(2-aminoethoxy)ethane, 2,2'-oxybis(ethylamine), 1, 14-diamino-3,6,9,12-tetraoxatetradecane, 1-aza-15-crown 5-ether, diethylene glycol bis(3-aminopropyl) ether, 1,11-diamino-3,6,9-trioxaundecane, or a compound in which an amino group of an amino acid and a derivative thereof is protected by a t-butoxycarbonyl group, but the present invention is not limited to these examples.

In a case where the resin composition contains a base generator, the content of the base generator is preferably 0.1 to 50 parts by mass with respect to 100 parts by mass of the resin in the resin composition. The lower limit thereof is more preferably 0.3 parts by mass or more and still more preferably 0.5 parts by mass or more. The upper limit thereof is more preferably 30 parts by mass or less, still more preferably 20 parts by mass or less, even still more preferably 10 parts by mass or less, even further still more preferably 5 parts by mass or less, and particularly preferably 4 parts by mass or less.

One kind or two or more kinds of base generators can be used. **In** a case where two or more kinds thereof are used, the total amount is preferably within the above-described range.

<Solvent>

The resin composition according to the embodiment of the present invention preferably contains a solvent.

As the solvent, any publicly known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, γ- valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, γ- valerolactone, 3-methoxy-N,N-dimethylpropionamide, toluene, dimethyl sulfoxide, ethyl carbitol acetate, butyl carbitol acetate, N-methyl-2-pyrrolidone, propylene glycol methyl ether, and propylene glycol methyl ether acetate, as well as levoglucosenone and dihydrolevoglucosenone, or a mixed solvent composed of two or more of these. A combined use of dimethyl sulfoxide and γ-butyrolactone, a combined use of dimethyl sulfoxide and γ-valerolactone, a combined use of 3-methoxy-N,N-dimethylpropionamide and γ-butyrolactone, a combined use of 3-methoxy-N,N-dimethylpropionamide and dimethyl sulfoxide, or, a combined use of N-methyl-2-pyrrolidone and ethyl lactate is particularly preferable. An aspect in which an amount of about 1% to 10% by mass of toluene with respect to the total mass of the solvent is further added to these combinedly used solvents is also one of the preferred aspects of the present invention.

**In** particular, from the viewpoint of the storage stability of the resin composition, an aspect in which γ-valerolactone is included as the solvent is also one of the preferred aspects of the present invention. **In** such an aspect, the content of γ-valerolactone with respect to the total mass of the solvent is preferably 50% by mass or more, more preferably 60% by mass or more, and still more preferably 70% by mass or more. **In** addition, the upper limit of the above-described content is not particularly limited, and it may be 100% by mass. The above-described content may be determined in consideration of the solubility or the like of the component contained in the resin composition, such as the specific resin.

**In** addition, in a case where dimethyl sulfoxide and γ-valerolactone are used in combination, with respect to the total mass of the solvent, it is preferable to contain 60% to 90% by mass of γ-valerolactone and 10% to 40% by mass of dimethyl sulfoxide, it is more preferable to contain 70% to 90% by mass of γ-valerolactone and 10% to 30% by mass of dimethyl sulfoxide, and it is still more preferable to contain 75% to 85% by mass of γ-valerolactone and 15% to 25% by mass of dimethyl sulfoxide.

Regarding the content of the solvent, the amount of the solvent is such that, from the viewpoint of coatability, the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method. **In** a case where two or more kinds of solvents are contained, the total thereof is preferably within the above-described range.

<Metal adhesiveness improving agent>

From the viewpoint of improving adhesiveness to a metal material used for an electrode, a wire, or the like, the resin composition according to the embodiment of the present invention preferably contains a metal adhesiveness improving agent. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

[Silane coupling agent]

Examples of the silane coupling agent include the compounds described in paragraph 0316 of WO2021/112189A and the compounds described in paragraphs 0067 to 0078 of JP2018-173573A, the contents of

which are incorporated in the present specification. In addition, it is also preferable to use two or more kinds of different silane coupling agents as described in paragraphs 0050 to 0058 of JP2011-128358A. It is also preferable to use the following compound as the silane coupling agent. In the following Formulae, Me represents a methyl group, and Et represents an ethyl group. In addition, examples of R shown below include a structure derived from a blocking agent in a blocked isocyanate group. The blocking agent may be selected depending on the desorption temperature; however, examples thereof include an alcohol compound, a phenol compound, a pyrazole compound, a triazole compound, a lactam compound, and an active methylene compound. It is preferably caprolactam or the like, for example, from the viewpoint of setting the desorption temperature to 160°C to 180°C. Examples of the commercially available product of such a compound include X-12-1293 (manufactured by Shin-Etsu Chemical Co., Ltd.).

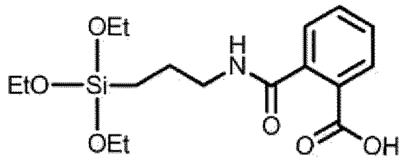
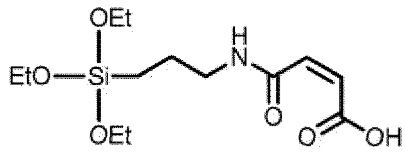

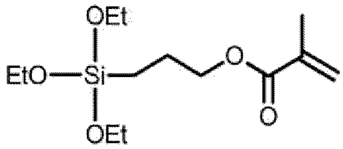
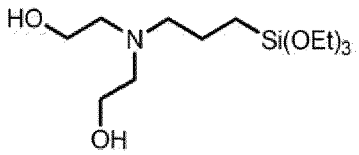
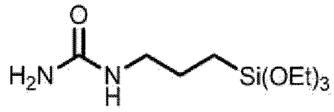

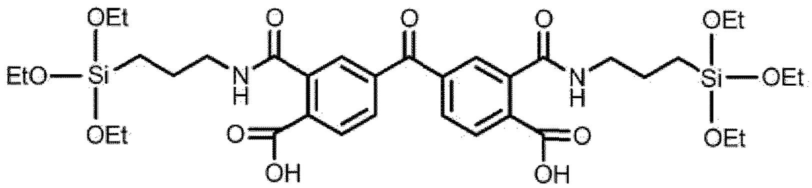

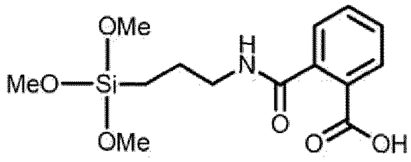
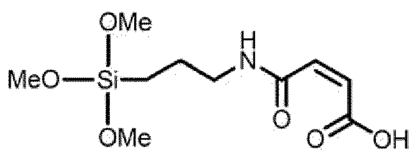

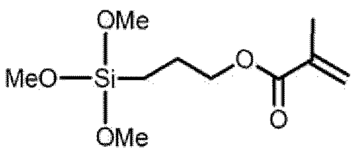
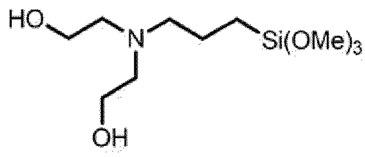
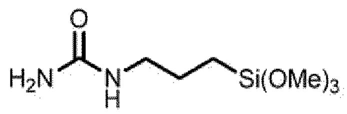

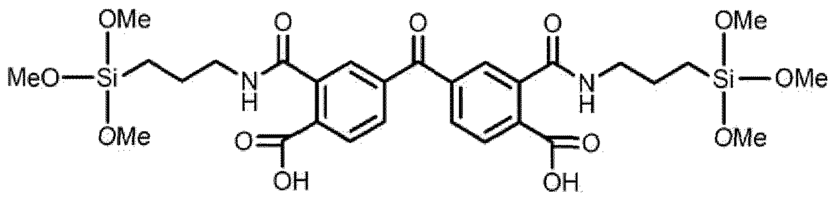

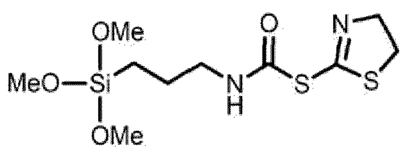
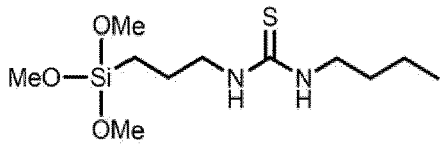

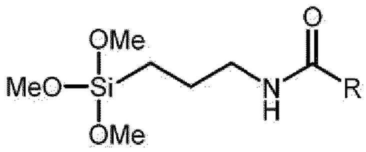
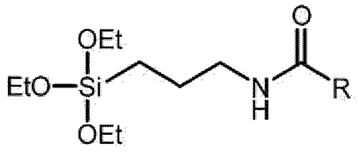

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. These can be used alone or in a combination of two or more thereof.

In addition, an oligomer type compound having a plurality of alkoxysilyl groups can also be used as the silane coupling agent.

Examples of such an oligomer type compound include a compound containing a repeating unit represented by Formula (S-1).

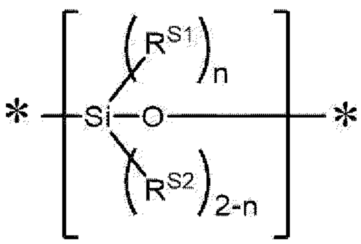

(S-1)

In Formula (S-1), $R^{S1}$ represents a monovalent organic group, $R^{S2}$ represents a hydrogen atom, a hydroxy group, or an alkoxy group, and n represents an integer of 0 to 2.

$R^{S1}$ preferably has a structure including a polymerizable group. Examples of the polymerizable group include a group having an ethylenically unsaturated bond, an epoxy group, an oxetanyl group, a benzoxazolyl group, a blocked isocyanate group, and an amino group. Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth) acryloyloxy group is more preferable, and a (meth)acryloyloxy group is still more preferable.

$R^{S2}$ is preferably an alkoxy group, and more preferably a methoxy group or an ethoxy group.

n represents an integer of 0 to 2, and it is preferably 1.

Here, structures of a plurality of repeating units represented by Formula (S-1) may be the same, where the plurality of repeating units are contained in the oligomer type compound.

Here, among a plurality of repeating units represented by Formula (S-1), which are contained in the oligomer type compound, it is preferable that at least one repeating unit has n of 1 or 2, it is more preferable that at least two repeating units have n of 1 or 2, and it is still more preferable that at least two repeating units have n of 1.

As such an oligomer type compound, a commercially available product can be used, and examples thereof include KR-513 (manufactured by Shin-Etsu Chemical Co., Ltd.).

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

As another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably 0.01 to 30 parts by mass, more preferably 0.1 to 10 parts by mass, and still more preferably 0.5 to 5 parts by mass with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical characteristics are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. For example, in a case where the resin composition is applied to a metal layer (or a metal wiring line) to form a film, it is possible to effectively suppress the migration of metal ions derived from the metal layer (or the metal wiring line) into the film, in a case where a migration suppressing agent is contained.

The migration suppressing agent is not particularly limited; however, examples thereof include a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

Among these, the resin composition according to the embodiment of the present invention preferably contains an azole compound.

The azole compound is a compound containing an azole structure, and the azole structure refers to a 5-membered ring structure including a nitrogen atom as a ring member, and is preferably a 5-membered ring structure including two or more nitrogen atoms as a ring member. Specific examples of the azole structure include an imidazole structure, a triazole structure, and a tetrazole structure. These structures may form a polycycle by fusion with another ring structure, such as benzimidazole or benzotriazole.

In addition, as the compound having an azole structure, a compound in which a group represented by Formula (R-1) or Formula (R-2) is directly bonded to the azole structure is also preferable.

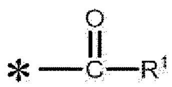

(R-1)

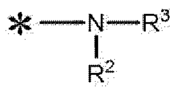

(R-2)

In Formula (R-1), $R^1$ represents a monovalent organic group, and * represents a bonding site to an azole structure.

In Formula (R-2), $R^2$ represents a hydrogen atom or a monovalent organic group, $R^3$ represents a monovalent organic group, and * represents a bonding site to the azole structure.

In Formula (R-1), $R^1$ is preferably a hydrocarbon group or a group represented by a bond between a hydrocarbon group and at least one group selected from the group consisting of -O-, -C(=O)-, -S-, $-S(=O)_2-$, and $-NR^N-$. $R^N$ is as described above.

The above-described hydrocarbon group is preferably an aliphatic hydrocarbon group, an aromatic hydrocarbon group, or a group represented by a combination thereof.

In addition, the total number of carbon atoms in $R^1$ is preferably 1 to 30, more preferably 2 to 25, and still more preferably 3 to 20.

In $R^1$, the bonding site to the carbonyl group in Formula (R-1) is preferably a hydrocarbon group or $-NR^N-$.

In Formula (R-1), * represents a bonding site to an azole structure, and is preferably a bonding site to a carbon atom which is a ring member of the azole structure.

In Formula (R-2), $R^2$ is preferably a hydrogen atom.

In a case where $R^2$ is a monovalent organic group, $R^2$ is preferably a hydrocarbon group or a group represented by a bond between a hydrocarbon group and at least one group selected from the group consisting of -O-, -C(=O)-, -S-, $-S(=O)_2-$, and $-NR^N-$. $R^N$ is as described above.

The above-described hydrocarbon group is preferably an aliphatic hydrocarbon group, an aromatic hydrocarbon group, or a group represented by a combination thereof.

In addition, in a case where $R^2$ is a monovalent organic group, the total number of carbon atoms is preferably 1 to 30, more preferably 2 to 25, and still more preferably 3 to 20.

In a case where $R^2$ is a monovalent organic group, a bonding site to a nitrogen atom in Formula (R-2) in $R^2$ is preferably a hydrocarbon group or -C(=O)-.

In Formula (R-2), $R^3$ is preferably a hydrocarbon group or a group represented by a bond between a hydrocarbon group and at least one group selected from the group consisting of -O-, -C(=O)-, -S-, $-S(=O)_2-$, and $-NR^N-$. $R^N$ is as described above.

The above-described hydrocarbon group is preferably an aliphatic hydrocarbon group, an aromatic hydrocarbon group, or a group represented by a combination thereof.

In addition, in a case where $R^3$ is a monovalent organic group, the total number of carbon atoms is preferably 1 to 30, more preferably 2 to 25, and still more preferably 3 to 20.

In $R^3$, the bonding site to the nitrogen atom in Formula (R-2) is preferably a hydrocarbon group or -C(=O)-.

In Formula (R-2), * represents a bonding site to an azole structure, and is preferably a bonding site to a carbon atom which is a ring member of the azole structure.

As the migration suppressing agent, an ion trap agent that captures an anion such as a halogen ion can also be used.

the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used as the other migration suppressing agents, the contents of which are incorporated in the present specification.

Specific examples of the migration suppressing agent include the following compounds.

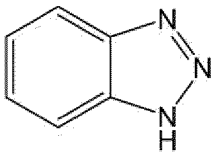

M-1

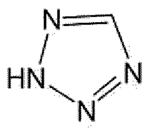

M-2

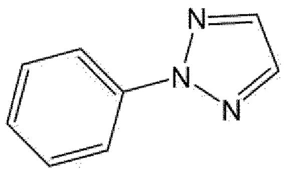

M-3

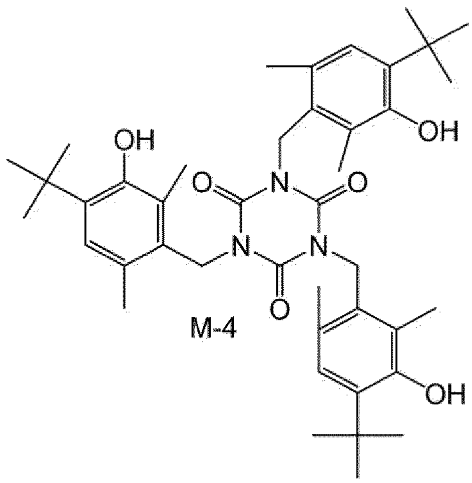

M-4

**In** a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition.

One kind of migration suppressing agent may be used alone, or two or more kinds thereof may be used. In a case where two or more kinds of migration suppressing agents are used, the total thereof is preferably within the above-described range.

<Light absorbing agent>

The resin composition according to the embodiment of the present invention also preferably contains a compound (a light absorbing agent) having a small absorbance at an exposure wavelength thereof upon exposure.

Whether or not a certain compound a contained in the resin composition corresponds to a light absorbing agent (that is, whether or not the absorbance thereof at the exposure wavelength decreases upon exposure) can be determined by the following method.

First, a solution of the compound a having the same concentration as the concentration contained in the resin composition is prepared, and the molar absorption coefficient of the compound a at the wavelength of the exposure light ($mol^{-1} \cdot L \cdot cm^{-1}$; also referred to as a "molar absorption coefficient 1") is measured. The above measurement is carried out quickly so that an influence of a change such as a decrease in the molar absorption coefficient of the compound a is small.

As a solvent in the above solution, a solvent of the resin composition is used in a case where the resin composition contains a solvent, and N-methyl-2-pyrrolidone is used in a case where the resin composition does not contain a solvent.

Next, the solution of the compound a is irradiated with exposure light. The exposure amount is 500 mJ, in terms of the integrated amount, with respect to 1 mol of the compound a.

Then, using the exposed solution of the compound a, the molar absorption coefficient of the compound a at the wavelength of the exposure light ($mol^{-1} \cdot L \cdot cm^{-1}$; also referred to as a "molar absorption coefficient 2") is measured.

From the above-described molar absorption coefficient 1 and molar absorption coefficient 2, a decay rate (%) is calculated based on the following expression, and in a case where the decay rate (%) is 5% or more, it is determined that the compound a is a compound (that is, a light absorbing agent) in which the absorbance at the exposure wavelength decreases due to the exposure.

Attenuation rate (%) = 1 - molar absorption coefficient 2/molar absorption coefficient 1 $\times$ 100

The attenuation rate is preferably 10% or more and more preferably 20% or more. In addition, the lower limit of the attenuation rate is not particularly limited, and it may be any attenuation rate of 0% by mass or more.

In a case where the resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the resin composition has sensitivity. The fact that the photopolymerization initiator has sensitivity to a certain wavelength refers to that a polymerization initiation species is generated in a case where the photopolymerization initiator is exposed at a certain wavelength.

Examples of the wavelength of the exposure light, which are mentioned in the relationship with the light source, include (1) a semiconductor laser (wavelength: 830 nm, 532 nm, 488 nm, 405 nm, 375 nm, 355 nm, etc); (2) a metal halide lamp; (3) a high-pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet (EUV) ray (wavelength: 13.6 nm); (6) an electron beam; and (7) a second harmonic wave of 532 nm and a third harmonic wave of 355 nm of a YAG laser.

As the wavelength of the exposure light, for example, any wavelength at which the photopolymerization initiator has sensitivity may be selected; however, an h-line (wavelength: 405 nm) or an i-line (wavelength: 365 nm) is preferable, and an i-line (wavelength: 365 nm) is more preferable.

The light absorbing agent may be a compound that generates a radical polymerization initiation species upon exposure; however, it is preferably a compound that does not generate a radical polymerization initiation species upon exposure from the viewpoint of resolution and chemical resistance.

Whether or not the light absorbing agent is a compound that generates a radical polymerization initiation species upon exposure is determined according to the following method.

A solution, which contains the light absorbing agent having the same concentration as the concentration contained in the resin composition and contains a radical crosslinking agent, is prepared. In a case where the resin composition contains a radical crosslinking agent, as the radical crosslinking agent in the solution, the same compound as the radical crosslinking agent contained in the resin composition is used at the same concentration. In a case where the resin composition does not contain a radical crosslinking agent, methyl methacrylate is used at a concentration 5 times that of the light absorbing agent.

Then, the irradiation with the exposure light is carried out. The exposure amount is 500 mJ in terms of the integrated amount.

After the exposure, the polymerization of the polymerizable compound is determined by, for example, high performance liquid chromatography, and in a case where the proportion of the molar amount of the polymerized polymerizable compound to the total molar amount of the polymerizable compound is 10% or less, it is determined that the light absorbing agent is a compound that does not generate a radical polymerization initiation species upon exposure.

The proportion of the molar amount is preferably 5% or less and more preferably 3% or less. In addition, the lower limit of the proportion of the molar amount is not particularly limited and may be 0%.

In a case where the resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the resin composition has sensitivity.

Examples of the compound that generates a radical polymerization initiation species upon exposure include the same compound as the photoradical polymerization initiator described above. In a case where the composition contains a photoradical polymerization initiator as the light absorbing agent, the light absorbing agent shall be a compound, where a radical species generated from the compound has the lowest polymerization initiation ability, and the photopolymerization initiator shall be the other ones.

Examples of the compound that does not generate a radical polymerization initiation species upon exposure

include a photoacid generator, a photobase generator, and a coloring agent having a changed absorption wavelength upon exposure.

Among these, the light absorbing agent is preferably a naphthoquinone diazide compound or a coloring agent having a changed absorbance upon exposure, and it is more preferably a naphthoquinone diazide compound.

In addition, for example, it is also conceivable to use, as the light absorbing agent, a photoacid generator or photobase generator in combination with a compound of which an absorbance is reduced at the exposure wavelength depending on the pH.

[Naphthoquinone diazide compound]

Examples of the naphthoquinone diazide compound include a compound of which an absorbance is reduced at an exposure wavelength due to generation of an indene carboxylic acid upon exposure, where a compound having a 1,2-naphthoquinone diazide structure is preferable.

The naphthoquinone diazide compound is preferably a naphthoquinone diazide sulfonic acid ester of a hydroxy compound.

The hydroxy compound is preferably a compound represented by any one of Formulae (H1) to (H6).

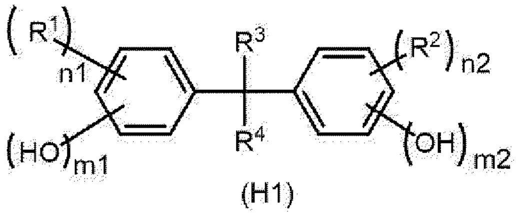

(H1)

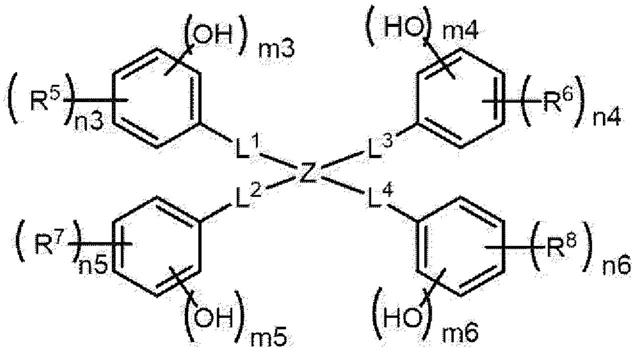

(H2)

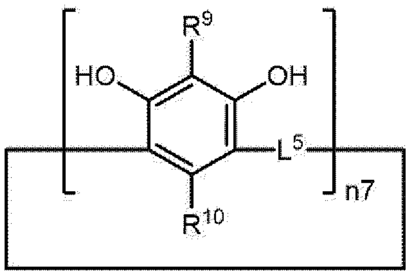

(H3)

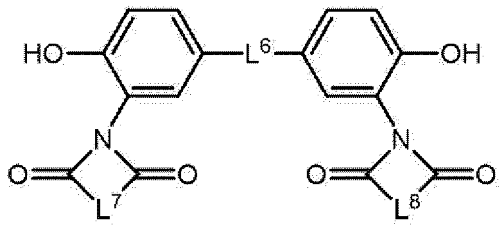

(H4)

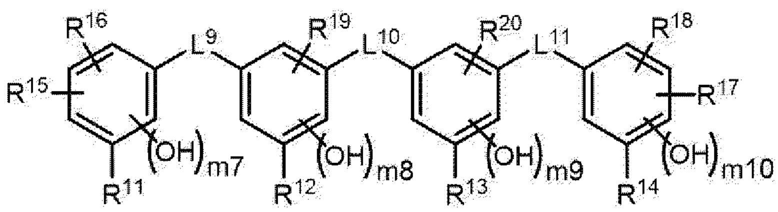

(H5)

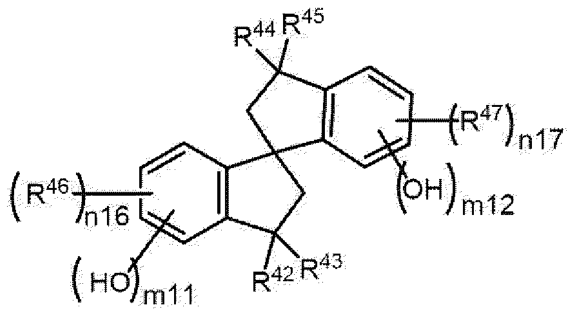

(H6)

In Formula (H1), $R^1$ and $R^2$ each independently represent a monovalent organic group, $R^3$ and $R^4$ each independently represent a hydrogen atom or a monovalent organic group, and n1, n2, m1, and m2 are each independently an integer of 0 to 5, where at least one of m1 or m2 is an integer of 1 to 5.

In Formula (H2), Z represents a tetravalent organic group, $L^1$, $L^2$, $L^3$, and $L^4$ each independently represent a single bond or a divalent organic group, $R^5$, $R^6$, and $R^7$ and $R^8$ each independently represent a monovalent organic group, n3, n4, n5, and n6 are each independently an integer of 0 to 3, and m3, m4, m5, and m6 are each independently an integer of 0 to 2 where at least one of m3, m4, m5, or m6 is 1 or 2.

In Formula (H3), $R^9$ and $R^{10}$ each independently represent a hydrogen atom or a monovalent organic group, $L^5$'s each independently represent a divalent organic group, and n7 represents an integer of 3 to 8.

In Formula (H4), $L^6$ represents a divalent organic group, and $L^7$ and $L^8$ each independently represent a divalent organic group containing an aliphatic tertiary or quaternary carbon.

In Formula (H5), $R^{11}$, $R^{12}$, $R^{13}$, $R^{14}$, $R^{15}$, $R^{16}$, $R^{17}$, $R^{18}$, $R^{19}$, and $R^{20}$ each independently represent a hydrogen atom, a halogen atom, or a monovalent organic group, $L^9$, $L^{10}$, and $L^{11}$ each independently represent a single bond or a divalent organic group, and m7, m8, m9, and m10 each independently represent an integer of 0 to 2, where at least one of m7, m8, m9, or m10 is 1 or 2.

In Formula (H6), $R^{42}$, $R^{43}$, $R^{44}$, and $R^{45}$ each independently represent a hydrogen atom or a monovalent organic group, $R^{46}$ and $R^{47}$ each independently represent a monovalent organic group, n16 and n17 each independently represent an integer of 0 to 4, and m11 and m12 each independently represent an integer of 0 to 4, where at least one of m11 or m12 is an integer of 1 to 4.

In Formula (H1), $R^1$ and $R^2$ are each independently preferably a monovalent organic group having 1 to 60 carbon atoms, and more preferably a monovalent organic group having 1 to 30 carbon atoms. Examples of the monovalent organic group as $R^1$ and $R^2$ include a hydrocarbon group which may have a substituent, and examples of the hydrocarbon group include an aromatic hydrocarbon group which may have a substituent such as a hydroxy group.

In Formula (H1), $R^3$ and $R^4$ are each independently preferably a monovalent organic group having 1 to 60 carbon atoms, and more preferably a monovalent organic group having 1 to 30 carbon atoms. Examples of the monovalent organic group as $R^3$ and $R^4$ include a hydrocarbon group which may have a substituent, and examples of the hydrocarbon group include a hydrocarbon group which may have a substituent such as a hydroxy group.

In Formula (H1), n1 and n2 are each independently preferably 0 or 1, and more preferably 0.

In Formula (H1), both m1 and m2 are preferably 1.

The compound represented by Formula (H1) is preferably a compound represented by any one of Formula (H1-1) to (H1-5).

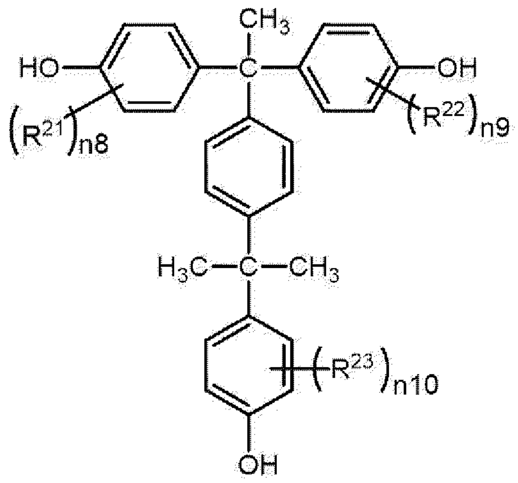

(H1-1)

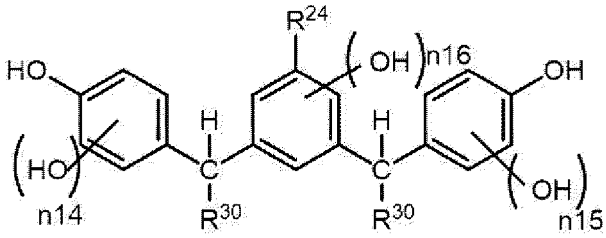

(H1-2)

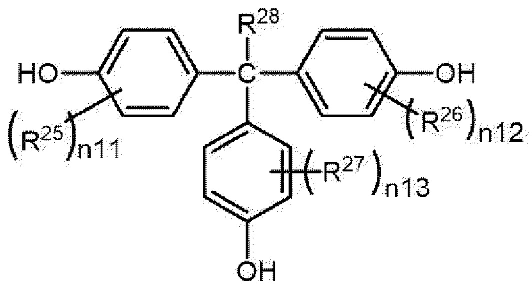

(H1-3)

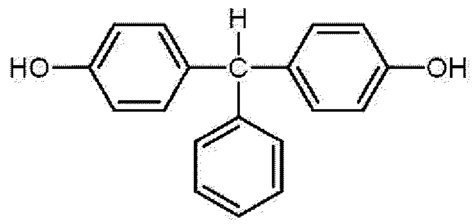

(H1-4)

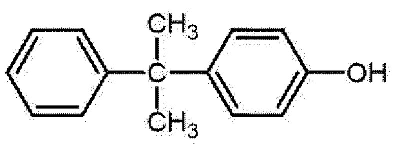

(H1-5)

In Formula (H1-1), $R^{21}$, $R^{22}$, and $R^{23}$ each independently represent a hydrogen atom or a monovalent organic group, and it is preferably a hydrogen atom or a monovalent organic group having 1 to 20 carbon atoms, and more preferably a hydrogen atom or a group represented by Formula (R-1).

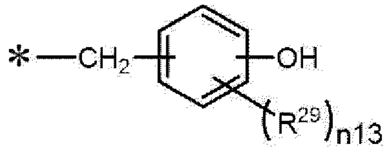

(R-1)

In Formula (R-1), $R^{29}$ represents a hydrogen atom, an alkyl group, or an alkoxy group, n13 represents an integer of 0 to 2, and * represents a bonding site to another structure.

In Formula (H1-1), n8, n9, and n10 each independently represent an integer of 0 to 2, where 0 or 1 is preferable.

In Formula (H1-2), $R^{24}$ represents a hydrogen atom or a monovalent organic group, and it is preferably a hydrogen atom, an alkyl group having 1 to 20 carbon atoms, or an alkoxy group having 1 to 20 carbon atoms. n14, n15, and n16 each independently represent an integer of 0 to 2. $R^{30}$ represents a hydrogen atom or an alkyl group.

In Formula (H1-3), $R^{25}$, $R^{26}$, $R^{27}$, and $R^{28}$ each independently represent a monovalent organic group, and they are preferably a hydrogen atom, an alkyl group, or a group represented by Formula (R-1).

In Formula (H1-3), n11, n12, and n13 each independently represent an integer of 0 to 2, where 0 or 1 is preferable.

The compound represented by Formula (H1-1) is preferably a compound represented by any one of Formulae (H1-1-1) to (H1-1-4).

The compound represented by Formula (H1-2) is preferably a compound represented by Formula (H1-2-1) or (H1-2-2).

The compound represented by Formula (H1-3) is preferably a compound represented by Formulae (H1-3-1) to (H1-3-3).

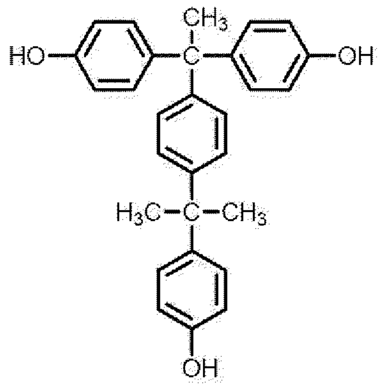

(H1-1-1)

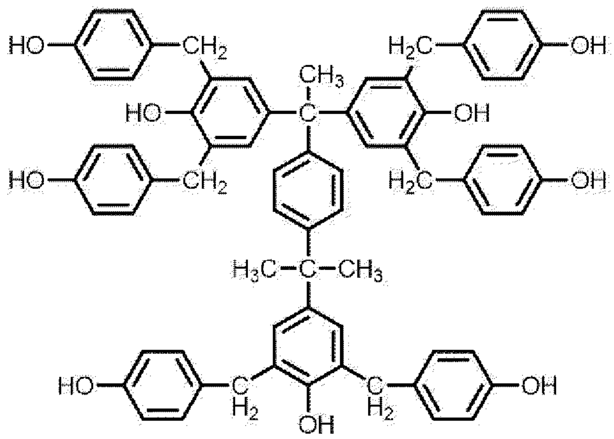

(H1-1-2)

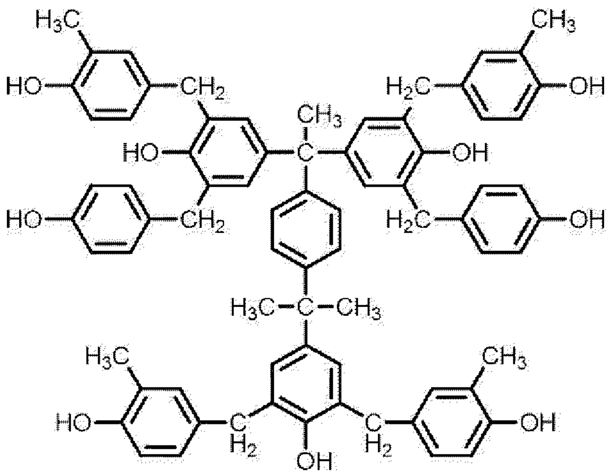

(H1-1-3)

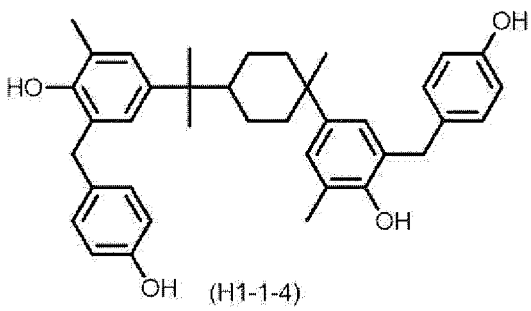

(H1-1-4)

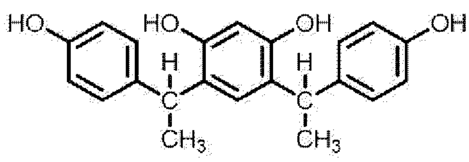

(H1-2-1)

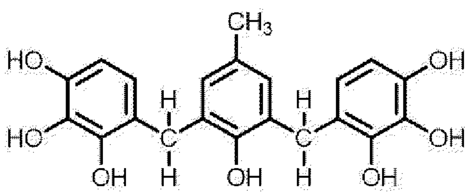

(H1-2-2)

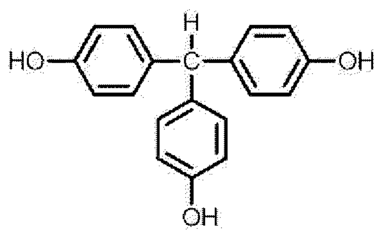

(H1-3-1)

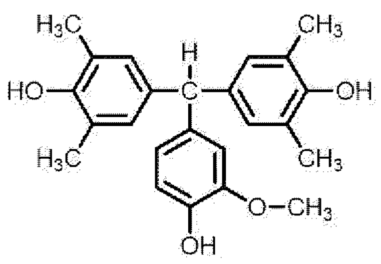

(H1-3-2)

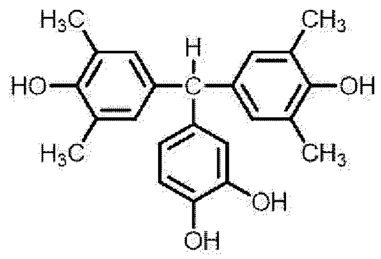

(H1-3-3)

In Formula (H2), Z is preferably a tetravalent group having 1 to 20 carbon atoms, and more preferably a group represented by any one of Formula (Z-1) to (Z-4). In Formulae (Z-1) to (Z-4), * represents a bonding site to another structure.

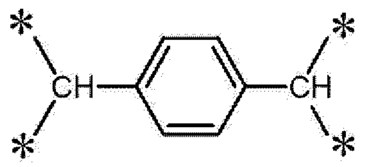

(Z-1)

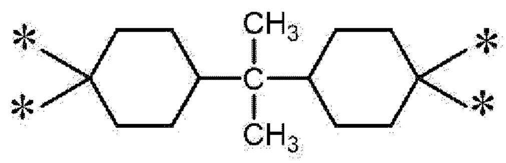

(Z-2)

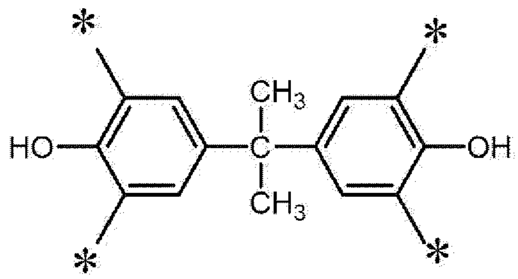

(Z-3)

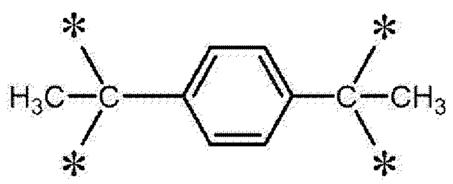

(Z-4)

In Formula (H2), $L^1$, $L^2$, $L^3$, and $L^4$ are each independently preferably a single bond or a methylene group.

In Formula (H2), $R^5$, $R^6$, $R^7$, and $R^8$ are each independently preferably an organic group having 1 to 30 carbon atoms.

In Formula (H2), n3, n4, n5, and n6 are each independently preferably an integer of 0 to 2, and more preferably 0 or 1.

In Formula (H2), m3, m4, m5, and m6 are each independently preferably 1 or 2, and more preferably 1.

Examples of the compound represented by Formula (H2) include compounds having the following structures.

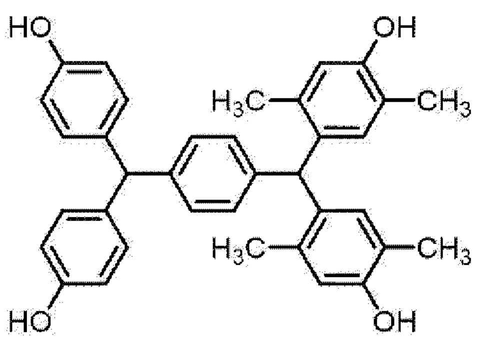

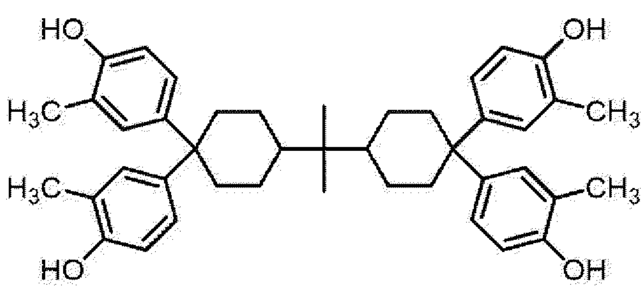

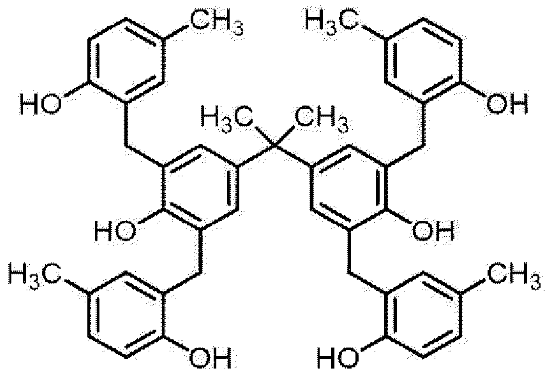

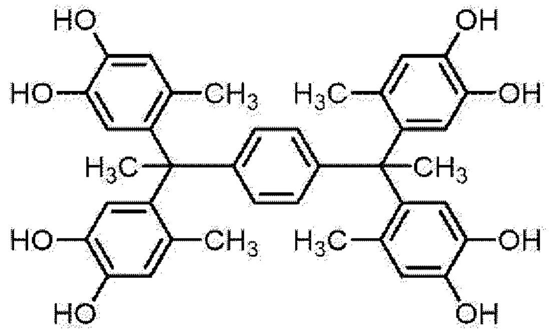

In Formula (H3), $R^9$ and $R^{10}$ each independently preferably represent a hydrogen atom or a monovalent organic group having 1 to 20 carbon atoms.

In Formula (H3), $L^5$'s are each independently preferably a group represented by Formula (L-1).

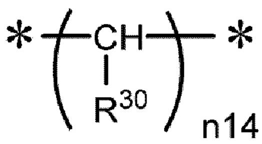

(L-1)

In Formula (L-1), $R^{30}$ represents a monovalent organic group having 1 to 20 carbon atoms, n14 represents an integer of 1 to 5, and * represents a bonding site to another structure.

In Formula (H3), n7 is preferably an integer of 4 to 6.

Examples of the compound represented by Formula (H3) include the following compounds. In the following Formula, n's each independently represent an integer of 0 to 9.

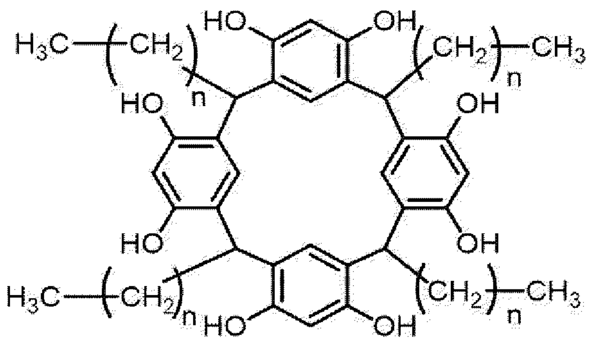

In Formula (H4), $L^6$ is preferably $-C(CF_3)_2-$, $-S(=O)_2-$, or $-C(=O)-$.

In Formula (H4), $L^7$ and $L^8$ are each independently preferably a divalent organic group having 2 to 20 carbon atoms.

Examples of the compound represented by Formula (H4) include the following compounds.

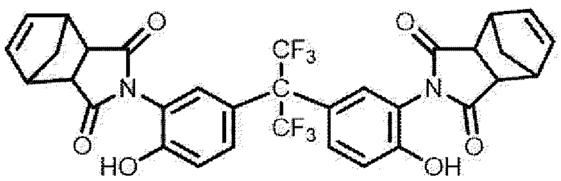

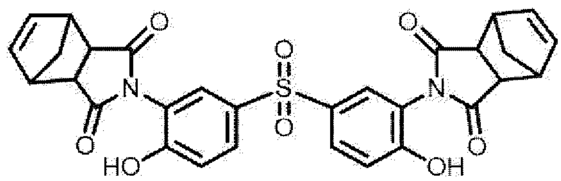

In Formula (H5), $R^{11}$, $R^{12}$, $R^{13}$, $R^{14}$, $R^{15}$, $R^{16}$, $R^{17}$, $R^{18}$, $R^{19}$, and $R^{20}$ are each independently preferably a hydrogen atom, a halogen atom, an alkyl group, an alkenyl group, an alkoxy group, an allyl group, or an acyl group.

In Formula (H5), $L^9$, $L^{10}$, and $L^{11}$ are each independently preferably a single bond, -O-, -S-,

$-S(=O)_2-$,$-C(=O)-$,$-C(=O)O-$, cyclopentylidene, cyclohexylidene, phenylene, or a divalent organic group having 1 to 20 carbon atoms, and they are more preferably a group represented by any one of Formula (L-2) to (L-4).

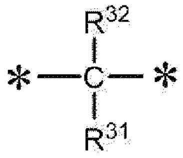

(L-2)

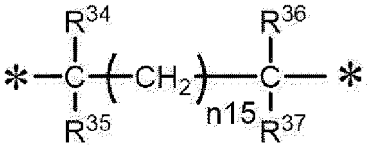

(L-3)

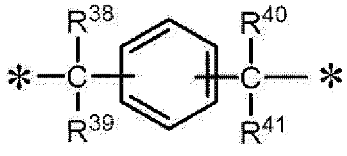

(L-4)

In Formulae (L-2) to (L-4), $R^{31}$ and $R^{32}$ each independently represent a hydrogen atom, an alkyl group, an alkenyl group, or an aryl group, $R^{34}$, $R^{35}$, $R^{36}$, and $R^{37}$ each independently represents a hydrogen atom or an alkyl group, n15 is an integer of 1 to 5, $R^{38}$ $R^{39}$, $R^{40}$, and $R^{41}$ each independently represent a hydrogen atom or an alkyl group, and * represents a bonding site to another structure.

Examples of the compound represented by Formula (H5) include the following compounds.

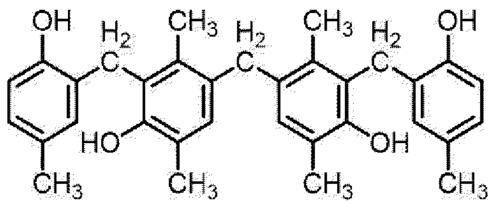

In Formula (H6), $R^{42}$, $R^{43}$, $R^{44}$, and $R^{45}$ each independently represent a hydrogen atom or a monovalent organic group and are preferably a hydrogen atom or a monovalent organic group having 1 to 20 carbon atoms, more preferably a hydrogen atom or an alkyl group having 1 to 20 carbon atoms, and stillmore preferably an alkyl group having 1 to 4 carbon atoms.

In Formula (H6), $R^{46}$ and $R^{47}$ are each independently preferably an alkyl group, an alkoxy group, or an aryl group, and more preferably an alkyl group.

In Formula (H6), n16 and n17 are each independently preferably an integer of 0 to 2, and more preferably 0 or 1.

In Formula (H6), n16 and n17 are each independently preferably an integer of 1 to 3, and more preferably 2 or 3.

Examples of the compound represented by Formula (H6) include the following compounds.

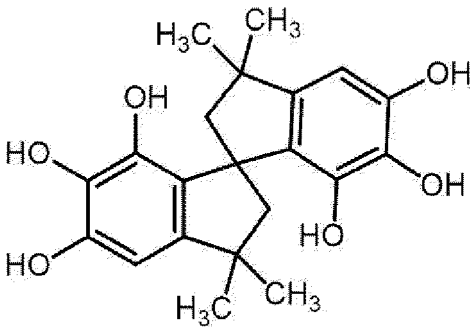

**In** addition, examples of the hydroxy compound include polyhydroxybenzophenones such as 2,3,4-trihydroxybenzophenone, 2,4,4'-trihydroxybenzophenone, 2,4,6-trihydroxybenzophenone, 2,3,4-trihydroxy-2'-methylbenzophenone, 2,3,4,4'-tetrahydroxybenzophenone, 2,2',4,4'-tetrahydroxybenzophenone, 2,4,6,3',4'-pentahydroxybenzophenone, 2,3,4,2',4'-pentahydroxybenzophenone, 2,3,4,2',5'-pentahydroxybenzophenone, 2,4,6,3',4',5'-hexahydroxybenzophenone, and 2,3,4,3',4',5'-hexahydroxybenzophenone; polyhydroxyphenylalkylketones such as 2,3,4-trihydroxyacetophenone, 2,3,4-trihydroxyphenylpentylketone, and 2,3,4-trihydroxyphenylhexylketone,

bis((poly)hydroxyphenyl) alkanes such as bis(2,4-dihydroxyphenyl)methane, bis(2,3,4-trihydroxyphenyl)methane, bis(2,4-dihydroxyphenyl)propane-1, bis(2,3,4-trihydroxyphenyl)propane-1, nordihydroguaiaretic acid, and 1,1-bis(4-hydroxyphenyl)cyclohexane, polyhydroxybenzoic acid esters such as 3,4,5-trihydroxybenzoic acid propyl, 2,3,4-trihydroxybenzoic acid phenyl, and 3,4,5-trihydroxybenzoic acid phenyl, and bis(polyhydroxybenzoil) alkanes or bis(polyhydroxybenzoil) aryls such as bis(2,3,4-trihydroxybenzoyl)methane, bis(3-acetyl-4,5,6-trihydroxyphenyl)-methane, bis(2,3,4-trihydroxybenzoyl)benzene, and bis(2,4,6-trihydroxybenzoyl)benzene,

alkylene-di(polyhydroxybenzoate) such as ethylene glycol-di(3,5-dihydroxybenzoate) or ethylene glycol-di(3,4,5-trihydroxybenzoate), polyhydroxybiphenyl such as 2,3,4-biphenyltriol, 3,4,5-biphenyltriol, 3,5,3',5'-biphenyltetrol, 2,4,2',4'-biphenyltetrol, 2,4,6,3',5'-biphenylpentol, 2,4,6,2',4',6'-biphenylhexol, or 2,3,4,2',3',4'-biphenylhexol, bis(polyhydroxy) sulfide such as 4,4'-thiobis(1,3-dihydroxy)benzene, bis(polyhydroxyphenyl) ether such as 2,2',4,4'-tetrahydroxydiphenyl ether, bis(polyhydroxyphenyl)sulfoxide such as 2,2',4,4'-tetrahydroxydiphenylsulfoxide, bis(polyhydroxyphenyl)sulfone such as 2,2',4,4'-diphenylsulfone,

polyhydroxytriphenylmethanes such as tris(4-hydroxyphenyl)methane, 4,4',4"-trihydroxy-3,5,3',5'-tetramethyltriphenylmethane, 4,4',3",4"-tetrahydroxy-3,5,3',5'-tetramethyltriphenylmethane, 4-[bis(3,5-dimethyl-4-hydroxyphenyl)methyl]-2-methoxy-phenol, 4,4'-(3,4-diol-benzylidene)bis[2,6-dimethylphenol], 4,4'-[(2-hydroxy-phenyl)methylene]bis[2-cyclohexyl-5-methylphenol], 4,4',2",3",4"-pentahydroxy-3,5,3',5'-tetramethyltriphenylmethane, 2,3,4,2',3',4'-hexahydroxy-5,5'-diacetyltriphenylmethane, 2,3,4,2',3',4',3",4"-octahydroxy-5,5'-diacetyltriphenylmethane, and 2,4,6,2',4',6'-hexahydroxy-5,5'-dipropionyltriphenylmethane, polyhydroxytriphenylethanes such as 4,4'-(phenylmethylene)bisphenol, 4,4'-(1-phenyl-ethylidene)bis[2-methylphenol], and 4,4',4"-ethylidene-trisphenol, polyhydroxyspirobiindanes such as 3,3,3',3'-tetramethyl-1,1'-spirobiindane-5,6,5',6'-tetrol, 3,3,3',3'-tetramethyl-1,1'-spirobiindane-5,6,7,5',6',7'-hexool, 3,3,3',3'-tetramethyl-1,1'-spirobiindane-4,5,6,4',5',6'-hexool, and 3,3,3',3'-tetramethyl-1,1'-spirobiindane-4,5,6,5',6',7'-hexool, polyhydroxyflavans such as 2,4,4-trimethyl-2',4',7'-trihydroxyflavan, polyhydroxyphthalides such as 3,3-bis(3,4-dihydroxyphenyl)phthalide, 3,3-bis(2,3,4-trihydroxyphenyl)phthalide, and 3',4',5',6'-tetrahydroxyspiro[phthalido-3,9'-xanthene], flavono coloring agents such as morin, quercetin, and rutin,

α,α',α"-tris(4-hydroxyphenyl) 1,3,5-triisopropylbenzene, α,α',α"-tris(3,5-dimethyl-4-hydroxyphenyl) 1,3,5-triisopropylbenzene, α,α',α"-tris(3,5-diethyl-4-hydroxyphenyl) 1,3,5-triisopropylbenzene, α,α',α"-tris(3,5-di-n-propyl-4-hydroxyphenyl) 1,3,5-triisopropylbenzene, α,α',α"-tris(3,5-diisopropyl-4-hydroxyphenyl) 1,3,5-triisopropylbenzene, α,α',α"-tris(3,5-di-n-butyl-4-hydroxyphenyl) 1,3,5-triisopropylbenzene, α,α',α"-tris(3-methyl-4-hydroxyphenyl) 1,3,5-triisopropylbenzene, α,α',α"-tris(3-methoxy-4-hydroxyphenyl) 1,3,5-triisopropylbenzene, α,α',α"-tris(2,4-dihydroxyphenyl) 1,3,5-triisopropylbenzene, 1,3,5-tris(3,5-dimethyl-4-hydroxyphenyl)benzene, 1,3,5-tris(5-methyl-2-hydroxyphenyl)benzene, 2,4,6-tris(3,5-dimethyl-4-hydroxyphenylthiomethyl)mesitylene,polyhydroxy compounds described in JP1992-253058A (JP-H4-253058A) such as 1-[α-methyl-α-(4'-hydroxyphenyl)ethyl]-4-[α,α'-bis(4"-hydroxyphenyl)ethyl]benzene, 1-[α-methyl(4'-hydroxyphenyl)ethyl]-3-[α,α'-bis(4"-hydroxyphenyl)ethyl]benzene, 1-[α-methyl-α-(3',5'-dimethyl-4'-hydroxyphenyl)ethyl]-4-[α,α'-bis(3",5"-dimethyl-4"-hydroxy phenyl)ethyl]benzene, 1-[α-methyl(3'-methyl-4'-hydroxyphenyl)ethyl]-4-[α',α'-bis(3"-methyl-4"-hydroxyphenyl)ethy l]benzene, 1-[α-methyl-α-(3'-methoxy-4'-hydroxyphenyl)ethyl]-4-[α',α'-bis(3"-methoxy-4"-hydroxyphen yl)ethyl]benzene, 1-[α-methyl-α-(2',4'-dihydroxyphenyl)ethyl]-4-[α',α'-bis(4"-hydroxyphenyl)ethyl]benzene, and 1-[α-methyl(2',4'-dihydroxyphenyl)ethyl]-3-[α',α'-bis(4"-hydroxyphenyl)ethyl]benzene, polyhydroxy compounds described in JP1993-224410A (JP-H5-224410A) such as α,α,α',α',α",α"-hexakis-(4-hydroxyphenyl)-1,3,5-triethylbenzene, and poly(hydroxyphenyl)alkanes described in JP1993-303200A (JP-H5-303200A) and EP-530148 such as 1,2,2,3-tetra(p-hydroxyphenyl)propane and 1,3,3,5-tetra(p-hydroxyphenyl)pentane,

p-bis(2,3,4-trihydroxybenzoyl)benzene, p-bis(2,4,6-trihydroxybenzoyl)benzene, m-bis(2,3,4-trihydroxybenzoyl) benzene, m-bis(2,4,6-trihydroxybenzoyl)benzene, p-bis(2,5-dihydroxy-3-bromobenzoyl)benzene, p-bis(2,3,4-trihydroxy-5-methylbenzoyl)benzene, p-bis(2,3,4-trihydroxy-5-methoxybenzoyl)benzene, p-bis(2,3,4-trihydroxy-5-nitrobenzoyl)benzene, p-bis(2,3,4-trihydroxy-5-cyanobenzoyl)benzene, 1,3,5-tris(2,5-dihydroxybenzoyl)benzene, 1,3,5-tris(2,3,4-trihydroxybenzoyl)benzene, 1,2,3-tris(2,3,4-trihydroxybenzoyl)benzene, 1,2,4-tris(2,3,4-trihydroxybenzoyl)benzene, 1,2,4,5-tetrakis(2,3,4-trihydroxybenzoyl)benzene, α,α'-bis(2,3,4-trihydroxybenzoyl)p-xylene, α,α',α'-tris(2,3,4-trihydroxybenzoyl)mesilene,

2,6-bis-(2-hydroxy-3,5-dimethylbenzyl)-p-cresol, 2,6-bis-(2-hydroxy-5'-methylbenzyl)-p-cresol, 2,6-bis-(2,4,6-trihydroxybenzyl)-p-cresol, 2,6-bis-(2,3,4-trihydroxybenzyl)-p-cresol, 2,6-bis(2,3,4-trihydroxybenzyl)-3,5-dimethyl-phenol, 4,6-bis-(4-hydroxy-3,5-dimethylbenzyl)-pyrogallol, 2,6-bis-(4-hydroxy-3,5-dimethylbenzyl)-1,3,4-trihydroxy-phenol, 4,6-bis-(2,4,6-trihydroxybenzyl)-2,4-dimethyl-phenol, 4,6-bis-(2,3,4-trihydroxybenzyl)-2,5-dimethyl-phenol, 2,6-bis-(4-hydroxybenzyl)-p-cresol,2,6-bis(4-hydroxybenzyl)-4-cyclohexylphenol, 2,6-bis(4-hydroxy-3-methylbenzyl)-p-cresol, 2,6-bis(4-hydroxy-3,5-dimethylbenzyl)-p-cresol, 2,6-bis(4-hydroxy-2,5-dimethylbenzyl)-p-cresol, 2,6-bis(4-hydroxy-3-methylbenzyl)-4-phenyl-phenol, 2,2',6,6'-tetrakis[(4-hydroxyphenyl)methyl]-4,4'-methylenediphenol, 2,2',6,6'-tetrakis[(4-hydroxy-3,5-dimethylphenyl)methyl]-4,4'-methylenediphenol, 2,2',6,6'-tetrakis[(4-hydroxy-3-methylphenyl)methyl]-4,4'-methylenediphenol, 2,2'-bis[(4-hydroxy-3,5-dimethylphenyl)methyl]6,6'-dimethyl-4,4'-methylenediphenol, 2,2',3,3'-tetrahydro-3,3,3',3'-tetramethyl-1,1'-spiropbi(1H-inden)-5,5',6,6',7,7'-hexanol, bis(4-hydroxy-3,5-dimethylphenyl)-(4-hydroxy-3-methoxyphenyl)methane, and the like.

In addition, a hyponuclear form of a phenol resin, such as a novolak resin, can also be used.

Examples of the naphthoquinone diazide sulfonic acid include 6-diazo 5,6-dihydro-5-oxo-1-naphthalenesulfonic

acid and 1,2-naphthoquinone-(2)-diazo-5-sulfonic acid, where these may be mixedly used.

A production method for a naphthoquinone diazide sulfonic acid ester of a hydroxy compound is not particularly limited. However, it is obtained, for example, by converting naphthoquinone diazide sulfonic acid into a sulfonyl chloride with chlorosulfonic acid or thionyl chloride, and subjecting the obtained naphthoquinone diazide sulfonyl chloride to a condensation reaction with the hydroxy compound.

For example, it can be obtained by subjecting a hydroxy compound and a predetermined amount of naphthoquinone diazide sulfonyl chloride to a reaction in a solvent such as dioxane, acetone, or tetrahydrofuran, in the presence of a basic catalyst such as triethylamine to carry out esterification, washing the obtained product with water, and carrying out drying.

The esterification rate for the naphthoquinone diazide sulfonic acid ester is not particularly limited; however, it is preferably 10% or more, and more preferably 20% or more. The upper limit of the esterification rate is not particularly limited and may be 100%.

The esterification rate can be checked by $^1$H-NMR or the like as a proportion of the esterified groups among the hydroxy groups contained in the hydroxy compound.

In addition, as the light absorbing agent, compounds described in paragraphs 0088 to 0108 of JP2019-206689A can also be used.

The content of the light absorbing agent with respect to the total solid content of the resin composition according to the embodiment of the present invention is not particularly limited, but is preferably 0.1% to 20% by mass, more preferably 0.5% to 10% by mass, and still more preferably 1% to 5% by mass.

In particular, from the viewpoint of improving the adhesiveness to the base material, the resin composition according to the embodiment of the present invention preferably further contains the above-described azole compound and the above-described silane coupling agent. By containing these compounds, particularly, the adhesiveness to the base material is likely to be maintained even after the cured substance is exposed to high temperature and high humidity conditions.

<Polymerization inhibitor>

The resin composition according to the embodiment of the present invention preferably contains a polymerization inhibitor. Examples of the polymerization inhibitor include a phenol-based compound, a quinone-based compound, an amino-based compound, an N-oxyl-free radical-based compound, a nitro-based compound, a nitroso-based compound, a heteroaromatic ring-based compound, and a metal compound.

Specific examples of the polymerization inhibitor include the compounds described in paragraph 0310 of WO2021/112189A, p-hydroquinone, o-hydroquinone, a 4-hydroxy-2,2,6,6-tetramethylpiperidine-1-oxyl free radical, phenoxazine, and 1,4,4-trimethyl-2,3-diazabicyclo[3.2.2]nona-2-en-N,N-dioxide. The content thereof is incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition.

One kind of polymerization inhibitor may be used, or two or more kinds thereof may be used. In a case where two or more kinds of polymerization inhibitors are used, the total thereof is preferably within the above-described range.

<Other additives>

The resin composition according to the embodiment of the present invention may contain various additives as necessary, for example, a surfactant, a higher fatty acid derivative, a thermal polymerization initiator, inorganic particles, an ultraviolet absorbing agent, an organic titanium compounds, an antioxidant, a photoacid generator, an aggregation inhibitor, a phenol-based compound, another polymer compound, a plasticizer, and other auxiliary agents (for example, an anti-foaming agent, and a flame retardant) within the scope in which the effect of the present invention is obtained. By appropriately containing these components, properties such as film properties can be adjusted. The details of the components can be found in, for example, paragraph "0183" and subsequent paragraphs of JP2012-003225A (corresponding to paragraph 0237 of US2013/0034812A) and paragraphs 0101 to 0104 and 0107 to 0109 of JP2008-250074A, the contents of which are incorporated in the present specification. In a case where these additives are blended, the total content thereof is preferably 3% by mass or less of the solid content of the resin composition according to the embodiment of the present invention.

[Inorganic particle]

Specific examples of the inorganic particle include calcium carbonate, calcium phosphate, silica, kaolin, talc,

titanium dioxide, alumina, barium sulfate, calcium fluoride, lithium fluoride, zeolite, molybdenum sulfide, and glass.

The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.

The average particle diameter of the inorganic particles is the primary particle diameter and the volume average particle diameter. The volume average particle diameter can be measured by, for example, a dynamic light scattering method with Nanotrac WAVE II EX-150 (manufactured by Nikkiso Co., Ltd.).

In a case where the above measurement is difficult, the measurement can also be carried out by a centrifugal sedimentation light transmission method, an X-ray transmission method, or a laser diffraction/light scattering method.

[Organic titanium compound]

In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).

II) Tetraalkoxytitanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), titanium tetrastearyloxide, and titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadien-1-yl)bis(2,6-difluorophenyl)titanium, and bis(η 5-2,4-cyclopentadien-1-yl)bis(2,6-difluoro-3-(1H-pyrrol-1-yl)phenyl)titanium.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetonate.

VII) Titanate coupling agents: examples thereof include isopropyltridodecylbenzenesulfonyl titanate.

Among these, it is preferable that the organic titanium compound is at least one compound selected from the group consisting of the above-described I) titanium chelate compound, II) tetraalkoxytitanium compound, and III) titanocene compound, from the viewpoint of more favorable chemical resistance. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case of containing an organic titanium compound, the content thereof is preferably 0.05 to 10 parts by mass and more preferably 0.1 to 2 parts by mass with respect to 100 parts by mass of the specific resin. In a case where the content thereof is 0.05 parts by mass or more, the heat resistance and the chemical resistance of the cured pattern to be obtained are further improved, and in a case where the content thereof is 10 parts by mass or less, the storage stability of the composition is more excellent.

Examples of the other additives include the compounds described in paragraphs 0316 to 0358 of WO2022/145355A. The above description is incorporated in the present specification.

<Characteristics of resin composition>

The viscosity of the resin composition according to the embodiment of the present invention can be adjusted by adjusting the concentration of solid contents of the resin composition. From the viewpoint of the coating film thickness, it is preferably 1,000 $mm^2/s$ to 12,000 $mm^2/s$, more preferably 2,000 $mm^2/s$ to 10,000 $mm^2/s$, and still more preferably 2,500 $mm^2/s$ to 8,000 $mm^2/s$. Within the above range, it is easy to obtain a coating film having high uniformity. In a case of being 1,000 $mm^2/s$ or more, it is easy to carry out coating at a film thickness to be required as, for example, an insulating film for redistribution of a wiring line, and in a case of being 12,000 $mm^2/s$ or less, a coating film having an excellent coating surface shape is obtained.

In a case where a cured substance having a film thickness of 10 μm is formed using the resin composition according to the embodiment of the present invention, the transmittance of the cured substance at a wavelength of 365 nm is preferably 15% or more, more preferably 20% or more, and still more preferably 25% or more.
The upper limit of the transmittance is not particularly limited and may be 100%.
The cured substance can be obtained, for example, by applying the resin composition according to the embodiment of the present invention to a silicon wafer, drying the silicon wafer at 100°C for 5 minutes, performing full-surface exposure with i-rays at an exposure energy of 500 $mJ/cm^2$, raising the temperature at a temperature rising rate of 10°C/min in a nitrogen atmosphere, and heating the silicon wafer at 230°C for 180 minutes.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.
Examples of the method of maintaining the moisture content include adjusting the humidity under storage conditions and reducing the void ratio of the storage container during storage.
From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.
In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.
In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.
Preferred examples of the method of adjusting the content of halogen atoms include ion exchange treatment.
A storage container publicly known in the related art can be used as a storage container for the resin composition according to the embodiment of the present invention. As the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

<Cured substance of resin composition>

In a case of curing the resin composition according to the embodiment of the present invention, it is possible to obtain a cured substance of the resin composition.
The cured substance according to the embodiment of the present invention is a cured substance formed by curing the resin composition.
The curing of the resin composition is preferably carried out by heating. The heating temperature is more preferably 120°C to 400°C, still more preferably 140°C to 380°C, and particularly preferably 170°C to 350°C. The form of the cured substance of the resin composition is not particularly limited and can be selected depending on the use application, where the form includes a film shape, a rod shape, a spherical shape, a pellet shape, and the like. In the present invention, the cured substance preferably has a film shape. The shape of the cured substance can also be selected depending on the use application by the pattern processing of the resin composition, where the use application includes the formation of a protective film on a wall surface, formation of via holes for conduction, adjustment of impedance, electrostatic capacity, or internal stress, and impartment of heat radiation function. The film thickness of the cured substance (the film consisting of the cured substance) is preferably 0.5 μm or more and 150 μm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.

$$\text{Shrinkage ratio [\%]} = 100 - (\text{volume after curing}/\text{volume before curing}) \times 100$$

<Characteristics of cured substance of resin composition>

The imidization reaction rate of the cured substance of the resin composition according to the embodiment of the present invention is preferably 70% or more, more preferably 80% or more, and still more preferably 90% or more. In a case of being 70% or more, a cured substance having excellent mechanical properties may be obtained.
The breaking elongation of the cured substance of the resin composition according to the embodiment of the present invention is preferably 30% or more, more preferably 40% or more, and still more preferably 50% or more.
The glass transition temperature (Tg) of the cured substance of the resin composition according to the embodiment of the present invention is preferably 180°C or higher, more preferably 210°C or higher, and still more preferably 230°C or higher.
The transmittance of the cured substance at a wavelength of 365 nm is preferably 15% or more, more preferably 20% or more, and still more preferably 25% or more.
The upper limit of the transmittance is not particularly limited and may be 100%.

<Preparation of resin composition>

The resin composition according to the embodiment of the present invention can be prepared by mixing the above-described components. The mixing method is not particularly limited, and mixing can be carried out by methods publicly known in the related art.
Examples of the mixing method include mixing with a stirring blade, mixing with a ball mill, and mixing by rotating a tank.
The temperature during the mixing is preferably 10°C to 30°C, and more preferably 15°C to 25°C.
It is preferable to carry out filtration using a filter for the intended purpose of removing foreign substances such as dust and fine particles in the resin composition according to the embodiment of the present invention. The filter pore diameter is, for example, preferably 5 μm or less, more preferably 1 μm or less, still more preferably 0.5 μm or less, and even still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case of carrying out pressurization to carry out filtration, the pressure for pressurization is, for example, preferably 0.01 MPa or more and 1.0 MPa or less, more preferably 0.03 MPa or more and 0.9 MPa or less, still more preferably 0.05 MPa or more and 0.7 MPa or less, and even still more preferably 0.05 MPa or more and 0.5 MPa or less.
In addition to filtration using a filter, impurity removal treatment using an adsorbing material may be carried out. The filtration using a filter and the impurity removal treatment using an adsorbing material may be combined. As the adsorbing material, a publicly known adsorbing material can be used. Examples thereof include an inorganic adsorbing material such as silica gel and zeolite and an organic adsorbing material such as activated carbon.
After filtration using a filter, a step of placing a bottle filled with the resin composition under reduced pressure to carry out degassing may be provided.

(Manufacturing method for cured substance)

The manufacturing method for a cured substance according to the embodiment of the present invention preferably includes a film forming step of applying a resin composition onto a base material to form a film.
The manufacturing method for a cured substance more preferably includes the above-described film forming step, an exposure step of selectively exposing the film formed by the film forming step, and a development step of

developing the film exposed by the exposure step with a developer to form a pattern.

It is particularly preferable that the manufacturing method for a cured substance includes the film forming step, the exposure step, the development step, and at least one of a heating step of heating a pattern obtained by the development step or a post-development exposure step of exposing the pattern obtained by the development step.

In addition, it is also preferable that the manufacturing method for a cured substance includes the above-described film forming step and a step of heating the film.

Hereinafter, details of each step will be described.

<Film forming step>

The resin composition according to the embodiment of the present invention can be applied onto a base material, thereby being used in a film forming step of forming a film.

The manufacturing method for a cured substance according to the embodiment of the present invention preferably includes a film forming step of applying a resin composition onto a base material to form a film.

[Base material]

The kind of the base material can be appropriately determined depending on the use application and is not particularly limited. Examples of the base material include a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, or Fe, paper, spin-on-glass (SOG), a thin film transistor (TFT) array base material, a mold base material, and an electrode plate of a plasma display panel (PDP). In particular, the base material is preferably a base material for semiconductor production, and more preferably a silicon base material, a Cu base material, or a mold base material.

A layer such as an intimate attachment layer made of hexamethyl disilazane (HMDS) or the like, or an oxide layer may be provided on the surface of these base materials.

The shape of the base material is not particularly limited, and it may be a circular shape or may be a rectangular shape.

In a case where the base material has a circular shape, the size of the base material is, for example, preferably a diameter of 100 to 450 mm and more preferably 200 to 450 mm. In a case of a rectangular shape, the length of the short side is, for example, preferably 100 to 1,000 mm and more preferably 200 to 700 mm.

As the base material, for example, a base material having a plate shape and preferably a base material (a substrate) having a panel shape are used.

In a case where the resin composition is applied to form a film on a surface of a resin layer (for example, a layer consisting of a cured substance) or on a surface of a metal layer, the resin layer or the metal layer serves as the base material.

The means for applying the resin composition onto a base material is preferably coating.

Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, a spin coating method, a slit coating method, a spray coating method, or an ink jet method is more preferable, and from the viewpoint of the uniformity of the film thickness and the viewpoint of productivity, a spin coating method or a slit coating method is more preferable. A film having a desired thickness can be obtained by adjusting the concentration of solid contents of the resin composition and application conditions according to the means to be applied. In addition, the coating method can be appropriately selected depending on the shape of the base material. In a case where a circular base material such as a wafer is used, a spin coating method, a spray coating method, an ink jet method, or the like is preferable, and in a case where a rectangular base material is used, a slit coating method, a spray coating method, an ink jet method, or the like is preferable. For example, the spin coating method can be applied at a rotation speed of 500 to 3,500 rpm for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used.

In addition, a step of removing an unnecessary film at the end part of the base material may be carried out. Examples of such a step include edge bead rinsing (EBR) and back rinsing.

A pre-wetting step of applying various solvents onto the base material before applying the resin composition onto the base material to improve the wettability of the base material and then applying the resin composition may be adopted.

<Drying step>

The above film may be subjected to a step (a drying step) of drying the film (or the layer) formed for removing the solvent, after the film forming step (the layer forming step).
That is, the manufacturing method for a cured substance according to the embodiment of the present invention may include a drying step of drying the film formed by the film forming step.
It is preferable that the drying step is carried out after the film forming step and before the exposure step.
The drying temperature of the film in the drying step is preferably 50°C to 150°C, more preferably 70°C to 130°C, and still more preferably 90°C to 110°C. **In** addition, the drying may be carried out by reducing the pressure. Examples of the drying time include 30 seconds to 20 minutes, and the drying time is preferably 1 minute to 10 minutes and more preferably 2 minutes to 7 minutes.

<Exposure step>

The film may be subjected to an exposure step of selectively exposing the film.
The manufacturing method for a cured substance may include an exposure step of selectively exposing the film formed by the film forming step.
The selective exposure means that a part of the film is exposed. In addition, by selectively exposing the film, an exposed region (an exposed portion) and an unexposed region (a non-exposed portion) are formed in the film.
The exposure amount is not particularly limited as long as the resin composition according to the embodiment of the present invention can be cured; however, it is, for example, preferably 50 to 10,000 mJ/cm$^2$ and more preferably 200 to 8,000 mJ/cm$^2$ in terms of conversion of exposure energy at a wavelength of 365 nm.
The exposure wavelength can be appropriately determined in a range of 190 to 1,000 nm and preferably in a range of 240 to 550 nm.
Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. Regarding the resin composition according to the embodiment of the present invention, exposure with a high pressure mercury lamp is particularly preferable, and from the viewpoint of exposure sensitivity, exposure with an i-line is more preferable.
The exposure method is not particularly limited as long as at least a part of the film consisting of the resin composition according to the embodiment of the present invention is exposed; however, examples thereof include exposure using a photo mask and exposure by a laser direct imaging method.

<Post-exposure heating step>

The film may be subjected to a step of carrying out heating after the exposure (a post-exposure heating step).
That is, the manufacturing method for a cured substance according to the embodiment of the present invention may include a post-exposure heating step of heating the film exposed in the exposure step.
The post-exposure heating step can be carried out after the exposure step and before the development step.
The heating temperature in the post-exposure heating step is preferably 50°C to 140°C and more preferably 60°C to 120°C.
The heating time in the post-exposure heating step is preferably 30 seconds to 300 minutes and more preferably 1 minute to 10 minutes.
In the post-exposure heating step, the temperature rising rate from the temperature at the start of heating to the maximum heating temperature is preferably 1 to 12 °C/min, more preferably 2 to 10 °C/min, and still more preferably 3 to 10 °C/min.
In addition, the temperature rising rate may be appropriately changed during heating.
The heating means in the post-exposure heating step is not particularly limited, and a publicly known hot plate, oven, infrared heater, or the like can be used.
In addition, it is also preferable to carry out the heating in an atmosphere having a low oxygen concentration by allowing an inert gas such as nitrogen, helium, argon, or the like to flow.

<Development step>

The exposed film may be subjected to a development step of carrying out development using a developer to form a pattern.
That is, the manufacturing method for a cured substance according to the embodiment of the present invention may include a development step of developing the film exposed in the exposure step using a developer to form a pattern.
By carrying out the development, one of the exposed portion and the non-exposed portion of the film is removed, and a pattern is formed.
Here, the development in which the non-exposed portion of the film is removed by the development step is referred to as negative-tone development, and the development in which the exposed portion of the film is removed by the development step is referred to as positive-tone development.

[Developer]

Examples of the developer that is used in the development step include a developer containing an alkaline aqueous solution or an organic solvent.
In a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. The content of the basic compound in the developer is preferably 0.01% to 10% by mass, more preferably 0.1% to 5% by mass, and still more preferably 0.3% to 3% by mass in the total mass of the developer.
In a case where the developer contains an organic solvent, the compounds described in paragraph 0387 of WO2021/112189A can be used as the organic solvent. The content thereof is incorporated in the present specification. In addition, suitable examples of the alcohols include methanol, ethanol, propanol, isopropanol, butanol, pentanol, octanol, diethylene glycol, propylene glycol, methyl isobutyl carbinol, and triethylene glycol, and suitable examples of the amides include N-methylpyrrolidone, N-ethylpyrrolidone, and dimethylformamide.
In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is particularly preferable.
In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.
In a case where the developer contains an organic solvent, the developer may further contain at least one of a basic compound or a base generator. In a case where at least one of the basic compound or the base generator in the developer permeates into the pattern, the performance such as the breaking elongation of the pattern may be improved.
The basic compound is preferably an organic base from the viewpoint of the reliability in a case of being remained in the cured film (the adhesiveness to the base material in a case where the cured substance is further heated).
The basic compound is preferably a basic compound having an amino group and preferably a primary amine, a secondary amine, a tertiary amine, an ammonium salt, a tertiary amide, or the like. However, in order to accelerate the imidization reaction, it is preferably a primary amine, a secondary amine, a tertiary amine, or an ammonium salt, more preferably a secondary amine, a tertiary amine, or an ammonium salt, still more preferably a secondary amine or a tertiary amine, and particularly preferably a tertiary amine.
From the viewpoint of mechanical characteristics (the breaking elongation) of the cured substance, it is preferable that the basic compound hardly remains in the cured film (the obtained cured substance), and from the viewpoint of accelerating cyclization, it is preferable that the residual amount of the basic compound hardly decreases due to vaporization or the like before heating.
Therefore, the boiling point of the basic compound is preferably 30°C to 350°C, more preferably 80°C to 270°C,

and still more preferably 100°C to 230°C at normal pressure (101,325 Pa).

The boiling point of the basic compound is preferably higher than the temperature obtained by subtracting 20°C from the boiling point of the organic solvent contained in the developer, and it is more preferably higher than the boiling point of the organic solvent contained in the developer.

For example, in a case where the boiling point of the organic solvent is 100°C, the basic compound to be used preferably has a boiling point of 80°C or higher and more preferably a boiling point of 100°C or higher.

The developer may contain only one kind of basic compound having an amide group or may contain two or more kinds thereof.

Specific examples of the basic compound include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, tetrabutylammonium hydroxide, ethylenediamine, butanediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl) amine, piperidine, methylpiperidine, dimethylpiperidine, piperazine, tropane, N-phenylbenzylamine, 1,2-dianilinoethane, 2-aminoethanol, toluidine, aminophenol, hexylaniline, phenylene diamine, phenylethylamine, dibenzylamine, pyrrole, N-methylpyrrole, N,N,N,N-tetramethylethylenediamine, and N,N,N,N-tetramethyl-1,3-propanediamine.

A preferred aspect of the base generator is the same as the preferred aspect of the base generator contained in the above-described composition. In particular, the base generator is preferably a thermal-base generator.

In a case where the developer contains at least one of a basic compound or a base generator, the content of the basic compound or the base generator is preferably 10% by mass or less, and more preferably 5% by mass or less with respect to the total mass of the developer. The lower limit of the content is not particularly limited; however, it is, for example, preferably 0.1% by mass or more.

In a case where the basic compound or the base generator is a solid in an environment where the developer is used, the content of the basic compound or the base generator is also preferably 70% to 100% by mass with respect to the total solid content of the developer.

The developer may contain only one kind of the basic compound or base generator or may contain two or more kinds thereof. In a case where at least one of the basic compound or the base generator is two or more kinds, the total thereof is preferably within the above-described range.

The developer may further contain another component.

Examples of the other component include a publicly known surfactant and a publicly known anti-foaming agent.

[Method of supplying developer]

The method of supplying a developer is not particularly limited as long as a desired pattern can be formed, and it includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

Examples of the method of supplying a developer in the development step include a step of continuously supplying a developer to a base material, a step of keeping a developer in a substantially stationary state on a base material, a step of vibrating a developer on a base material by ultrasonic waves or the like, and a step obtained by combining these steps.

The development time is preferably 10 seconds to 10 minutes and more preferably 20 seconds to 5 minutes. The temperature of the developer during development is not particularly determined; however, it is preferably 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.
Examples of the organic solvent in a case where the rinsing liquid contains an organic solvent include the same organic solvents as the organic solvents exemplified in the above-described case where the developer contains an organic solvent.
The organic solvent contained in the rinsing liquid is preferably an organic solvent different from the organic solvent contained in the developer, and it is more preferably an organic solvent having a solubility of the pattern, which is lower than that of the organic solvent contained in the developer.
In a case where the rinsing liquid contains an organic solvent, one kind of organic solvent can be used, or two or more kinds thereof can be mixedly used. The organic solvent is preferably cyclopentanone, γ-butyrolactone, dimethyl sulfoxide, N-methylpyrrolidone, cyclohexanone, PGMEA, or PGME, more preferably cyclopentanone, γ-butyrolactone, dimethyl sulfoxide, PGMEA, or PGME, and still more preferably cyclohexanone or PGMEA.
In a case where the rinsing liquid contains an organic solvent, the organic solvent is preferably 50% by mass or more, more preferably 70% by mass or more, and still more preferably 90% by mass or more with respect to the total mass of the rinsing liquid. In addition, the organic solvent may be 100% by mass with respect to the total mass of the rinsing liquid.
The rinsing liquid may contain at least one of a basic compound or a base generator.
Although not particularly limited, in a case where the developer contains an organic solvent, an aspect in which the rinsing liquid contains at least one of an organic solvent, a basic compound, or a base generator is also one of the preferred aspects of the present invention.
Examples of the basic compound and the base generator which are contained in the rinsing liquid include the compounds exemplified as the basic compound and the base generator which may be contained in a case where the developer contains an organic solvent, and the same applies to the preferred aspects thereof.
The basic compound and the base generator, which are contained in the rinsing liquid, may be selected in consideration of the solubility in the solvent in the rinsing liquid.
In a case where the rinsing liquid contains at least one of a basic compound or a base generator, the content of the basic compound or the base generator is preferably 10% by mass or less, and more preferably 5% by mass or less with respect to the total mass of the rinsing liquid. The lower limit of the content is not particularly limited; however, it is, for example, preferably 0.1% by mass or more.
In a case where the basic compound or the base generator is a solid in an environment where the rinsing liquid is used, the content of the basic compound or the base generator is also preferably 70% to 100% by mass with respect to the total solid content of the rinsing liquid.
In a case where the rinsing liquid contains at least one of a basic compound or a base generator, the rinsing liquid may contain only one kind of the basic compound or base generator or may contain two or more kinds thereof. In a case where at least one of the basic compound or the base generator is two or more kinds, the total thereof is preferably within the above-described range.
The rinsing liquid may further contain another component.
Examples of the other component include a publicly known surfactant and a publicly known anti-foaming agent.

[Method of supplying rinsing liquid]

The method of supplying a rinsing liquid is not particularly limited as long as a desired pattern can be formed and includes a method of immersing a base material in a rinsing liquid, a method of supplying a rinsing liquid to a base material by liquid filling, a method of supplying a rinsing liquid to a base material with a shower, and a method of continuously supplying a rinsing liquid to a base material by means such as a straight nozzle.
From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.
That is, the rinsing step is preferably a step of supplying, with a straight nozzle, or continuously supplying a rinsing liquid to the exposed film, and it is more preferably a step of supplying a rinsing liquid with a spray nozzle.
In the method of supplying a rinsing liquid in the rinsing step, a step of continuously supplying a rinsing liquid to a base material, a step of keeping a rinsing liquid in a substantially stationary state on a base material, a step of vibrating a

rinsing liquid on the base material by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly determined; however, it is preferably 10°C to 45°C and more preferably 18°C to 30°C.

The development step may include a step of bringing the treatment liquid into contact with the pattern after the treatment using the developer or after the pattern is washed with the rinsing liquid. In addition, such a method of supplying a treatment liquid before the developer or rinsing liquid which is in contact with the pattern is completely dried may be adopted.

Examples of the treatment liquid include a treatment liquid containing at least one of water or an organic solvent and at least one of a basic compound or a base generator.

Preferred aspects of the organic solvent and at least one of the basic compound or the base generator are the same as the preferred aspects of the organic solvent and at least one of the basic compound or the base generator, which are used in the above-described rinsing liquid.

As a method of supplying the treatment liquid to the pattern, the same method as the above-described method of supplying the rinsing liquid can be used, and the same applies to the preferred aspect thereof.

The content of the basic compound or the base generator in the treatment liquid is preferably 10% by mass or less and more preferably 5% by mass or less with respect to the total mass of the treatment liquid. The lower limit of the content is not particularly limited; however, it is, for example, preferably 0.1% by mass or more.

In addition, In a case where the basic compound or the base generator is a solid in an environment where the treatment liquid is used, the content of the basic compound or the base generator is also preferably 70% to 100% by mass with respect to the total solid content of the treatment liquid.

In a case where the treatment liquid contains at least one of a basic compound or a base generator, the treatment liquid may contain only one kind of the basic compound or the base generator, or may contain two or more kinds thereof. In a case where at least one of the basic compound or the base generator is two or more kinds, the total thereof is preferably within the above-described range.

<Heating step>

The pattern obtained by the development step (a pattern after the rinsing in a case where the rinsing step is carried out) may be subjected to a heating step of heating the pattern obtained by the development.

That is, the manufacturing method for a cured substance according to the embodiment of the present invention may include a heating step of heating the pattern obtained by the development step.

In addition, the manufacturing method for a cured substance according to the embodiment of the present invention may include a pattern obtained by another method without carrying out the development step, or a heating step of heating a film obtained by the film forming step.

In the heating step, the resin such as the polyimide precursor is cyclized to be a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.

The heating step is preferably a step of accelerating the cyclization reaction of the polyimide precursor in the pattern under the action of the base or the like generated from the base generator by heating.

The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.

In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition.

The heating time (the heating time at the maximum heating temperature) is preferably 5 to 360 minutes, more preferably 10 to 300 minutes, and still more preferably 15 to 240 minutes.
In particular, in a case of forming a multilayered laminate, the heating temperature is preferably 30°C or higher, more preferably 80°C or higher, still more preferably 100°C or higher, and particularly preferably 120°C or higher, from the viewpoint of adhesiveness between layers.
The upper limit of the heating temperature is preferably 350°C or lower, more preferably 250°C or lower, and still more preferably 240°C or lower.
The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment step may be carried out as a step of two or more stages, for example, a first stage pretreatment step may be carried out in a range of 100°C to 150°C, and then a second stage pretreatment step may be carried out in a range of 150°C to 200°C.
Further, cooling may be carried out after heating, and the cooling rate, in this case, is preferably 1 to 5 °C/min.
From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.
The heating means in the heating step is not particularly limited; however, examples thereof include a hot plate, an infrared furnace, an electric heating oven, a hot air oven, and an infrared oven.

<Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.
That is, the manufacturing method for a cured substance according to the embodiment of the present invention may include a post-development exposure step of exposing the pattern obtained by the development step. The manufacturing method for a cured substance according to the embodiment of the present invention may include the heating step and the post-development exposure step or may include only one of the heating step and the post-development exposure step.
**In** the post-development exposure step, it is possible to accelerate, for example, a reaction in which the cyclization of a polyimide precursor or the like proceeds by photosensitization of a photobase generator.
**In** the post-development exposure step, it is sufficient that at least a part of the pattern obtained in the development step is exposed; however, it is preferable that the whole of the above pattern is exposed.
The exposure amount in the post-development exposure step is preferably 50 to 20,000 $mJ/cm^2$ and more preferably 100 to 15,000 $mJ/cm^2$ in terms of conversion of exposure energy at the wavelength at which the photosensitive compound has a sensitivity.
The post-development exposure step can be carried out using, for example, the light source in the above-described exposure step, and it is preferable to use broadband light.

<Metal layer forming step>

The pattern (preferably a pattern that has been subjected to at least one of the heating step or the post-development exposure step) obtained by the development step may be subjected to a metal layer forming step of forming a metal layer on the pattern.
That is, it is preferable that the manufacturing method for a cured substance according to the embodiment of the present invention includes a metal layer forming step of forming a metal layer on the pattern (preferably a pattern that has been subjected to at least one of the heating step or the post-development exposure step) obtained by the development step.
For the metal layer, existing metal kinds can be used without particular limitations. Examples thereof include copper, aluminum, nickel, vanadium, titanium, chromium, cobalt, gold, tungsten, tin, silver, and an alloy including these metals, where copper or aluminum is more preferable, and copper is still more preferable.
The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method

(PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning method combining photolithography and electrolytic plating. Examples of the preferred aspect of the plating include electrolytic plating using a copper sulfate plating liquid or a copper cyanide plating liquid.

The thickness of the metal layer at the thickest portion is preferably 0.01 to 50 μm and more preferably 1 to 10 μm.

<Use application>

Examples of the field to which the manufacturing method for a cured substance according to the embodiment of the present invention or the cured substance according to the embodiment of the present invention can be applied include an insulating film of an electronic device, an interlayer insulating film for a re-distribution layer, and a stress buffer film. In addition, a sealing film, a substrate material (a base film or cover lay of a flexible print substrate, an interlayer insulating film), or such an insulating film in a use application for mounting as described above, which is patterned by etching, is mentioned. For these use applications, for example, Science & Technology Co., Ltd., "High functionality and applied technology of polyimide" April 2008, Technical library CMC TL "Basics and development of polyimide materials" supervised by Masaaki Kakimoto, published in November 2011, "Latest Polyimide Basics and Applications" edited by Japan Polyimide & Aromatic Polymers Study Group, NTS Inc., August 2010, or the like can be referred to.

The manufacturing method for a cured substance according to the embodiment of the present invention and the cured substance according to the embodiment of the present invention can also be used for the production of board surfaces such as an offset board surface or a screen board surface, for etching of molded parts, for the production of protective lacquers and dielectric layers in electronics, in particular, microelectronics.

(Laminate and manufacturing method for laminate)

A laminate according to the embodiment of the present invention refers to a structure body having a plurality of layers consisting of the cured substance according to the embodiment of the present invention.

The laminate is a laminate including two or more layers consisting of a cured substance, and it may be a laminate in which three or more layers are laminated.

At least one of the two or more layers consisting of a cured substance, which are included in the laminate, is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a cured substance according to the embodiment of the present invention.

In the laminate according to the embodiment of the present invention, an aspect in which two or more layers of layers consisting of a cured substance are included and a metal layer is provided between any of the layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wiring line of the re-distribution layer or the like.

<Laminating step>

The manufacturing method for a laminate according to the embodiment of the present invention preferably further includes a laminating step.

The laminating step is a series of steps including carrying out again, in the following order on the surface of the pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. In addition, (e) the metal layer forming step may be included after at least one of the heating step or the post-development exposure step of (d). It is needless to say that the laminating step may further include appropriately the above-described drying step.

In a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin layers of 2 or more layers and 9 or less layers is still more preferable.

In the above layers, the compositions, shapes, film thicknesses, and the like may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in this order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

(Surface activation treatment step)

The manufacturing method for a laminate according to the embodiment of the present invention preferably includes a surface activation treatment step of subjecting at least a part of the metal layer or a part of the resin composition layer to a surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

It is preferable that the surface activation treatment is carried out on a part or whole of the resin composition layer (the resin layer) after the exposure. **In** a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative-tone development is carried out, it is less likely to be damaged by the surface treatment, and thus the adhesiveness is likely to be improved.

The surface activation treatment can be carried out, for example, according to the method described in paragraph 0415 of WO2021/112189A. The content thereof is incorporated in the present specification.

(Semiconductor device and manufacturing method therefor)

The present invention also discloses a semiconductor device, which includes the cured substance according to the embodiment of the present invention or the laminate.

In addition, the present invention also discloses a manufacturing method for a semiconductor device, which includes the manufacturing method for a cured substance according to the embodiment of the present invention or the manufacturing method for a laminate according to the embodiment of the present invention.

As the specific examples of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

<Synthesis of polyimide precursor>

[Synthesis Example SP-1: Synthesis of polyimide (SP-1)]

20.80 g (40 mmol) of 4,4'-(4,4'-isopropylidenediphenoxy)diphtalic acid anhydride was dissolved in 70 g of N-methylpyrrolidone (NMP). Subsequently, 9.08 g (35.2 mmol) of 4,4'-isopropylidenebis(2-aminophenol) was dissolved in 50 g of NMP, and the solution was added dropwise over 1 hour at a temperature of 10°C to 25°C and stirred at 25°C for 30 minutes. Then, 10 g of toluene was added thereto, the mixture was reacted at 200°C for 4 hours while nitrogen was flowing, and the mixture was cooled to 25°C. Subsequently, 15.3 g (100 mmol) of 4-(chloromethyl)styrene, 16.6 g (120 mmol) of potassium carbonate, 1.66 g (12 mmol) of potassium iodide, and 0.08 g of 2,2,6,6-tetramethylpiperidine 1-oxide free radical were added thereto, the mixture was reacted at 95°C for 15 hours, cooled to 25°C, and diluted with 120 g of tetrahydrofuran. Subsequently, the reaction solution was added dropwise to a mixed solution of 1.8 L of methanol and 0.6 L of water, and the mixture was stirred for 15 minutes and a polyimide resin was filtered. Next, the resin was subjected to reslurrying with 1 L of water, filtered, reslurried again with 1 L of methanol, filtered, and dried at 40°C for 8 hours under reduced pressure. Subsequently, the resin dried as described above was dissolved in 250 g of tetrahydrofuran, 40 g of an ion exchange resin (MB-1: manufactured by ORGANO CORPORATION) was added thereto, the mixture was stirred for 4 hours, the ion exchange resin was filtered and removed, and then the polyimide resin was precipitated in 2 L of methanol and stirred for 15 minutes. The polyimide resin was filtered and acquired, and dried at 45°C for 1 day under reduced pressure to obtain a polyimide resin (SP-1). The obtained polyimide (SP-1) had a weight-average molecular weight of 15,500 and a number-average molecular weight of 7,000. The polyimide (SP-1) is a resin having a repeating unit represented by Formula (SP-1). The structure of the repeating unit was determined from a $^{1}$H-NMR spectrum.

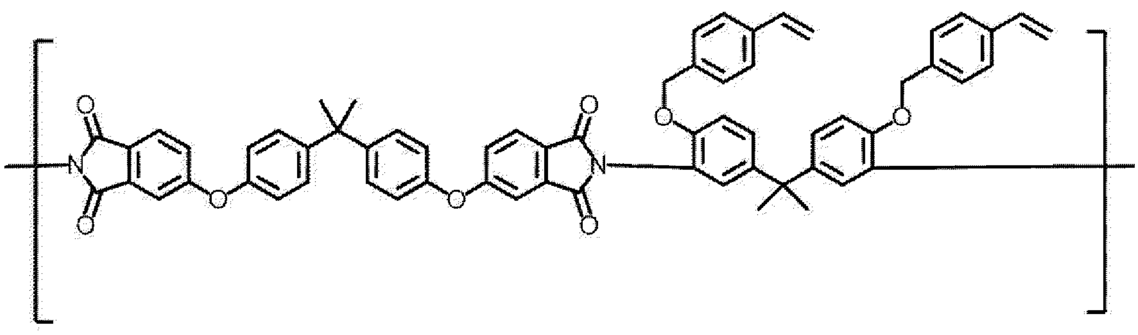

(SP-1)

[Synthesis Examples SP-2 to SP-5: Synthesis of polyimides (SP-2 to SP-5 and SP-12)]

Polyimides (SP-2) to (SP-5) and (SP-12) were synthesized by the same method as that for the polyimide (SP-1),

except that the raw materials used were appropriately changed.

Each of the polyimides (SP-2) to (SP-5) and (SP-12) is a resin having a repeating unit represented by Formulae (SP-2) to (SP-5) and (SP-12). The structure of each repeating unit was determined from a $^1$H-NMR spectrum. In the following structures, the description of the ratio indicates the content molar ratio of each structure. In addition, the weight-average molecular weight and the number-average molecular weight of these resins are shown in the following table.

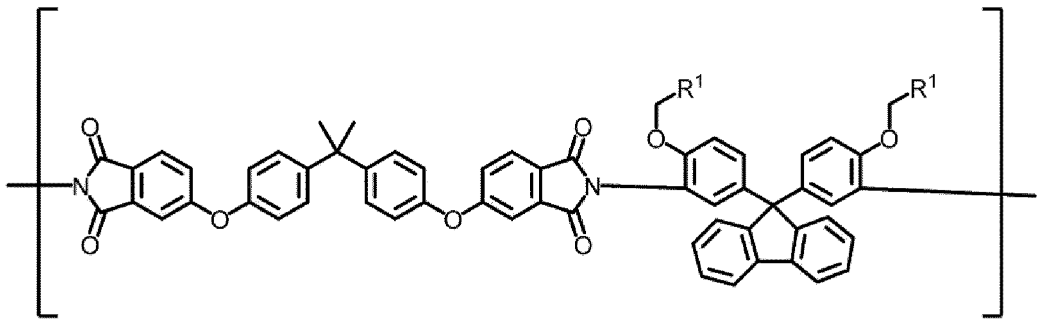

$R^1$= 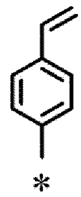 or 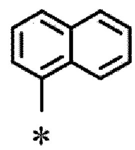

60/40

SP-2

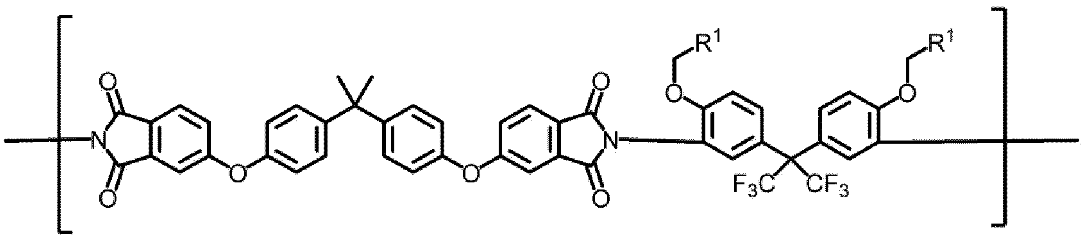

$R^1$= 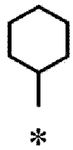 or 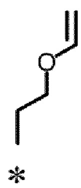

50/50

SP-3

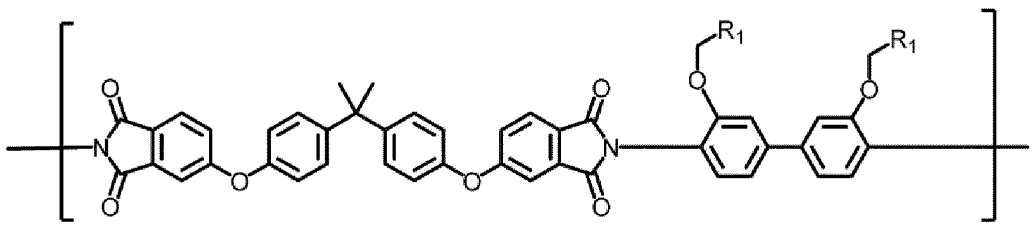

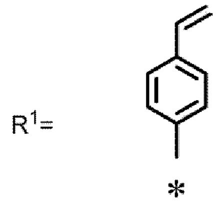

or

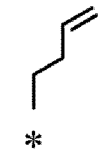

30/70

SP-4

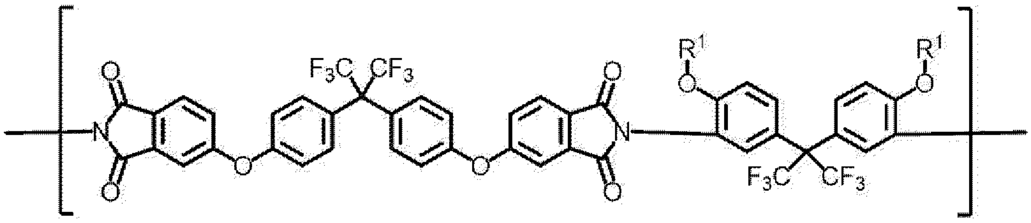

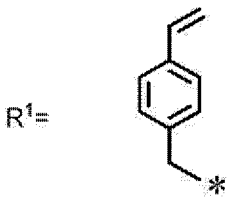

or

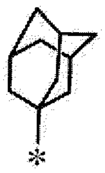

or

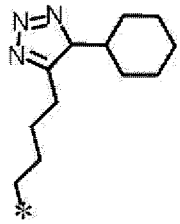

40/40/20

SP-5

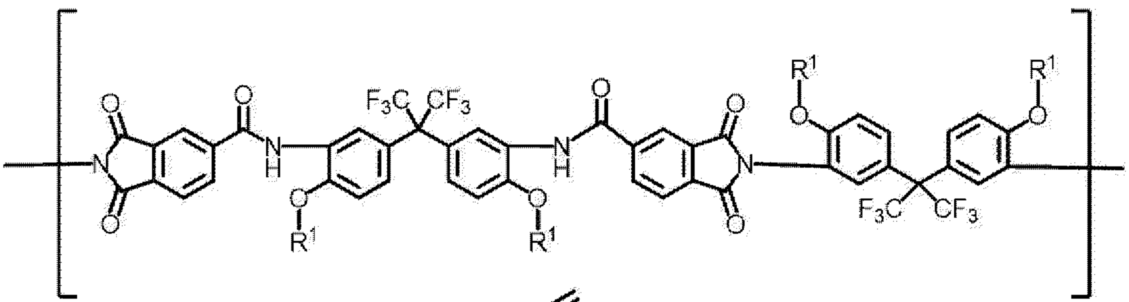

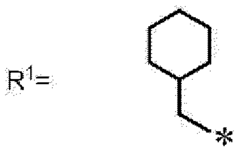

or

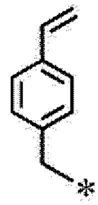

or

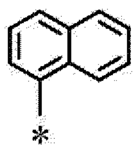

or H

48/30/20/2

SP-12

[Table 1]

| | Weight-average molecular weight | Number-average molecular weight |
|---|---|---|
| SP-2 | 22,100 | 8,900 |
| SP-3 | 50,100 | 19,100 |

(continued)

| | Weight-average molecular weight | Number-average molecular weight |
|---|---|---|
| SP-4 | 35,500 | 14,200 |
| SP-5 | 20,700 | 8,800 |
| SP-12 | 18,900 | 7,700 |

[Synthesis Example SP-6: Synthesis of polyimide (SP-6)]

30.0 g (57.64 mmol) of 4,4'-(4,4'-isopropylidenediphenoxy)diphtalic acid anhydride was dissolved in 120 g of N-methylpyrrolidone (NMP). Subsequently, 9.94 g (24.2 mmol) of 4,4'-isopropylidenebis(2-aminophenol), 5.235 g (24.2 mmol) of 4,4'-diamino-3,3'-dihydroxybiphenyl, and 0.629 g (5.764 mmol) of p-aminophenol were dissolved in 100 g of NMP, and the solution was added dropwise over 1 hour at a temperature of 10°C to 25°C, stirred at 25°C for 30 minutes, 10 g of toluene was added thereto, the mixture was reacted at 200°C for 4 hours while flowing nitrogen, and the mixture was cooled to 25°C. Subsequently, 13.2 g (86.4 mmol) of 4-(chloromethyl)styrene, 16.6 g (120 mmol) of potassium carbonate, 1.66 g (12 mmol) of potassium iodide, and 0.08 g of 2,2,6,6-tetramethylpiperidine 1-oxide free radical were added thereto, the mixture was reacted at 95°C for 15 hours, cooled to 25°C, and diluted with 200 g of tetrahydrofuran. Subsequently, the reaction solution was added dropwise to a mixed solution of 2.0 L of methanol and 0.5 L of water, and the mixture was stirred for 15 minutes and a polyimide resin was filtered. Next, the resin was subjected to reslurrying with 1 L of water, filtered, reslurried again with 1 L of methanol, filtered, and dried at 40°C for 10 hours under reduced pressure. Subsequently, the resin dried as described above was dissolved in 250 g of tetrahydrofuran, 40 g of an ion exchange resin (MB-1: manufactured by ORGANO CORPORATION) was added thereto, the mixture was stirred for 4 hours, the ion exchange resin was filtered and removed, and then the polyimide resin was precipitated in 2 L of methanol and stirred for 15 minutes. The polyimide resin was filtered and acquired, and dried at 45°C for 1 day under reduced pressure to obtain a polyimide resin (SP-6). The obtained polyimide (SP-6) had a weight-average molecular weight of 19,600 and a number-average molecular weight of 7,700. The polyimide (SP-6) is a resin having a repeating unit represented by Formula (SP-6). The structure of the repeating unit was determined from a $^1$H-NMR spectrum. In the following structures, the subscripts of the repeating units represent the content molar ratio of the respective repeating units.

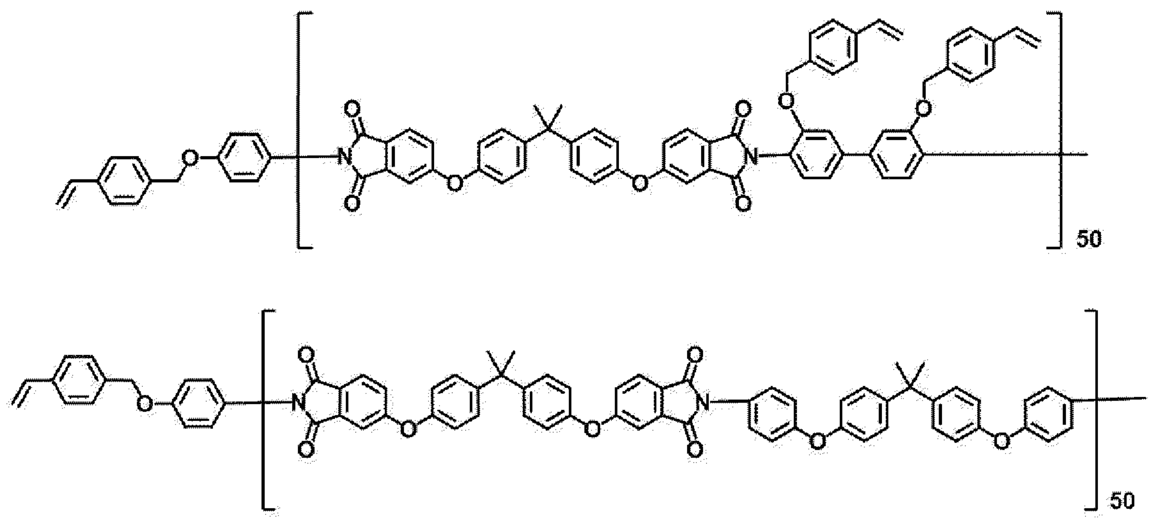

SP-6

[Synthesis Examples SP-7 to SP-11: Synthesis of polyimides (SP-7) to (SP-11) and (SP-13) to (SP-15)]

Polyimides (SP-7) to (SP-11) and (SP-13) to (SP-15) were synthesized by the same method as that for the polyimide (SP-6), except that the raw materials used were appropriately changed.

Each of the polyimides (SP-7) to (SP-11) and (SP-13) to (SP-15) is a resin having a repeating unit represented by Formulae (SP-7) to (SP-11) and (SP-13) to (SP-15). The structure of each repeating unit was determined from a $^1$H-NMR spectrum. In the following structures, the subscripts of the repeating units represent the content molar ratio of the respective repeating units. In the following structures, the subscripts of the repeating units represent the content molar

ratio of the respective repeating units.

In addition, the weight-average molecular weight and the number-average molecular weight of these resins are shown in the following table.

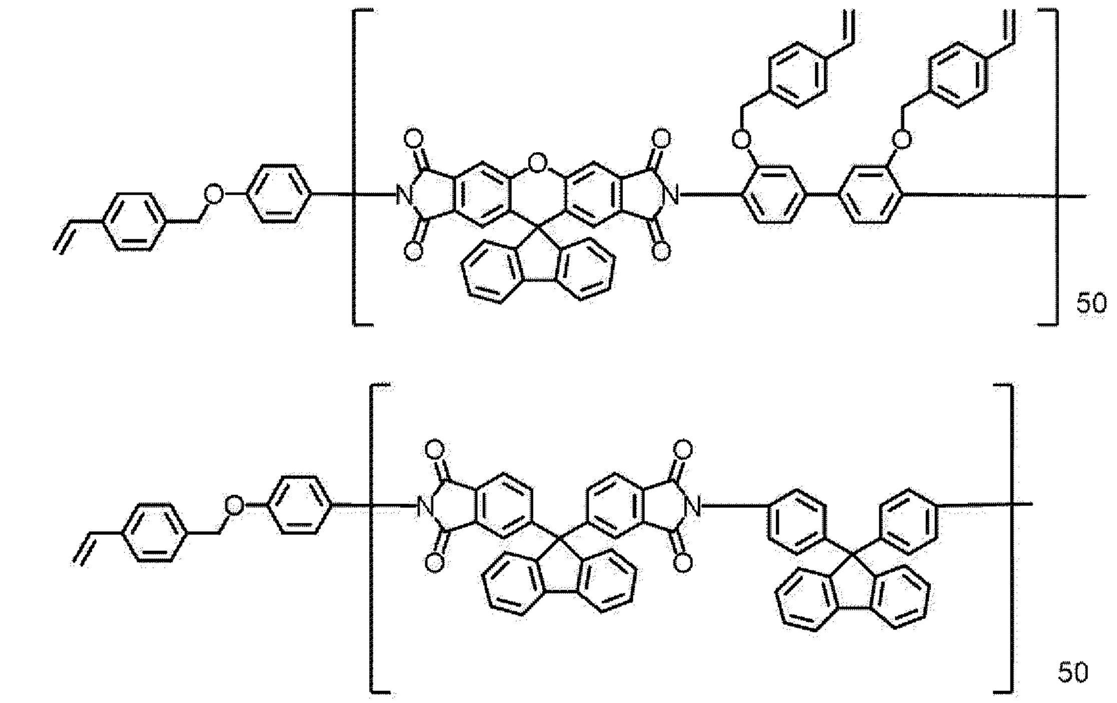

SP-7

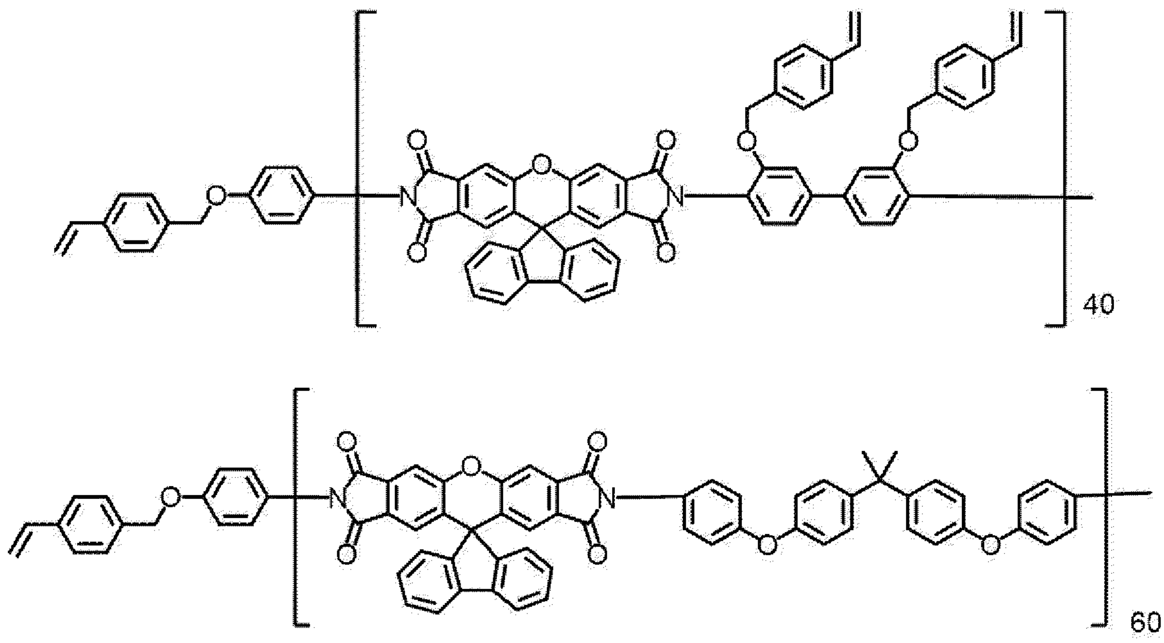

SP-8

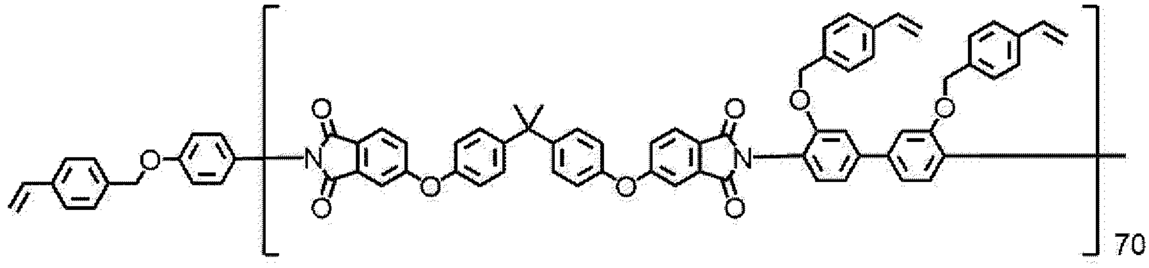

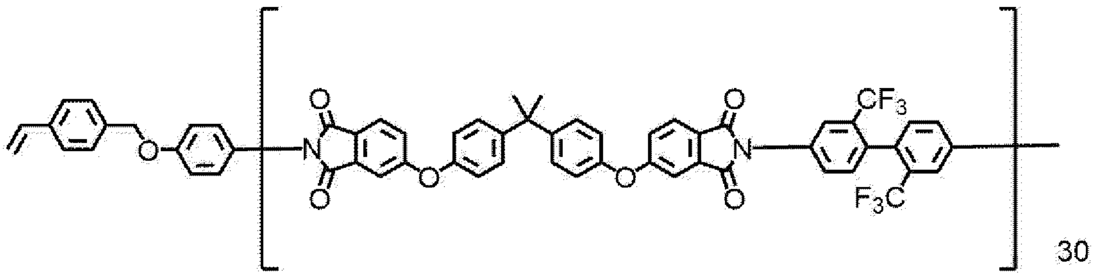

SP-9

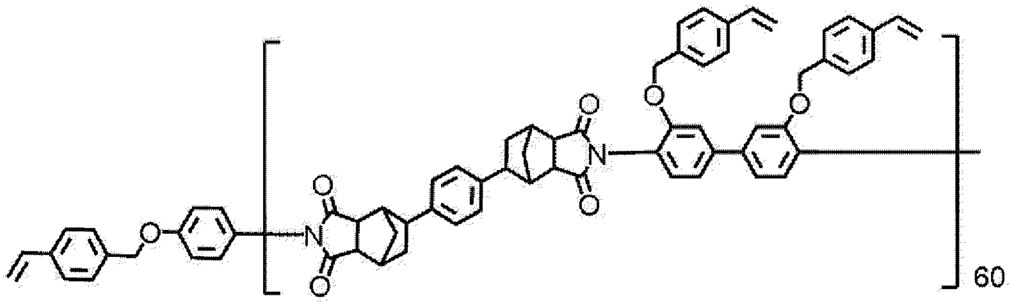

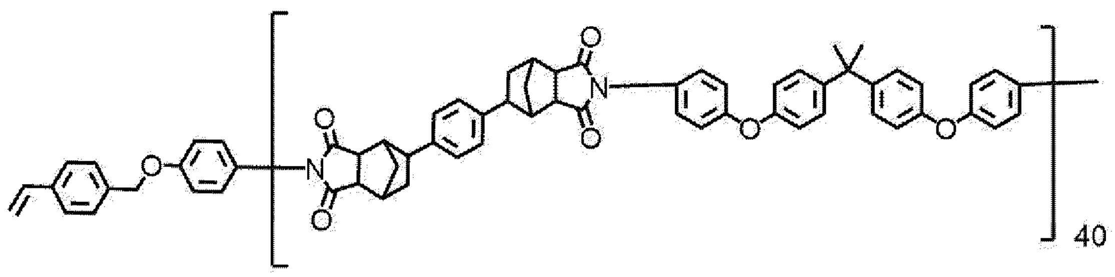

SP-10

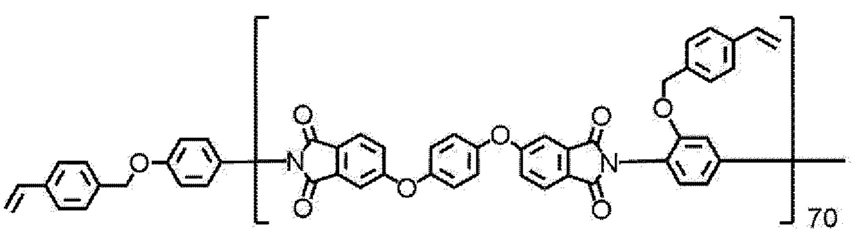

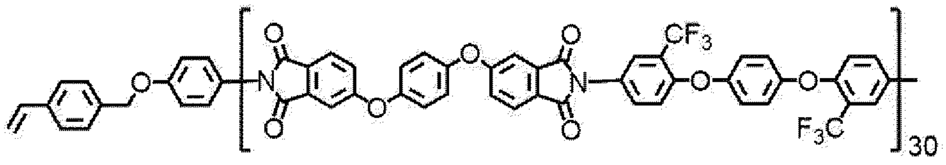

SP-11

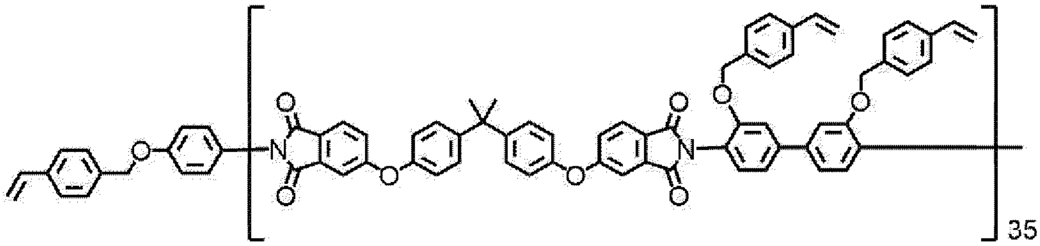

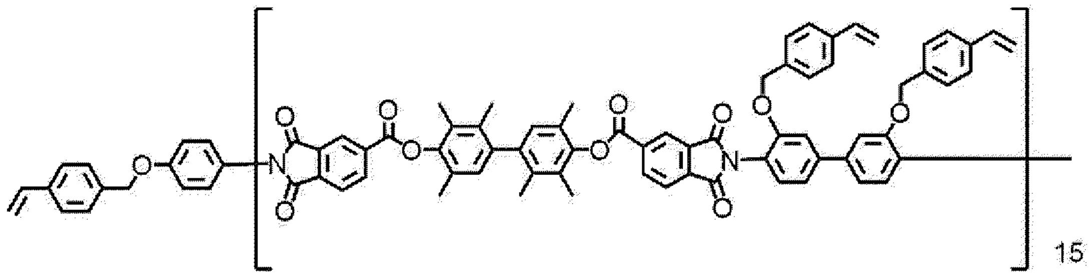

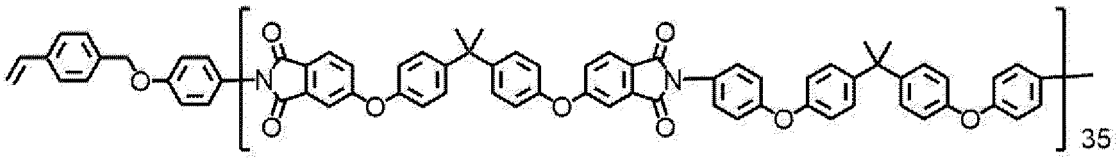

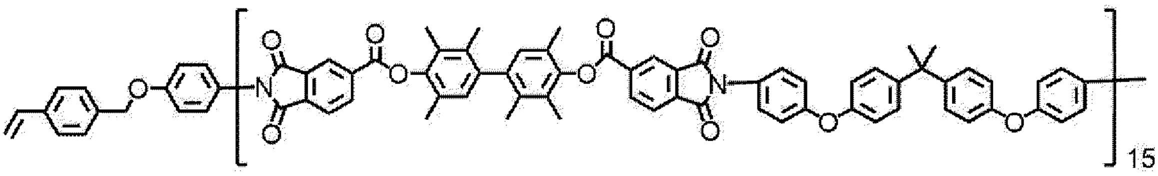

SP-13

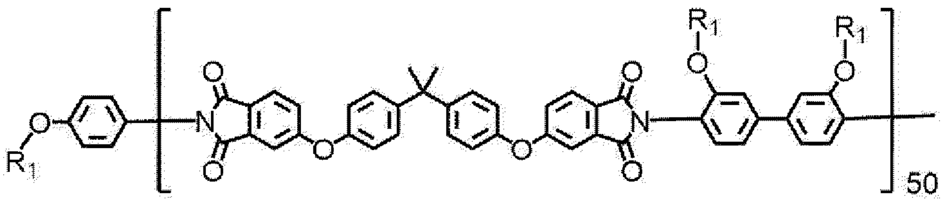

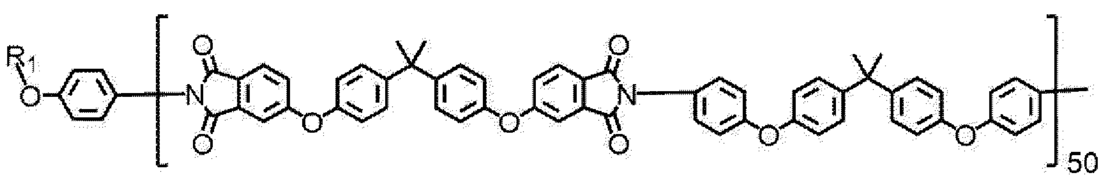

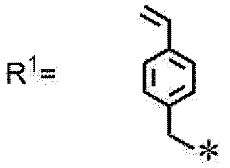 or 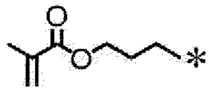 or H = 80 / 19 / 1

SP-14

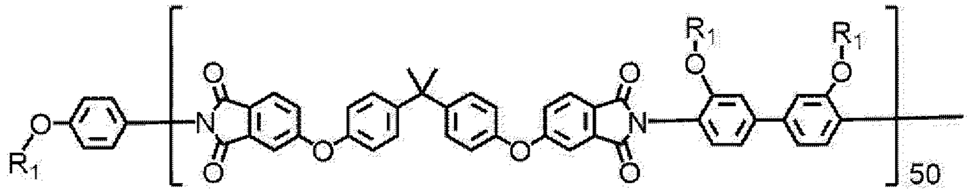

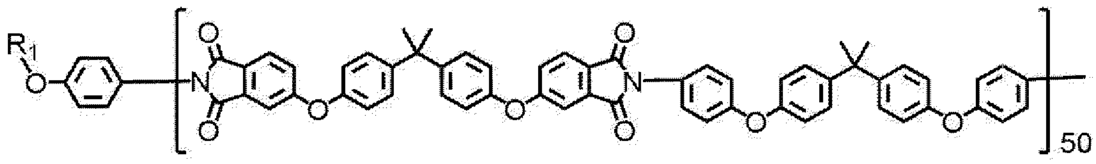

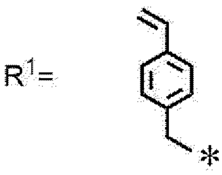 or 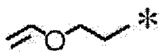 = 60/40

SP-15

[Table 2]

| | Weight-average molecular weight | Number-average molecular weight |
|---|---|---|
| SP-7 | 15.700 | 7.130 |
| SP-8 | 25.900 | 12.600 |
| SP-9 | 45.600 | 17.500 |
| SP-10 | 8.900 | 3.800 |
| SP-11 | 10.600 | 4.200 |
| SP-13 | 14.500 | 7.000 |
| SP-14 | 20.500 | 8.800 |
| SP-15 | 21.200 | 9.100 |

<Synthesis of polyimide precursor>

[Synthesis Example P-1: Synthesis of polyimide precursor P-1]

19.90 g (38.1 mmol) of 4,4'-(4,4'-isopropylidenediphenoxy) diphthalic acid anhydride, 17.80 g (77.8 mmol) of glycerol dimethacrylate, 0.05 g of hydroquinone, 13.40 g (169 mmol) of pyridine, and 70 g of diglyme were mixed, and the mixture was stirred at a temperature of 60°C for 5 hours to produce 4,4'-(4,4'-isopropylidenediphenoxy) bis(phthalic acid anhydride) and a diester of glycerol dimethacrylate. Next, the mixture was cooled to -10°C, 9.53 g (79.2 millimoles) of thionyl chloride was subsequently added dropwise over 90 minutes, and stirring was carried out for 2 hours to obtain a white precipitate of pyridinium hydrochloride. Next, a solution obtained by dissolving 13.47 g (32.8 mmol) of 4,4'-isopropylidenebis[(4-aminophenoxy)benzene] in 100 mL of NMP was added dropwise thereto over 2 hours. Next,

10.0 g (217 millimoles) of ethanol was added, and the mixture was stirred for 2 hours. Next, the polyimide precursor resin was precipitated in 4 L of water and the water-polyimide precursor resin mixture was stirred for 15 minutes at a speed of 500 rpm. The polyimide precursor resin was filtered and acquired, and then the mixture was stirred again in 4 L of water for 30 minutes, filtered again, and dried at 40°C for 2 days. Subsequently, the resin dried as described above was dissolved in 200 g of tetrahydrofuran, 50 g of an ion exchange resin (MB-1: manufactured by ORGANO CORPORATION) was added thereto, and the mixture was stirred for 6 hours. Next, the polyimide precursor resin was precipitated in 4 L of water and the water-polyimide precursor resin mixture was stirred for 15 minutes at a speed of 500 rpm. The polyimide precursor resin was filtered and acquired, and dried at 45°C for 2 days under reduced pressure to obtain a polyimide precursor (P-1). The weight-average molecular weight of the obtained polyimide precursor (P-1) was 28,500, and the number-average molecular weight thereof was 10,400. A polyimide precursor (P-1) is a resin having a repeating unit represented by Formula (P-1). The structure of the repeating unit was determined from a $^{1}$H-NMR spectrum.

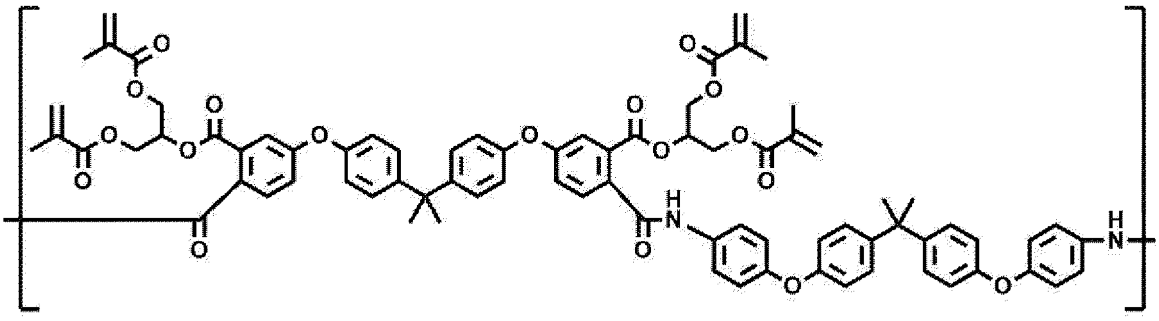

(P-1)

[Synthesis Example P-2: Synthesis of polyimide precursor (P-2)]

A polyimide precursor (P-2) was synthesized in the same method as in Synthesis Example P-1, except that the raw materials used were appropriately changed. The polyimide precursor (P-2) is a resin having a repeating unit represented by Formula (P-2). The structure of the repeating unit was determined from a $^{1}$H-NMR spectrum. In the following structures, the subscripts of the repeating units represent the content molar ratio of the respective repeating units.

The weight-average molecular weight (Mw) of the polyimide precursor (P-2) was measured to be 20,500 and the number-average molecular weight (Mn) was measured to be 8,900.

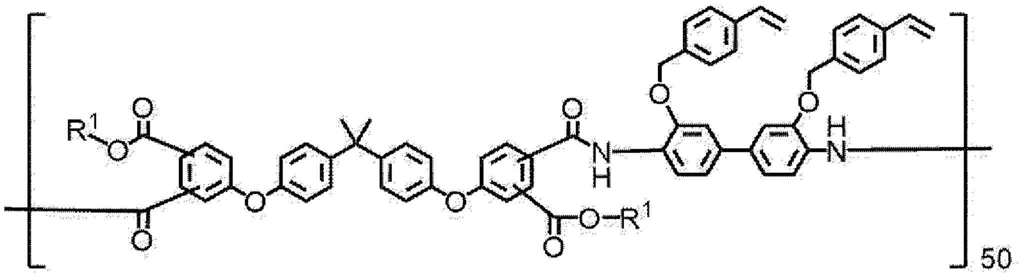

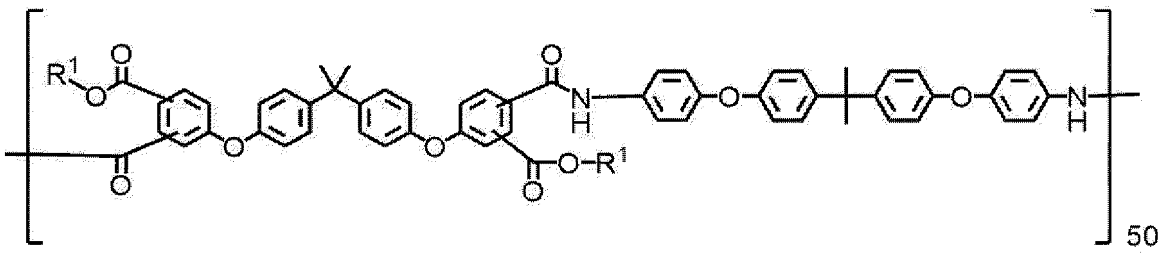

$R^1$= 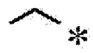 or 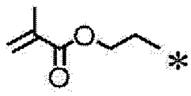 = 90/10

P-2

[Synthesis Example A-1: Synthesis of polyimide precursor (A-1) for Comparative Example]

While removing moisture in a drying reactor comprising a flat bottom joint to which a stirrer, a condenser, and an internal thermometer were attached, 31.0 g (100 mmol) of 4,4'-diaminodiphenyl ether was dissolved in 180.0 g of N-methylpyrrolidone (NMP). Subsequently, 44.4 g (100 mmol) of 4,4'-(hexafluoroisopropylidene)diphthalic acid dianhydride was added thereto, and the mixture was stirred at a temperature of 40°C for 2 hours. Next, 50 mL of toluene was added thereto, the temperature was raised to 180°C while flowing nitrogen at a flow rate of 200 ml/min, stirring was carried out for 6 hours, and cooling was carried out to room temperature. Next, 130.0 g of N-methylpyrrolidone was added thereto, diluted, and then the polyimide was precipitated in 2 L of water, and the water-polyimide mixture was stirred at a speed of 2,000 rpm for 30 minutes. The polyimide precursor resin was filtered and removed, and the filtrate was mixed with 1.5 L of methanol, stirred again for 30 minutes, and filtered again. Next, the obtained polyimide was dried at 40°C for 1 day under reduced pressure to obtain A-1. The weight-average molecular weight (Mw) of A-1 was 30,100, and the number-average molecular weight (Mn) thereof was 14,500.

The polyimide precursor (A-1) is a resin having a repeating unit represented by Formula (A-1). The structure of the repeating unit was determined from a $^1$H-NMR spectrum.

The polyimide precursor (A-1) for Comparative Example does not correspond to the specific resin.

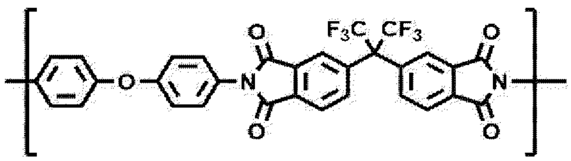

(A-1)

[Synthesis Example A-2: Synthesis of polyimide precursor (A-2)]

77.5 g of 4,4'-oxydiphthalic acid dianhydride (ODPA) and 73.5 g of 4,4'-biphthalic acid dianhydride were placed in a separable flask, and 134.0 g of 2-hydroxyethyl methacrylate (HEMA) and 400 ml of γ-butyrolactone were added thereto. 79.1 g of pyridine was added thereto with stirring at room temperature to obtain a reaction mixture. After the heat generation due to the reaction was stopped, the reaction mixture was further allowed to cool to room temperature and left to stand for 16 hours.

Next, under ice-cooling, a solution obtained by dissolving 206.3 g of dicyclohexylcarbodiimide (DCC) in 180 ml of γ-butyrolactone was added to the reaction mixture over 40 minutes with stirring. Subsequently, a suspension obtained by suspending 93.0 g of 4,4'-diaminodiphenyl ether in 350 ml of γ-butyrolactone was added thereto over 60 minutes with stirring. Further, the suspension was stirred at room temperature for 2 hours, and 30 ml of ethyl alcohol was added thereto, followed by stirring for 1 hour. Then, 400 ml of γ-butyrolactone was added thereto. The precipitate formed in the reaction mixture was acquired by filtration to obtain a reaction solution.

The obtained reaction solution was added to 3 L of ethyl alcohol to form a precipitate consisting of a crude polymer. The produced crude polymer was filtered and collected and then dissolved in 1.5 L of tetrahydrofuran to obtain a crude polymer solution. The obtained crude polymer solution was added dropwise to 28 L of water to precipitate a polymer, and the obtained precipitate was collected by filtration and then vacuum-dried to obtain a powdery comparative polyimide precursor (A-2). In a case where the weight-average molecular weight (Mw) of this comparative polyimide precursor (A-2) was measured, it was 22,600.

The comparative polyimide precursor (A-2) is a resin having a repeating unit represented by Formula (A-2). The structure of the repeating unit was determined from a $^1$H-NMR spectrum. The content molar ratio of each repeating unit is 1: 1.

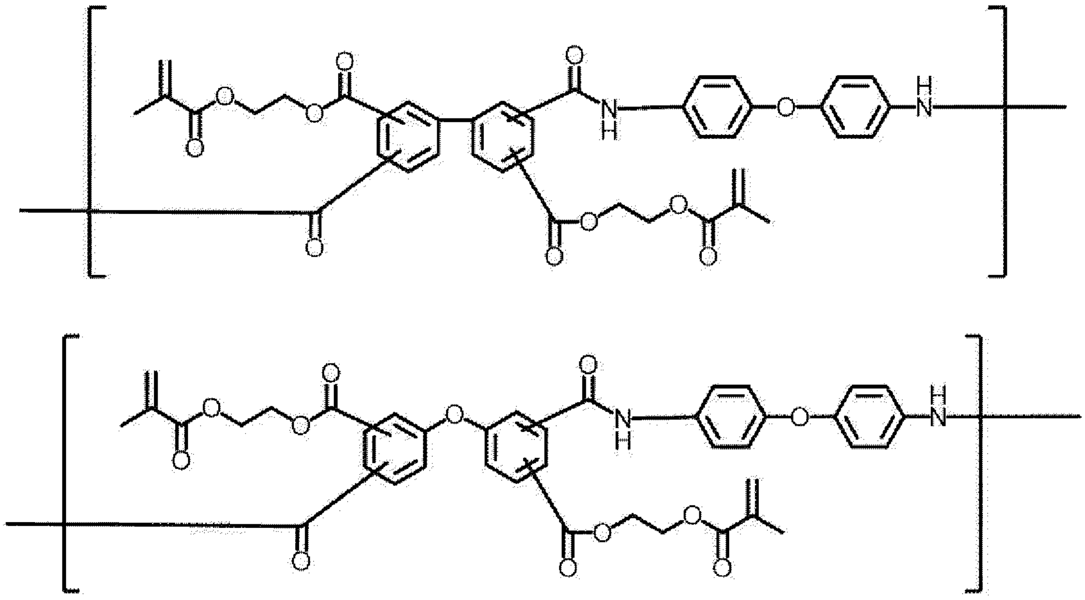

(A-2)

<Examples and Comparative Examples>

**In** each of Examples, the components shown in the table below were mixed to obtain each of the resin compositions. Further, in each Comparative Example, components shown in the following table were mixed to obtain each of the comparative compositions.

Specifically, the content of each component described in the table was set to the amount (in terms of parts by mass) described in the column of "Adding amount" of each column of the table.

The obtained resin composition and the comparative composition were filtered under pressure using a filter made of polytetrafluoroethylene, having a micropore width of 0.5 μm.

In addition, in the table, the description of "-" indicates that the corresponding component is not contained in the composition.

[Table 3]

| | Resin | | Polymerizable compound | | Solvent | | Polymerization initiator | | Migration suppressing agent | | Metal adhesiveness improving agent | | Polymerization inhibitor | | Base generator | | Curing condition | Development method (developer) | Resolution | Focus margin | Chemical resistance | Relative permittivity (Dk) | Dielectric loss tangent (Df) |
|---|---|---|---|---|---|---|---|---|---|---|---|---|---|---|---|---|---|---|---|---|---|---|---|
| | Type | Adding amount | Type | Adding amount | Type | Adding amount | Type | Adding amount | Type | Adding amount | Type | Adding amount | Type | Adding amount | Type | Adding amount | Temperature | | | | | | |
| Example 1 | SP-1 | 30 | B-3 | 55 | DMSO/GBL | 62 | OXE-01 | 165 | E-1 | 01 | F-1 | 07 | G-2 | 005 | - | - | 230°C | Solvent (cyclopentanone) | A | A | A | A | A |
| Example 2 | SP-2 | 305 | B-1 | 60 | γ-V | 61 | OXE-02 | 166 | E-7 | 01 | F-6 | 07 | G-2 | 004 | - | - | 200°C | Solvent (cyclopentanone) | A | A | A | A | A |
| Example 3 | SP-3 | 295 | B-2/B-3 | 40/20 | γ-V | 62 | OXE-01/CPI-310B | 10066 | E-1 | 01 | F-7 | 07 | G-2 | 004 | - | - | 230°C | Solvent (cyclopentanone) | B | B | A | A | A |
| Example 4 | SP-4 | 30 | B-5 | 55 | DMSO/GBL | 62 | OXE-01 | 165 | E-2 | 01 | F-2 | 07 | G-3 | 005 | - | - | 230°C | Solvent (cyclopentanone) | B | B | A | A | A |
| Example 5 | SP-5 | 32 | B-4 | 45 | GBL | 61 | OXE-01 | 166 | E-3 | 01 | F-3 | 07 | G-1 | 004 | - | - | 200°C | Solvent (cyclopentanone) | B | B | A | B | B |
| Example 6 | SP-6 | 294 | B-7 | 71 | GBL | 61 | OXE-02 | 165 | E-7 | 01 | F-4 | 07 | G-2 | 005 | - | - | 230°C | Solvent (cyclopentanone) | A | A | A | A | A |
| Example 7 | SP-7 | 30 | B-8 | 65 | GBL | 61 | OXE-01 | 166 | E-5 | 01 | F-5 | 07 | G-2 | 004 | - | - | 170°C | Solvent (cyclopentanone) | A | A | B | A | A |
| Example 8 | SP-8 | 297 | B-6/B-7 | 518 | GBL | 61 | Irgacure 784 | 166 | E-1 | 01 | F-1 | 07 | G-2 | 004 | - | - | 230°C | Solvent (cyclopentanone) | A | B | A | A | A |
| Example 9 | SP-9 | 297 | B-5/B-8 | 518 | DMSO/GBL | 61 | OXE-01 | 166 | E-1 | 01 | F-1 | 07 | G-2 | 004 | - | - | 230°C | Solvent (cyclopentanone) | B | B | A | A | A |
| Example 10 | SP-10 | 287 | B-3/B-6 | 338 | NMP | 62 | OXE-01 | 166 | E-1 | 01 | F-1 | 07 | G-2 | 004 | - | - | 230°C | Solvent (cyclopentanone) | A | A | B | B | B |
| Example 11 | SP-11 | 297 | B-8 | 68 | GBL | 61 | OXE-01 | 165 | E-1 | 01 | F-1 | 07 | G-2 | 005 | - | - | 230°C | Solvent (cyclopentanone) | A | A | A | A | A |
| Example 12 | SP-1/P-1 | 261/65 | B-1 | 50 | DMSO/GBL | 60 | OXE-01 | 127 | E-1 | 015 | F-1 | 07 | G-2 | 008 | D-1 | 02 | 230°C | Solvent (cyclopentanone) | A | A | A | B | B |

[Table 4]

| | Resin | | Polymerizable compound | | Solvent | | Polymerization initiator | | Migration suppressing agent | | Metal adhesiveness improving agent | | Polymerization inhibitor | | Base generator | | Curing condition | Development method (developer) | Resolution | Focus margin | Chemical resistance | Relative permittivity (Dk) | Dielectric loss tangent (Df) |
|---|---|---|---|---|---|---|---|---|---|---|---|---|---|---|---|---|---|---|---|---|---|---|---|
| | Type | Adding amount | Type | Adding amount | Type | Adding amount | Type | Adding amount | Type | Adding amount | Type | Adding amount | Type | Adding amount | Type | Adding amount | Temperature | | | | | | |
| Example13 | SP-6/P-2 | 26165 | B-2 | 50 | DMSO/γ-V | 60 | OXE-02 | 12 | E-2 | 012 | F-2 | 07 | G-2 | 008 | D-2 | 03 | 230°C | Solvent (cyclopentanone) | B | A | A | A | A |
| Example14 | SP-6/SP-9 | 163163 | B-2 | 53 | NMP | 60 | OXE-02 | 12 | E-2 | 012 | F-2 | 07 | G-2 | 008 | - | - | 230°C | Solvent (cyclopentanone) | A | A | A | B | B |
| Example15 | SP-6 | 313 | B-8 | 60 | GBL | 61 | OXE-02 | 165 | - | - | - | - | G-2 | 005 | - | - | 230°C | Solvent (cyclopentanone) | A | A | A | A | A |
| Example16 | SP-12 | 30 | B-7 | 55 | DMSO/GBL | 62 | OXE-01 | 166 | E-4 | 01 | F-1 | 07 | G-5 | 004 | - | - | 230°C | Solvent (cyclopentanone) | A | A | A | B | B |
| Example17 | SP-13 | 297 | B-8 | 68 | DMSO/GBL | 61 | OXE-01 | 166 | E-6 | 01 | F-1 | 07 | G-4 | 004 | - | - | 230°C | Solvent (cyclopentanone) | A | A | B | A | A |
| Example18 | SP-14 | 294 | B-8 | 71 | GBL | 61 | OXE-02 | 165 | E-5 | 01 | F-4 | 07 | G-2 | 005 | - | - | 230°C | Solvent (cyclopentanone) | A | A | A | B | B |
| Example19 | SP-14 | 294 | B-8 | 68 | NMP | 61 | OXE-01/CPI-310B | 10095 | E-7 | 01 | F-4 | 07 | G-2 | 005 | - | - | 230°C | Solvent (cyclopentanone) | A | A | A | B | B |
| Example20 | SP-6 | 294 | B-7 | 70 | GBL | 61 | OXE-02/D-1 | 1205 | E-7 | 01 | F-4 | 07 | G-6 | 01 | - | - | 200°C | Solvent (cyclopentanone) | A | A | A | A | A |
| Example21 | P-2 | 30 | B-8 | 75 | DMSO/GBL | 60 | OXE-01 | 13 | E-3 | 02 | F-3 | 07 | G-3 | 01 | D-3 | 02 | 230°C | Solvent (cyclopentanone) | B | B | A | A | B |
| Example22 | SP-15 | 294 | B-7 | 71 | GBL | 61 | OXE-02 | 165 | E-7 | 01 | F-4 | 07 | G-2 | 005 | - | - | 230°C | Solvent (cyclopentanone) | A | A | A | A | A |
| Comparative Example1 | A-1 | 30 | B-3 | 77 | DMSO/GBL | 60 | OXE-01 | 13 | E-3 | 02 | F-3 | 07 | G-3 | 01 | - | 0 | 230°C | Solvent (cyclopentanone) | D | D | D | C | D |
| Comparative Example2 | A-2 | 30 | B-9 | 75 | DMSO/GBL | 60 | OXE-01 | 13 | E-3 | 02 | F-3 | 07 | G-3 | 01 | D-3 | 02 | 230°C | Solvent (cyclopentanone) | C | C | B | D | D |

Details of each of the components listed in the table are as follows.

[Resin]

- · SP-1 to SP-15: polyimides (SP-1) to (SP-15) synthesized above
- · P-1 to P-2: Polyimide precursors (P-1) to (P-2) which are synthesized as described above
- · A-1 to A-2: synthetic products (comparative examples) described above

[Polymerizable compound]

- · B-1 to B-2: polymerizable compounds having the following structures

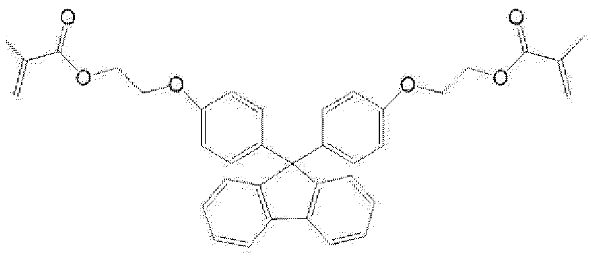

B-1

ClogP=8.65

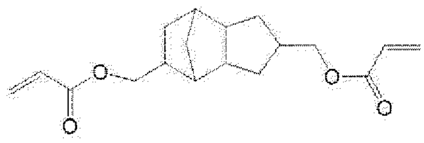

B-2

ClogP=4.67

- · B-3: SR-209 (manufactured by Sartomer Company Inc.)
- · B-4: dipentaerythritol hexaacrylate ((ADPH), manufactured by Shin-Nakamura Chemical Co., Ltd.)
- · B-5: 1,6-bis(acryloyloxy)heptane (manufactured by Tokyo Chemical Industry Co., Ltd.)
- · B-6: neopentylglycidyl diacrylate (manufactured by Tokyo Chemical Industry Co., Ltd.)
- · B-7: BLEMMER PDBP (manufactured by NOF Corporation)
- · B-8: BLEMMER ADT-250 (manufactured by NOF Corporation)
- · B-9: SR-209 (manufactured by Sartomer Company Inc.)

[Solvent]

- · DMSO: dimethyl sulfoxide
- · GBL: γ-butyrolactone
- · NMP: N-methylpyrrolidone
- · γ-V: γ-valerolactone

In the tables, the description of "DMSO/GBL" and "DMSO/γ-V" indicates that the mixture was used, in which DMSO and GBL were mixed at a mixing ratio (mass ratio) of DMSO:GBL = 80:20 and a mixing ratio (mass ratio) of DMSO:γ-valerolactone = 80:20.

[Polymerization initiator (all trade names)]

- · OXE-01: IRGACURE OXE 01 (manufactured by BASF SE)
- · OXE-02: IRGACURE OXE 02 (manufactured by BASF SE)
- · Irgacure 784: Irgacure 784 (manufactured by BASF SE)

· CPI-310B (manufactured by San-Apro Ltd.)
· D-1: Benzoyl peroxide (manufactured by Tokyo Chemical Industry Co., Ltd.)

[Migration suppressing agent]

· E-1 to E-7: Compounds having the following structures

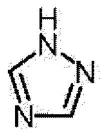
(E-1)

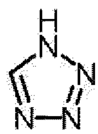
(E-2)

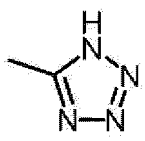
(E-3)

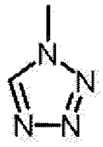
(E-4)

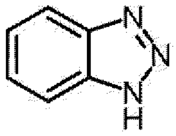
(E-5)

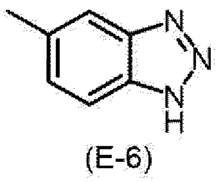
(E-6)

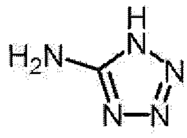
(E-7)

[Metal adhesiveness improving agent]

· F-1 to F-3: Compounds having the following structures

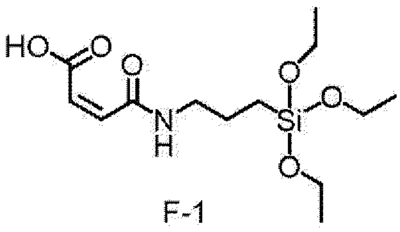
F-1

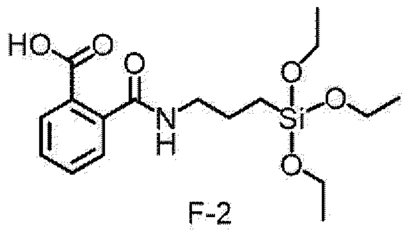
F-2

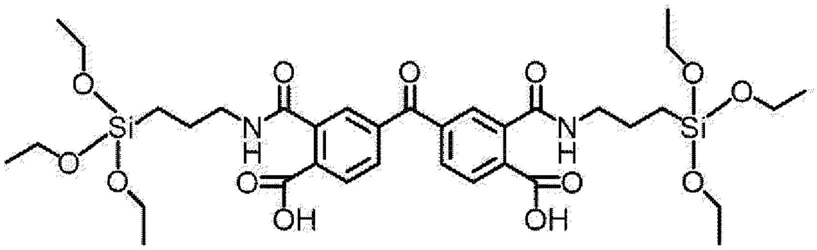
F-3

F-4: X-12-1293 (manufactured by Shin-Etsu Chemical Co., Ltd.)
F-5: KR-513 (manufactured by Shin-Etsu Chemical Co., Ltd.)
F-6: 3-aminopropyltriethoxysilane (manufactured by Tokyo Chemical Industry Co., Ltd.)
F-7: Tris[3-(trimethoxysilyl)propyl]isocyanurate (manufactured by Tokyo Chemical Industry Co., Ltd.)

[Polymerization inhibitor]

- · G-1: 1,4-benzoquinone
- · G-2: 4-methoxyphenol
- · G-3: 1,4-dihydroxybenzene
- · G-4: A compound having the following structure

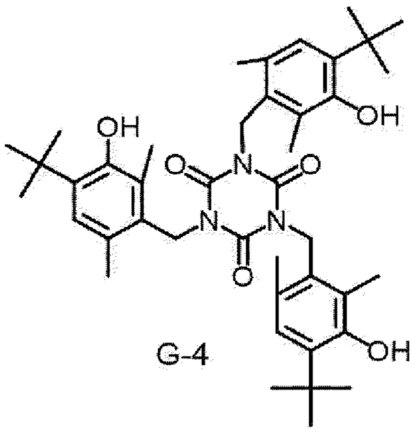

G-4

- · G-5: 2-nitroso-1-naphthol (manufactured by Tokyo Chemical Industry Co., Ltd.)
- · G-6: 2,2,6,6-tetramethylpiperidin-1-oxyl free radical

[Base generator]

··D-1 and D-3: Compounds having the following structures

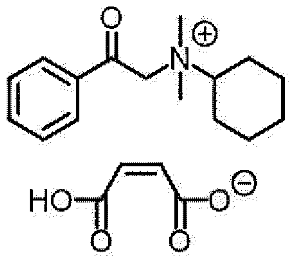

D-1

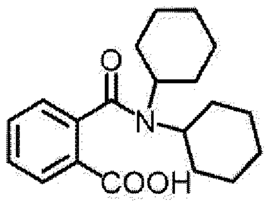

D-2

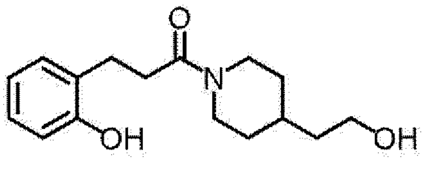

D-3

<Evaluation>

[Evaluation of resolution]

In each of Examples and Comparative Examples, each resin composition or comparative composition was applied onto a silicon substrate to form a coating film. Next, a heating treatment was performed for 240 seconds using a hot plate at 100°C to form a resin composition layer having a film thickness of 15 μm. Next, the resin composition layer was irradiated with i-rays (light having a wavelength of 365 nm) at an exposure amount of 100 to 1000 mJ/$cm^2$ using a stepper exposure device FPA-3000i5+ (manufactured by Canon Inc.) through a pattern mask having a 15 μm square bay, while changing the exposure amount by 100 mJ/$cm^2$, and then the silicon substrate on which the negative-tone photosensitive

resin composition layer after the exposure was formed was placed on a horizontal rotary table of a spin-shower developing machine (DW-30 type; manufactured by Chemitronics Co., Ltd.), and developed at 23°C for 30 seconds using the developer described in the column of "Development method (developer)" in the table to remove the unexposed portion by developing, rinsed with a rinsing liquid (PGMEA) at 23°C for 60 seconds, thereby forming a pattern. The resolution of the resin composition or the comparative composition was evaluated according to the following evaluation standards. In addition, it was determined that a pattern having a line width of 15 μm (a pattern having a 15 μm square) was resolvable in a case where the exposure width of the base substrate was 15 μm ± 3 μm.

- Evaluation standards -

A: The difference between the maximum value and the minimum value of the exposure amount at which a pattern having a thickness of 15 μm and a line width of 15 μm was resolvable was 900 $mJ/cm^2$ or more.
B: The difference between the maximum value and the minimum value of the exposure amount capable of resolving a pattern having a thickness of 15 μm and a line width of 15 μm was 600 $mJ/cm^2$ or more and less than 900 $mJ/cm^2$.
C: The difference between the maximum value and the minimum value of the exposure amount capable of resolving a pattern having a thickness of 15 μm and a line width of 15 μm was 300 $mJ/cm^2$ or more and less than 600 $mJ/cm^2$.
D: The difference between the maximum value and the minimum value of the exposure amount capable of resolving a pattern having a thickness of 15 μm and a line width of 15 μm was less than 300 $mJ/cm^2$.

[Evaluation of focus margin property]

Each of the resin compositions or comparative compositions prepared in each of Examples and Comparative Examples was applied onto an 8-inch silicon wafer by a spin coating method to form a coating film. The silicon wafer to which the obtained coating film was applied was dried on a hot plate at 100°C for 5 minutes, and a resin composition layer having a uniform thickness of 8 μm was formed on the silicon wafer.

The resin composition layer was irradiated with energy from 200 $mJ/cm^2$ to 600 $mJ/cm^2$ in steps of 100 $mJ/cm^2$ using an i-ray stepper FPA-3030 iWa (NA = 0.16) (manufactured by Canon Inc.) using a mask having a circular pattern having a mask size of a diameter of 5 μm. In this case, the focus was moved by 2 μm in the film bottom portion direction with respect to each exposure amount based on the film surface, and the exposure was performed. After the exposure, the wafer was placed on a horizontal rotary table of a spin-shower development device (DW-30 type; manufactured by Chemitronics Co., Ltd.), and development was performed at 23°C for 30 seconds using the developer described in the column of "Development method (developer)" in the table to remove the unexposed portion by development. Then, rinsing was performed at 23°C for 60 seconds using a rinsing liquid (PGMEA) to form a pattern.

The exposed resin composition layer (resin layer) was heated at a temperature rising rate of 10°C/min in a nitrogen atmosphere and heated for 180 minutes at the temperature described in the column of "Temperature" in "Curing condition" in the table to obtain a pattern of the cured layer (resin layer) of the resin composition layer.

For each of the obtained patterns, the pattern shape and the width of the pattern portion were observed under an optical microscope, and the focus margin was obtained. In a case where the angle between the bottom surface and the side surface of the pattern was 80° to 100° and the diameter of the pattern was 4 to 6 μm, it was determined that the pattern was formed.

As the focus margin is wider (the numerical value is larger), the result is more preferable in terms of the focus margin property.

- Evaluation standards -

A: The focus margin was 10 μm or more.
B: The focus margin was equal to or more than 7 μm and less than 10 μm.
C: The focus margin was more than 4 μm and less than 7 μm.
D: The focus margin was 4 μm or less.

[Evaluation of chemical resistance]

Each of the resin compositions or comparative compositions prepared in each of Examples and Comparative Examples was applied onto a silicon wafer by a spin coating method to form a coating film. The silicon wafer to which the

obtained coating film was applied was dried on a hot plate at 100°C for 5 minutes, and a resin composition layer having a uniform thickness of 15 μm was formed on the silicon wafer. The resin composition layer on the silicon wafer was exposed over the entire surface using a stepper (Nikon NSR 2005 i9C) at an exposure energy of 500 mJ/$cm^2$, the exposed resin composition layer (resin layer) was heated at a temperature rising rate of 10°C/min in a nitrogen atmosphere, and heated at the temperature described in the column of "Temperature" in "Curing condition" in the table for 180 minutes, thereby obtaining a cured layer (resin layer) of the resin composition layer.

The obtained resin layer was immersed in the following chemical liquid under the following conditions, and the dissolution rate was calculated.

Chemical liquid: a 90:10 (mass ratio) mixture of dimethyl sulfoxide (DMSO) and an aqueous solution containing 25% by mass of tetramethylammonium hydroxide (TMAH).

Evaluation conditions: The resin layer was immersed in the chemical liquid at 75°C for 15 minutes, and the film thickness before and after the immersion was compared to calculate the dissolution rate (nm/min).

The evaluation was carried out according to the following evaluation standards, and the evaluation results are described in the column of "Chemical resistance" of the table. It can be said that the lower the dissolution rate is, the more excellent the chemical resistance is.

- Evaluation standards -

A: The dissolution rate was less than 200 nm/min.
B: The dissolution rate was 200 nm/min or more and less than 300 nm/min.
C: The dissolution rate was 300 nm/min or more and less than 400 nm/min.
D: The dissolution rate was 400 nm/min or more.

[Evaluation of dielectric constant]

Each of the resin compositions or comparative compositions prepared in each of Examples and Comparative Examples was applied onto a 12-inch silicon wafer by a spin coating method to form a coating film. The silicon wafer to which the obtained coating film was applied was dried on a hot plate at 100°C for 5 minutes, and a resin composition layer having a uniform film thickness of 15 μm was formed on the silicon wafer. The resin composition layer on the silicon wafer was exposed over the entire surface using a stepper (Nikon NSR 2005 i9C) at an exposure energy of 500 mJ/$cm^2$, the exposed resin composition layer (resin layer) was heated at a temperature rising rate of 10°C/min in a nitrogen atmosphere, and heated at the temperature described in the column of "Temperature" in "Curing condition" in the table for 180 minutes, thereby obtaining a cured layer (resin layer) of the resin composition layer.

The cured layer (resin film) after curing was immersed in a 4.9% by mass hydrofluoric acid aqueous solution, and the cured film was peeled off from the silicon wafer.

A relative permittivity (Dk) and a dielectric loss tangent (Df) of the cured film (film sample) at 28 GHz were measured by a resonator perturbation method and evaluated according to the following standards. The evaluation results are described in the column of "Dielectric constant" in the table below.

<Measurement method>

Split cylinder resonator (CR-728)
(Device configuration)
Network analyzer: N5230A (manufactured by Keysight Technologies, Inc.)
(Evaluation standards)
Relative permittivity (Dk)

A: The relative permittivity (Dk) of the film was less than 2.9.
B: The relative permittivity (Dk) of the film was 2.9 to less than 3.0.
C: The relative permittivity (Dk) of the film was 3.0 to less than 3.2.
D: The relative permittivity (Dk) of the film was 3.2 or more.

Dielectric loss tangent (Df)

A: The dielectric loss tangent (Df) was less than 0.010.
B: The dielectric loss tangent (Df) was 0.010 to less than 0.015.
C: The dielectric loss tangent (Df) was 0.015 to less than 0.020.
D: The dielectric loss tangent (Df) was 0.020 or more.

From the above results, it can be seen that, with the cured substance formed of the resin composition according to the embodiment of the present invention, a cured substance having a low dielectric constant can be obtained.
The comparative composition according to Comparative Example 1 does not contain the specific resin. It can be seen that the dielectric constant of the cured substance is high for such a comparative composition.

<Example 101>

The resin composition used in Example 1 was applied in a layer shape onto a surface of a thin copper layer of the resin base material on the surface of which the thin copper layer was formed, by a spin coating method, dried at 100°C for 4 minutes, and after forming a resin composition layer having a film thickness of 20 μm, exposure was carried out using a stepper (NSR1505 i6, manufactured by Nikon Corporation). Exposure was carried out through a mask (a binary mask in which the pattern is a pattern of 1: 1 line and space and the line width is 10 μm) at a wavelength of 365 nm. After the exposure, heating was carried out at 100°C for 4 minutes. After the heating, the layer was developed with cyclopentanone for 2 minutes and rinsed with PGMEA for 30 seconds to obtain a layer pattern.
Next, the temperature was raised at a temperature rising rate of 10 °C/min in a nitrogen atmosphere, and after the temperature reached 230°C, the temperature was maintained at 230°C for 3 hours, thereby forming an interlayer insulating film for a re-distribution layer. This interlayer insulating film for a re-distribution layer was excellent in insulating properties.
In addition, in a case where a semiconductor device was manufactured using this interlayer insulating film for a re-distribution layer, it has been confirmed that the semiconductor device operates without any problem.

### Claims

1. A resin composition comprising:

    at least one resin selected from the group consisting of a polyimide and a precursor thereof and having a ring structure with 5 or more membered rings in a side chain;
    a polymerization initiator; and
    a polymerizable compound.

2. A resin composition comprising:

    at least one resin selected from the group consisting of a polyimide and a precursor thereof and including a structure represented by Formula (A-1);
    a polymerization initiator; and
    a polymerizable compound,

    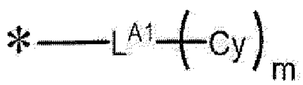 (A-1)

    in Formula (A-1), $L^{A1}$ represents a single bond or an (m+1)-valent linking group, Cy's each independently represent a ring structure with 5 or more membered rings, which may have a substituent, m represents an integer of 1 or more, and * represents a bonding site to an atom included in a main chain of the resin.

3. The resin composition according to claim 1 or 2,
    wherein the resin further has a polymerizable group.

4. The resin composition according to claim 3,
    wherein a polymerizable group value of the resin is 0.2 to 5 mmol/g.

5. The resin composition according to claim 1 or 2,

wherein in a case where a film-like cured substance having a film thickness of 10 μm is formed using the resin composition, a transmittance of the cured substance at a wavelength of 365 nm is 15% or more.

**6.** The resin composition according to claim 1 or 2,

wherein the resin includes a repeating unit represented by Formula (1-1),

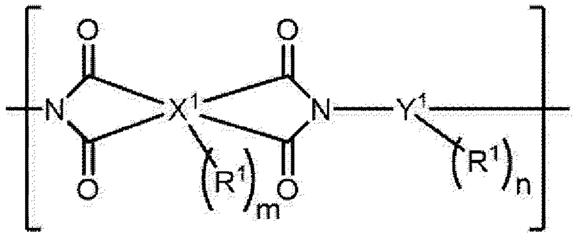

(1-1)

in Formula (1-1), $X^1$ represents an organic group having 4 or more carbon atoms, $Y^1$ represents an organic group having 4 or more carbon atoms, $R^1$'s each independently represent a structure represented by Formula (R-1), m represents an integer of 0 to 4, and n represents an integer of 1 or more,

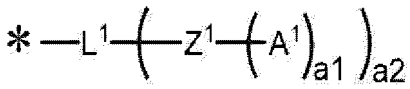

(R-1)

in Formula (R-1), $L^1$ represents an (a2+1)-valent linking group, $Z^1$ represents an aromatic group or a cyclic aliphatic group, $A^1$ represents a polymerizable group, a1 represents an integer of 0 or more and equal to or less than a maximum number of substituents of $Z^1$, a2 represents an integer of 1 or more, and * represents a bonding site to $X^1$ or $Y^1$ in Formula (1-1).

**7.** The resin composition according to claim 6,
wherein at least one of $A^1$'s in Formula (R-1) included in Formula (1-1) is a vinyl group, a (meth)acryloxy group, a vinyl ether group, an allyl group, an epoxy group, or a group including these groups.

**8.** The resin composition according to claim 7,
wherein the at least one of $A^1$'s in Formula (R-1) in Formula (1-1) is a vinyl group or a vinyl ether group.

**9.** The resin composition according to claim 6,

wherein $X^1$ and $Y^1$ in Formula (1-1) each include a structure obtained by removing two or more hydrogen atoms from a structure represented by any one of Formulae (V-1) to (V-4),

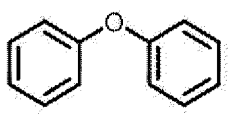

(V-1)

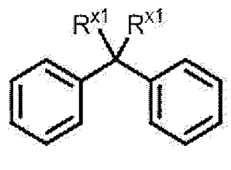

(V-2)

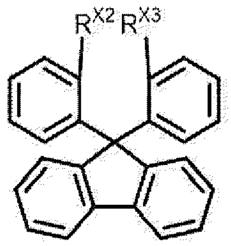

(V-3)

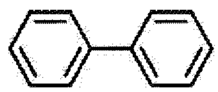

(V-4)

in Formula (V-2), $R^{X1}$'s each independently represent a hydrogen atom, an alkyl group, or a halogenated alkyl group,
in Formula (V-3), $R^{X2}$ and $R^{X3}$ each independently represent a hydrogen atom or a substituent, and $R^{X2}$ and $R^{X3}$ may be bonded to each other to form a ring structure.

**10.** The resin composition according to claim 6,

wherein $L^1$ in Formula (R-1) is a group represented by Formula (L-1),

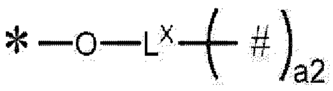

(L-1)

in Formula (L-1), $L^x$ represents an (a2+1)-valent linking group, a2 represents an integer of 1 or more, * represents a bonding site to $X^1$ or $Y^1$ in Formula (1-1), and # represents a bonding site to $Z^1$ in Formula (R-1).

**11.** A resin composition comprising:

at least one resin selected from the group consisting of a polyimide and a precursor thereof and including at least one repeating unit represented by Formula (2-1) or Formula (3-1);
a polymerization initiator; and
a polymerizable compound,

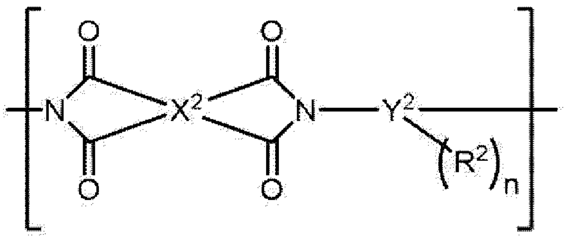

(2-1)

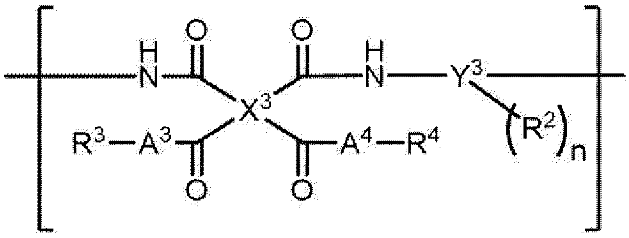

(3-1)

in Formula (2-1), $X^2$ represents an organic group having 4 or more carbon atoms, $Y^2$ represents an organic group having 4 or more carbon atoms, $Y^2$ does not include an ester bond, $R^2$'s each independently represent a group represented by Formula (R-2), and n represents an integer of 1 or more,
in Formula (3-1), $X^3$ represents an organic group having 4 or more carbon atoms, $Y^3$ represents an organic group having 4 or more carbon atoms, $Y^3$ does not include an ester bond, $A^3$ and $A^4$ each independently represent an oxygen atom or $-NR^N-$, $R^3$ and $R^4$ each independently represent a hydrogen atom or a monovalent organic group, $R^2$'s each independently represent a group represented by Formula (R-2), and n represents an integer of 1 or more,

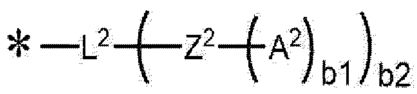

(R-2)

in Formula (R-2), $L^2$ represents a (b2+1)-valent linking group, $Z^2$ represents a (b1+1)-valent organic group, $A^2$ represents a polymerizable group, b1 represents an integer of 1 or more and equal to or less than a maximum number of substituents of $Z^2$, b2 represents an integer of 1 or more, * represents a bonding site to $Y^2$ in Formula (2-1) or $Y^3$ in Formula (3-1), and the number of ester bonds included in Formula (R-2) is 1 or 0.

**12.** The resin composition according to claim 11,
wherein the resin is a resin having a ring structure with 5 or more membered rings in a side chain.

**13.** The resin composition according to claim 11,
wherein a polymerizable group value of the resin is 0.2 to 5 mmol/g.

**14.** The resin composition according to claim 11, wherein in a case where a film-like cured substance having a film thickness of 10 μm is formed using the resin composition, a transmittance of the cured substance at a wavelength of 365 nm is 15% or more.

**15.** The resin composition according to claim 11, wherein at least one of $A^2$'s in Formula (R-2) included in Formula (2-1) is a vinyl group, a (meth)acryloxy group, a vinyl ether group, an allyl group, an epoxy group, or a group including these groups, at least one of $A^2$'s in Formula (R-2) included in Formula (3-1) is a vinyl group, a (meth)acryloxy group, a vinyl ether group, an allyl group, an epoxy group, or a group including these groups, $X^2$ and $Y^2$ in Formula (2-1) each include a structure obtained by removing two or more hydrogen atoms from a structure represented by any one of Formulae (V-1) to (V-4), and $X^3$ and $Y^3$ in Formula (3-1) each include a structure obtained by removing two or more hydrogen atoms from a structure represented by any one of Formulae (V-1) to (V-4),

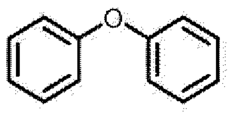
(V-1)

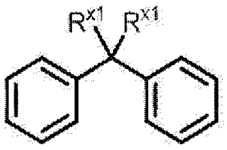
(V-2)

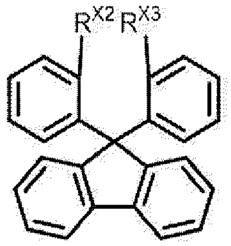
(V-3)

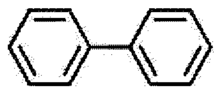
(V-4)

in Formula (V-2), $R^{X1}$'s each independently represent a hydrogen atom, an alkyl group, or a halogenated alkyl group,
in Formula (V-3), $R^{X2}$ and $R^{X3}$ each independently represent a hydrogen atom or a substituent, and $R^{X2}$ and $R^{X3}$ may be bonded to each other to form a ring structure.

**16.** The resin composition according to claim 11,

wherein $L^2$ in Formula (R-2) is a group represented by Formula (L-2), and $A^2$ in Formula (R-2) is a vinyl group or a vinyl ether group,

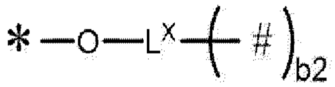
(L-2)

in Formula (L-2), $L^X$ represents a (b2+1)-valent linking group, b2 represents an integer of 1 or more, * represents a bonding site to $X^2$ or $Y^2$ in Formula (2-1) or $X^3$ or $Y^3$ in Formula (3-1), and # represents a bonding site to $Z^2$ in Formula (R-2).

**17.** The resin composition according to any one of claims 1, 2, and 11 to 16, wherein the polymerization initiator is a photoacid generator.

**18.** The resin composition according to any one of claims 1, 2, and 11 to 16, wherein the polymerization initiator includes two or more kinds of polymerization initiators.

**19.** The resin composition according to any one of claims 1, 2, and 11 to 16, wherein the polymerization initiator includes a photopolymerization initiator and a thermal polymerization initiator, or includes a photoradical polymerization initiator and a photoacid generator.

**20.** The resin composition according to any one of claims **1,** 2, and 11 to 16, further comprising:

an azole compound; and
a silane coupling agent.

**21.** The resin composition according to any one of claims 1, 2, and **11** to 16,

wherein the resin composition is used for forming an interlayer insulating film for a re-distribution layer.

**22.** A cured substance obtained by curing the resin composition according to any one of claims **1, 2,** and 11 to 16.

**23.** A laminate comprising:

two or more layers consisting of the cured substance according to claim 22; and
a metal layer provided between any of the layers consisting of the cured substance.

**24.** A manufacturing method for a cured substance, further comprising:
a film forming step of applying the resin composition according to any one of claims **1, 2,** and 11 to 16 onto a base material to form a film.

**25.** The manufacturing method for a cured substance according to claim 24, further comprising:

an exposure step of selectively exposing the film; and
a development step of developing the film using a developer to form a pattern.

**26.** The manufacturing method for a cured substance according to claim 24, further comprising:
a heating step of heating the film at 50°C to 450°C.

**27.** A manufacturing method for a laminate, comprising:
the manufacturing method for a cured substance according to claim 24.

**28.** A manufacturing method for a semiconductor device, comprising:
the manufacturing method for a cured substance according to claim 24.

**29.** A semiconductor device comprising:
the cured substance according to claim 22.

**INTERNATIONAL SEARCH REPORT**

International application No. **PCT/JP2023/035636**

**A. CLASSIFICATION OF SUBJECT MATTER**

***C08G 73/10***(2006.01)i; ***C08F 290/14***(2006.01)i; ***G03F 7/004***(2006.01)i; ***G03F 7/027***(2006.01)i; ***G03F 7/037***(2006.01)i; ***G03F 7/075***(2006.01)i; ***G03F 7/20***(2006.01)i

FI: C08G73/10; C08F290/14; G03F7/004 501; G03F7/004 503Z; G03F7/027 514; G03F7/037; G03F7/075 501; G03F7/20 501; G03F7/20 521

According to International Patent Classification (IPC) or to both national classification and IPC

**B. FIELDS SEARCHED**

Minimum documentation searched (classification system followed by classification symbols)

C08G73/10; C08F290/14; G03F7/004; G03F7/027; G03F7/037; G03F7/075; G03F7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2018/003726 A1 (FUJIFILM CORPORATION) 04 January 2018 (2018-01-04) claims, paragraphs [0138], [0158]-[0169], examples | 1-5, 18-29 |
| Y | | 17 |
| A | | 6-16 |
| Y | WO 2017/170600 A1 (ASAHI KASEI KABUSHIKI KAISHA) 05 October 2017 (2017-10-05) claims, paragraph [0398] | 17 |
| X | JP 2006-512422 A (ELSICON, INC.) 13 April 2006 (2006-04-13) claims, examples | 1-8, 10-14, 16, 22, 24, 27 |
| A | | 9, 15,17-21, 23, 25-26. 28-29 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 November 2023** | **12 December 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No.
**PCT/JP2023/035636**

**C. DOCUMENTS CONSIDERED TO BE RELEVANT**

| Category* | Citation of document, with indication, where appropriate, of the relevant passages | Relevant to claim No. |
|---|---|---|
| X<br><br><br>A | WO 2018/159637 A1 (NISSAN CHEMICAL CORPORATION) 07 September 2018 (2018-09-07)<br>claims, paragraphs [0143]-[0156], [0239], examples | 1-8, 10-14, 16-19, 22, 24, 26-27<br><br>9, 15, 20-21, 23, 25, 28-29 |
| A | JP 63-318549 A (HITACHI LTD) 27 December 1988 (1988-12-27)<br>entire text | 1-29 |

Form PCT/ISA/210 (second sheet) (January 2015)

**INTERNATIONAL SEARCH REPORT**
**Information on patent family members**

International application No.
**PCT/JP2023/035636**

| Patent document cited in search report | Publication date (day/month/year) | Patent family member(s) | Publication date (day/month/year) |
|---|---|---|---|
| WO 2018/003726 A1 | 04 January 2018 | TW 201817773 A | |
| WO 2017/170600 A1 | 05 October 2017 | US 2019/0113845 A1<br>claims, paragraph [0144]<br>KR 10-2018-0011245 A<br>CN 107850844 A<br>TW 201740198 A | |
| JP 2006-512422 A | 13 April 2006 | WO 2003/102045 A1<br>claims, examples<br>US 2003/0232927 A1<br>EP 1551898 A1<br>KR 10-0973365 B1<br>CN 102770464 A | |
| WO 2018/159637 A1 | 07 September 2018 | KR 10-2019-0125360 A<br>CN 110546176 A<br>TW 201843134 A | |
| JP 63-318549 A | 27 December 1988 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2020255859 A
- WO 2021039782 A
- WO 2017038598 A
- JP 2013256506 A
- WO 2022145355 A
- JP 2016027357 A
- WO 2021112189 A
- JP 48041708 B
- JP S48041708 B
- JP 51037193 A
- JP S51037193 A
- JP 2032293 B
- JP H02032293 B
- JP 2016765 B
- JP H02016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H01105238 A
- WO 2015199219 A
- JP 2014130173 A
- JP 6301489 B
- WO 2018221177 A
- WO 2018110179 A
- JP 2019043864 A
- JP 2019044030 A
- JP 2019167313 A
- JP 2015087611 A
- JP 10291969 A
- JP H10291969 A
- JP 4225898 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- WO 2021020359 A
- JP 4600600 B
- JP 2007269779 A
- JP 2009191061 A
- WO 2015125469 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- JP 2008063554 A
- WO 2018038002 A
- JP 2018173573 A
- JP 2011128358 A
- JP 2014186186 A
- JP 2013072935 A
- JP 2013015701 A
- JP 2009283711 A
- JP 2011059656 A
- JP 2012194520 A
- JP 4253058 A
- JP H4253058 A
- JP 5224410 A
- JP H5224410 A
- JP 5303200 A
- JP H5303200 A
- EP 530148 A
- JP 2019206689 A
- JP 2012003225 A
- US 20130034812 A
- JP 2008250074 A
- JP 2015123351 A
- JP 2006023696 A
- JP 2006047592 A
- US 9159547 B
- JP 2007157879 A
- JP 2001521288 A

- JP 2004214501 A
- JP 2004101850 A
- US 7888181 B2
- US 9177926 B2


**Non-patent literature cited in the description**


- *J. Chem. Inf. Comput. Sci.*, 1987, vol. 27, 21
- *J. Chem. Inf. Comput. Sci.*, 1989, vol. 29, 163
- *Eur. J. Med. Chem. -Chim. Theor.*, 1984, vol. 19, 71
- *MATERIAL STAGE*, 2019, vol. 19 (3), 37-60
- *J. C. S. Perkin II*, 1979, 1653-1660
- *J. C. S. Perkin II*, 1979, 156-162
- *Journal of Photopolymer Science and Technology*, 1995, 202-232
- Polymer Dictionary. 2005, 683-684
- High functionality and applied technology of polyimide. Science & Technology Co., Ltd., April 2008
- Basics and development of polyimide materials. Technical library CMC TL, November 2011
- Latest Polyimide Basics and Applications. NTS Inc., August 2010